(19) Europäisches Patentamt
European Patent Office
Office européen des brevets

(11) EP 2 752 712 A1

(12) **EUROPEAN PATENT APPLICATION**
published in accordance with Art. 153(4) EPC

(43) Date of publication:
**09.07.2014 Bulletin 2014/28**

(21) Application number: **12828562.4**

(22) Date of filing: **31.08.2012**

(51) Int Cl.:
*G03F 7/075* (2006.01)
*C08F 230/08* (2006.01)
*C08F 290/08* (2006.01)
*C08G 77/14* (2006.01)
*C08G 77/20* (2006.01)
*G03F 7/033* (2006.01)
*G03F 7/038* (2006.01)
*H01L 21/027* (2006.01)

(86) International application number:
**PCT/JP2012/072247**

(87) International publication number:
**WO 2013/031985 (07.03.2013 Gazette 2013/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **31.08.2011 JP 2011189890**
**20.04.2012 JP 2012096947**

(60) Divisional application:
**14001209.7**

(71) Applicant: **Asahi Kasei E-Materials Corporation**
**Chiyoda-ku**
**Tokyo 101-8101 (JP)**

(72) Inventors:
- **SAITO, Yamato**
  **Chiyoda-ku, Tokyo 101-8101 (JP)**
- **IWAMA, Juri**
  **Chiyoda-ku, Tokyo 101-8101 (JP)**
- **KATSUMATA, Toru**
  **Chiyoda-ku, Tokyo 101-8101 (JP)**
- **SASAKI, Yuka**
  **Chiyoda-ku, Tokyo 101-8101 (JP)**
- **KIMURA, Masashi**
  **Chiyoda-ku, Tokyo 101-8101 (JP)**
- **MATSUDA, Harumi**
  **Chiyoda-ku, Tokyo 101-8101 (JP)**

(74) Representative: **Strehl Schübel-Hopf & Partner**
**Maximilianstrasse 54**
**80538 München (DE)**

(54) **PHOTOSENSITIVE ALKALI-SOLUBLE SILICONE RESIN COMPOSITION**

(57) The present invention relates to a photosensitive alkali-soluble silicone resin composition comprising an alkali-soluble silicone resin (A) which comprises a carboxyl group or a dicarboxylic acid anhydride group in one molecule; an alkali-soluble resin (B) whose acid value is between 10 mgKOH/g and 200 mgKOH/g; and a photoinitiator (C). The (A) or (B) ingredient may comprise a photosensitive unsaturated double bond group, or the photosensitive alkali-soluble silicone resin composition may further comprise a compound (D) which comprises a photosensitive unsaturated double bond.

Fig.1

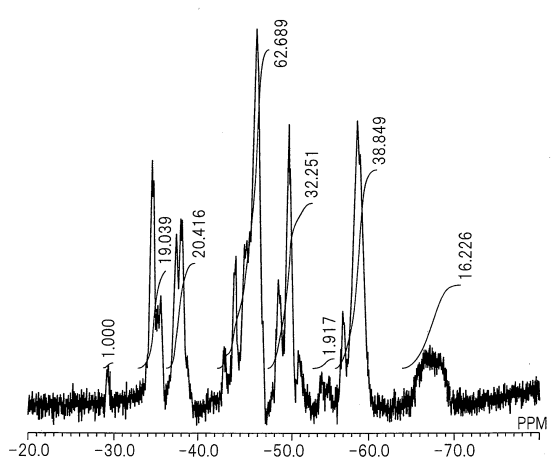


EP 2 752 712 A1

**Description**

TECHNICAL FIELD

The present invention relates to a resin composition used for an insulating material employed in a display device, for formation of a surface protective film, an interlayer insulating film, an α-ray shielding film, etc., in a semiconductor device, and for an image sensor, a semiconductor device having mounted therein a micromachine or a microactuator, etc., and a display device, etc., manufactured using the same.

BACKGROUND ART

In applications, such as an insulating material of an electronic component and a surface protective film, interlayer insulating film, α-ray shielding film, etc., of a semiconductor device, a polyimide resin excellent in heat resistance, electric properties and mechanical properties is being widely used. This resin is usually used in the form of a photosensitive polyimide precursor composition and is characterized in that when the composition is coated on a base material, soft-baked, irradiated with (exposed to) active light through a desired pattern mask, developed and subjected to a heat curing treatment, a cured relief pattern composed of a heat-resistant polyimide resin can be easily formed (see, for example, Patent Document 1).

On the other hand, the polyimide having the above-described excellent properties has a polyimide ring-derived absorption in the region of 500 to 400 nm and therefore, is not suitable for an application requiring high transparency, such as display device or optical material.

Also, in consideration of the main material of the constituent element or the structure design, a material which can be subjected to a heat curing treatment at a lower temperature is increasingly demanded. However, in the case of the conventional polyimide resin precursor composition, when the curing treatment temperature is lowered, the thermal imidization cannot be completed and various physical properties of the cured film are reduced. Therefore, the lower limit of the curing treatment temperature has been around 300°C.

Also, Patent Document 2 discloses a photosensitive siloxane-based material capable of low-temperature curing, but only by the technique disclosed in Patent Document 2, development with an alkali developer cannot be carried out at the microfabrication. The pattern forming method using an alkali developer is advantageous in that the environmental load is low as compared with development using an organic solvent and the cost can be kept low, and therefore, a photosensitive resin capable of alkali development and low-temperature curing is being strongly demanded.

In addition, Patent Document 3 discloses a photosensitive siloxane-based material capable of pattern formation by alkali development and low-temperature curing.

RELATED ART

PATENT DOCUMENT

Patent Document 1: Japanese Unexamined Patent Publication (Kokai) No. 6-342211
Patent Document 2: Kokai No. 2007-277332
Patent Document 3: International Publication No. 2010/061744, pamphlet

SUMMARY OF THE INVENTION

PROBLEMS TO BE SOLVED BY THE INVENTION

However, it has been found that in the case of using the technique disclosed in Patent Document 3, it is not possible to improve sufficiently the heat-resistant transparency, thermal crack resistance and cold-heat shock test resistance when forming a thick film for use as a display device or an optical material.

Furthermore, the material disclosed in Patent Document 3 is subject to inhibition of surface curing by oxygen when exposed to an atmosphere and is low in surface curability and therefore, the residual film ratio after alkali development (the residual film ratio indicates [thickness of coating film after alkali development/thickness of coating film after coating and removal of solvent]×100 (%)) is reduced, making it difficult to stably form a thick film.

For this reason, a photosensitive film-forming material exhibiting excellent low-temperature curability and in the form of a thick film, satisfying physical properties, such as heat-resistant transparency, thermal crack resistance, cold-heat shock test resistance and high residual film ratio, which are demanded in technical fields requiring high transparency, such as a display device or optical material, has not yet been discovered.

Accordingly, an object of the present invention is to provide a novel photosensitive alkali-soluble silicone resin composition allowing for pattern formation by alkali development, exhibiting excellent low-temperature curability, and in the form of a thick film, satisfying physical properties, such as heat-resistant transparency, thermal crack resistance, cold-heat shock test resistance and high residual film ratio, which are demanded in technical fields requiring high transparency, such as a display device or optical material.

MEANS TO SOLVE THE PROBLEMS

As a result of intensive studies on the molecular structure, characteristics, etc. of an alkali-soluble silicone resin so as to solve the above-mentioned problems, the present inventors have found that the above-described object can be attained by a photosensitive alkali-soluble silicone resin composition containing a specific alkali-soluble silicone resin, a specific alkali-soluble resin and a photopolymerization initiator, i.e., the present invention is as follows.

[1] A photosensitive alkali-soluble silicone resin composition comprising:

(A) an alkali-soluble silicone resin having a carboxyl group or a dicarboxylic acid anhydride group in one molecule;
(B) an alkali-soluble resin having an acid value of 10 to 200 mgKOH/g; and
(C) a photopolymerization initiator,

wherein the component (A) or (B) has a photopolymerizable unsaturated double bond group or the photosensitive alkali-soluble resin composition further contains (D) a photopolymerizable unsaturated double bond-containing compound.

[2] The photosensitive alkali-soluble silicone resin composition according to [1], wherein the alkali-soluble silicone resin (A) further contains a photopolymerizable unsaturated double bond group in one molecule.

[3] The photosensitive alkali-soluble silicone resin composition according to [1] or [2], wherein the alkali-soluble silicone resin (A) is obtained by a reaction of:

(A-1) a silane compound represented by following formula (I):

$$R^1R^2_aSi(R^3)_{3-a} \qquad (I)$$

{wherein $R^1$ is a monovalent organic group containing a carboxyl group or a dicarboxylic acid anhydride group and having a carbon number of 4 to 20, $R^2$ is a methyl group, $R^3$ is at least one monovalent organic group selected from the group consisting of a methoxy group, an ethoxy group, a propoxy group and an isopropoxy group, a hydroxyl group or chloro group(Cl), and a is an integer of 0 or 1} and
(A-2) a silane compound represented by following formula (II):

$$R^4_bR^5_cSi(R^3)_{4-b-c} \qquad (II)$$

{wherein each of $R^4$ and $R^5$ is a group containing a photopolymerizable unsaturated double bond group or a polymerizable cyclic ether bond group and having a carbon number of 2 to 20, an aryl group having a carbon number of 6 to 20, an alkylaryl group having a carbon number of 2 to 20, an alkyl group having a carbon number of 1 to 20, which may be substituted with a mercapto group or an amino group, a cycloalkyl group having a carbon number of 5 to 20, or a group containing a carboxyl group or a dicarboxylic acid anhydride group and having a carbon number of 4 to 20, $R^4$ and $R^5$ may be the same or different and may be bonded to each other through a covalent bond, $R^3$ is at least one monovalent organic group selected from the group consisting of a methoxy group, an ethoxy group, a propoxy group and an isopropoxy group, a hydroxyl group or Cl, b is an integer selected from 0 to 2, c is an integer of 0 or 1, but b+c does not exceed 2}.

[4] The photosensitive alkali-soluble silicone resin composition according to any one of [1] to [3], wherein the alkali-soluble silicone resin (A) is obtained by reacting:

the silane compound (A-1);
the silane compound (A-2); and

(A-3) a silanediol compound represented by following formula (III):

$R^6{}_2Si(OH)_2$ (III)

{wherein $R^6$ is an aryl group having a carbon number of 6 to 20, an alkylaryl group having a carbon number of 2 to 20, an alkyl group having a carbon number of 1 to 20, which may be substituted with a mercapto group or an amino group, or a cycloalkyl group having a carbon number of 5 to 20, and a plurality of $R^6$ may be the same or different and may be bonded to each other through a covalent bond},
in the presence of a catalyst.

[5] The photosensitive alkali-soluble silicone resin composition according to any one of [1] to [4], wherein the alkali-soluble silicone resin (A) further contains a polymerizable cyclic ether group in one molecule.
[6] The photosensitive alkali-soluble silicone resin composition according to any one of [1] to [5], wherein the alkali-soluble resin (B) contains a photopolymerizable unsaturated double bond group in one molecule.
[7] The photosensitive alkali-soluble silicone resin composition according to any one of [1] to [6], wherein the alkali-soluble resin (B) contains a photopolymerizable unsaturated double bond group and a carboxyl group or a dicarboxylic acid anhydride group in one molecule.
[8] The photosensitive alkali-soluble silicone resin composition according to any one of [1] to [7], wherein the alkali-soluble resin (B) is at least one polymer selected from the group consisting of a vinyl polymer composed of a reaction product of a polymerizable unsaturated double bond, an epoxy polymer composed of an addition reaction product of an epoxy group and a hydroxyl group, an aromatic methylene polymer composed of a reaction product of phenol and formaldehyde, a urethane polymer composed of a reaction product of dialcohol and diisocyanate, and an ester polymer composed of a reaction product of dicarboxylic acid and diepoxide.
[9] The photosensitive alkali-soluble silicone resin composition according to any one of [1] to [8], wherein the acid value (A)/acid value (B) ratio of the acid value (mgKOH/g) of the alkali-soluble silicone resin (A) to the acid value (mgKOH/g) of the alkali-soluble resin (B) is from 0.1 to 5.0.
[10] The photosensitive alkali-soluble silicone resin composition according to any one of [1] to [9], wherein both the alkali-soluble silicone resin (A) and the alkali-soluble resin (B) have a photopolymerizable unsaturated double bond group, and the photosensitive alkali-soluble silicone resin composition contains the photopolymerizable unsaturated double bond-containing compound (D).
[11] The photosensitive alkali-soluble silicone resin composition according to any one of [1] to [10], wherein with respect to the FT-IR spectrum of the photosensitive alkali-soluble silicone resin composition, the ratio ($I_y/I_x$) between the intensity ($I_x$) in the region of 1,000 to 1,100 $cm^{-1}$ selected from the highest intensity when a maximum peak is not present, the intensity of one maximum peak when only one maximum peak is present, and the intensity of a highest maximum when a plurality of maximum peaks are present, and the intensity ($I_y$) in the region of 880 to 920 $cm^{-1}$ selected from the highest intensity when a maximum peak is not present, the intensity of one maximum peak when only one maximum peak is present, and the intensity of a highest maximum peak when a plurality of maximum peaks are present, is from 0.01 to 0.4.
[12] The photosensitive alkali-soluble silicone resin composition according to any one of [1] to [11], wherein the three-dimensional crosslinking degree (T) as calculated from the integration ratio in the $^{29}$Si-NMR spectrum of the photosensitive alkali-soluble silicone resin composition according to following formula (IV) is 0.15 or less:

$$\text{Three-dimensional crosslinking degree (T)} = (A_{T3}+A_{Q3}+A_{Q4}*2)/\{(A_{M0}+A_{M1})+(A_{D0}+A_{D1}+A_{D2})+(A_{T0}+A_{T1}+A_{T2}+A_{T3})+(A_{Q0}+A_{Q1}+A_{Q2}+A_{Q3}+A_{Q4})\} \quad \text{(formula IV)}$$

[13] The photosensitive alkali-soluble silicone resin composition according to any one of [1] to [11], wherein the three-dimensional crosslinking degree (T') as calculated from the integration ratio in the $^{29}$Si-NMR spectrum of the photosensitive alkali-soluble silicone resin composition according to following formula (V) is 0.3 or less:

$$\text{Three-dimensional crosslinking degree (T')} = (A_{T3})/(A_{T0}+A_{T1}+A_{T2}+A_{T3}) \quad \text{(formula V)}$$

[14] The photosensitive alkali-soluble silicone resin composition according to any one of [1] to [13], which contains:

from 1 to 98 mass% of the alkali-soluble silicone resin (A);
from 1 to 50 mass% of the alkali-soluble resin (B); and
from 0.01 to 15 mass% of the photopolymerization initiator (C), based on the total solid content in the photosensitive alkali-soluble silicone resin composition.

[15] The photosensitive alkali-soluble silicone resin composition according to any one of [1] to [14], which contains:

from 1 to 98 mass% of the alkali-soluble silicone resin (A);
from 1 to 50 mass% of the alkali-soluble resin (B);
from 0.01 to 15 mass% of the photopolymerization initiator (C); and
from 5 to 45 mass% of the photopolymerizable unsaturated double bond-containing compound (D), based on the total solid content in the photosensitive alkali-soluble silicone resin composition.

[16] The photosensitive alkali-soluble silicone resin composition according to any one of [1] to [15], which further contains (E) a solvent.
[17] The photosensitive alkali-soluble silicone resin composition according to any one of [1] to [16], which further contains (F) a hindered amine-based stabilizer.
[18] The photosensitive alkali-soluble silicone resin composition according to [17], wherein the hindered amine-based stabilizer (F) is contained in an amount of 0.001 to 15 mass% based on the mass of the total solid content in the photosensitive alkali-soluble silicone resin composition.
[19] The photosensitive alkali-soluble silicone resin composition according to any one of [1] to [18], wherein in a cured product obtained by curing the photosensitive alkali-soluble silicone resin composition, the transmittance of light at a wavelength of 400 nm under the conditions after baking the cured product having a thickness of 10 $\mu$m at 220°C for 3 hours in an atmosphere is 70% or more.
[20] A cured product obtained by curing the photosensitive alkali-soluble silicone resin composition according to any one of [1] to [19].
[21] A transparent insulating film obtained by curing the photosensitive alkali-soluble silicone resin composition according to any one of [1] to [19].
[22] A cured product obtained by curing a resin composition comprising (G) a polyorganosiloxane, (H) an alkali-soluble resin except for the polyorganosiloxane (G), and (C) a photopolymerization initiator, wherein the three-dimensional crosslinking degree (T) as calculated from the integration ratio in the solid $^{29}$Si-NMR spectrum of the cured product according to following formula (IV) is 0.2 or less:

$$\text{Three-dimensional crosslinking degree (T)} = (A_{T3}+A_{Q3}+A_{Q4}*2)/\{(A_{M0}+A_{M1})+(A_{D0}+A_{D1}+A_{D2})+(A_{T0}+A_{T1}+A_{T2}+A_{T3})+(A_{Q0}+A_{Q1}+A_{Q2}+A_{Q3}+A_{Q4})\} \quad \text{(formula IV)}$$

[23] A cured product obtained by curing a resin composition comprising (G) a polyorganosiloxane, (H) an alkali-soluble resin except for the polyorganosiloxane (G), and (C) a photopolymerization initiator, wherein the three-dimensional crosslinking degree (T') as calculated from the integration ratio in the solid $^{29}$Si-NMR spectrum of the cured product according to following formula (V) is 0.45 or less:

$$\text{Three-dimensional crosslinking degree (T')} = (A_{T3})/(A_{T0}+A_{T1}+A_{T2}+A_{T3}) \quad \text{(formula V)}$$

[24] The cured product according to [22] or [23], wherein the polyorganosiloxane (G) is obtained by condensing a silane compound having a carboxylic acid group or a carboxylic acid anhydride group.
[25] The cured product according to any one of [22] to [24], wherein the polyorganosiloxane (G) contains a component in which the number of silicon (Si) atoms bonded to an oxygen (○) atom is two and/or a component in which the number of Si atoms bonded to an ○ atom is three.
[26] The cured product according to any one of [22] to [25], wherein the resin composition further contains at least one member selected from the group consisting of (F) a hindered amine-based stabilizer, (I) a photocrosslinkable monomer, (J) a silane coupling agent and (K) an ultraviolet absorber.
[27] The cured product according to any one of [22] to [26], wherein the glass transition temperature (Tg) of the

cured product as measured by dynamic viscoelasticity measurement (DMA) is 80°C or more.

[28] The cured product according to any one of [22] to [27], wherein the cured product has a thickness of 10 μm and the transmittance of light at a wavelength of 400 nm under the conditions after baking the cured product at 220°C for 3 hours in an atmosphere is 70% or more.

## EFFECTS OF THE INVENTION

The photosensitive alkali-soluble silicone resin composition of the present invention can provide a cured film allowing for pattern formation by alkali development, exhibiting excellent low-temperature curability, and in the form of a thick film, satisfying physical properties, such as heat-resistant transparency, thermal crack resistance, cold-heat shock test resistance and high residual film ratio, which are demanded in technical fields requiring high transparency, such as display device or optical material. Furthermore, the cured product and transparent insulating film of the present invention enable production of a display device having a cured relief pattern realizing excellent transparency and high heat resistance at the same time.

## BRIEF DESCRIPTION OF THE DRAWINGS

[Fig. 1] A liquid $^{29}$Si-NMR spectrum of the composition of Example 26.
[Fig. 2] A liquid $^{29}$Si-NMR spectrum of the composition of Example 27.
[Fig. 3] A liquid $^{29}$Si-NMR spectrum of the composition of Example 28.
[Fig. 4] A liquid $^{29}$Si-NMR spectrum of the composition of Comparative Example 1.
[Fig. 5] An FT-IR spectrum of the composition of Example 26.
[Fig. 6] An FT-IR spectrum of the composition of Example 27.
[Fig. 7] An FT-IR spectrum of the composition of Example 28.
[Fig. 8] An FT-IR spectrum of the composition of Comparative Example 1.
[Fig. 9] A solid $^{29}$Si-NMR spectrum of the cured product of Example 26.
[Fig. 10] A solid $^{29}$Si-NMR spectrum of the cured product of Example 27.
[Fig. 11] A solid $^{29}$Si-NMR spectrum of the cured product of Example 28.
[Fig. 12] A solid $^{29}$Si-NMR spectrum of the cured product of Comparative Example 1.
[Fig. 13] A DMA Tan $\delta$ curve of the cured product of Example 26.
[Fig. 14] A DMA Tan $\delta$ curve of the cured product of Example 27.
[Fig. 15] A DMA Tan $\delta$ curve of the cured product of Example 28.
[Fig. 16] A DMA Tan $\delta$ curve of the cured product of Comparative Example 1.

## MODE FOR CARRYING OUT THE INVENTION

The photosensitive alkali-soluble silicone resin composition of the present invention is described in detail below.

### <Photosensitive Alkali-Soluble Silicone Resin Composition>

The photosensitive alkali-soluble silicone resin composition of the present invention comprises:

(A) an alkali-soluble silicone resin having a carboxyl group or a dicarboxylic acid anhydride group in one molecule;
(B) an alkali-soluble resin having an acid value of 10 to 200 mgKOH/g; and
(C) a photopolymerization initiator, and the component (A) or (B) has a photopolymerizable unsaturated double bond group or the photosensitive alkali-soluble resin composition further contains:
(D) a photopolymerizable unsaturated double bond-containing compound.

### <(A) Alkali-Soluble Silicone Resin>

The alkali-soluble silicone resin (A) has a carboxyl group or a dicarboxylic acid anhydride group in one molecule. By virtue of having a carboxyl group or a dicarboxylic acid anhydride group in the structure, the alkali-soluble silicone resin (A) can enhance the alkali solubility of silicone resin, reduce the residue after development and impart good pattern formability.

The silicone resin indicates, for example, a resin that has, as described in "Silicone Handbook", Nikkan Kogyo Shinbunsha (1990), a two-dimensional or three-dimensional network structure obtained by polymerizing an organosilane

compound containing from 1 to 4 reactive groups, such as alkoxysilyl group and chlorosilyl group, has an Si-O-Si bond, and has a weight average molecular weight (Mw) of 500 or more in terms of polystyrene measured by gel permeation chromatography (GPC). By making the molecular weight of a silicone resin high, the content of Si-O-Si bond can be increased and the heat-resistant transparency can be enhanced.

Specifically, the silicone resin includes, for example, BY16-880, BY16-750, SF8418 (produced by Dow Corning Toray Silicone Co., Ltd.), X-22-162C, X-22-3701E, X-22-3710 (produced by Shin-Etsu Silicone Co., Ltd.), TSF4770 (produced by Momentive Performance Materials Inc.), SILAPLANE FM-6611, FM-6621 and FM6625 (produced by Chisso Corporation).

The content of the carboxyl group or dicarboxylic acid anhydride group of the alkali-soluble silicone resin (A) is not particularly limited as long as the resin contains such a group, but in view of reduction of the residue after development and crack resistance of the cured film, the acid value is preferably 10 mgKOH/g or more, more preferably 15 mgKOH/g or more, still more preferably 20 mgKOH/g or more. Furthermore, in view of adherence of the pattern, the acid value is preferably 200 mgKOH/g or less, more preferably 190 mgKOH/g or less, still more preferably 180 mgKOH/g or less.

Also, in the case of containing two or more alkali-soluble silicone resins (A), the content of the carboxyl group or dicarboxylic acid anhydride group of at least one alkali-soluble silicone resin is preferably in the above-described acid value range.

The acid value indicates a milligram number of potassium hydroxide necessary for neutralizing a carboxyl group in 1 g of a sample.

One example for measuring the acid value is as follows. A sample in an amount of 3 g is precisely weighed and dissolved in 20 ml of ethanol. The obtained solution is stirred at room temperature and after further adding 5 g of purified water, stirred at room temperature for another 1 hour. Thereafter, a few drops of a methanol solution of phenolphthalein are added as an indicator, and by means of neutralizing titration with an aqueous 1/2 N potassium hydroxide solution, the acid value is calculated from the amount of the aqueous potassium hydroxide solution used.

The alkali-soluble silicone (A) has a carboxyl group or a dicarboxylic acid anhydride group in one molecule and preferably further contains a group containing a photopolymerizable unsaturated double bond group or a polymerizable cyclic ether bond group and having a carbon number of 2 to 20, an aryl group having a carbon number of 6 to 20, an alkylaryl group having a carbon number of 2 to 20, an alkyl group having a carbon number of 1 to 20, or a cycloalkyl group having a carbon number of 5 to 20. Although this is not particularly limited as long as the resin has such a group, the alkali-soluble silicone resin (A) preferably contains a photopolymerizable unsaturated double bond group, because by having a photopolymerizable unsaturated double bond group in the alkali-soluble silicone resin (A), the adherence of pattern, the film hardness and the crack resistance are increased and good physical film properties are obtained

The molar concentration of the photopolymerizable unsaturated double bond group of the alkali-soluble silicone resin (A) is, in view of adherence of pattern, film hardness and crack resistance, preferably 0.01 mmol/g or more, more preferably 0.1 mmol/g or more, still more preferably 0.5 mmol/g or more. From the standpoint of reducing the residue during development, the molar concentration above is preferably 10.0 mmol/g or less, more preferably 7.5 mmol/g or less, still more preferably 5.0 mmol/g or less.

The weight average molecular weight (Mw) of the alkali-soluble silicone resin (A) is not particularly limited but in view of heat resistance of the silicone resin, 500 or more, preferably 800 or more, in terms of polystyrene measured by gel permeation chromatography (GPC). In view of solubility during development and pattern formability, the Mw above is preferably 100,000 or less, more preferably 80,000 or less, still more preferably 50,000 or less, and most preferably 10,000 or less.

In the embodiment of the present invention, the content of the alkali-soluble silicone resin (A) is not particularly limited and may be arbitrarily selected according to the desired film thickness or usage, but the content based on the mass of all components (total solid content) except for the solvent in the photosensitive alkali-soluble silicone resin composition is, in view of heat-resistant transparency, preferably 1 mass% or more, more preferably 10 mass% or more, still more preferably 15 mass% or more, and in view of crack resistance, is preferably 99 mass% or less, more preferably 90 mass% or less, still more preferably 80 mass% or less.

In view of ease of resin design and production, the alkali-soluble silicone resin (A) of the present invention is preferably obtained by a reaction of:

(A-1) a silane compound represented by following formula (I), and
(A-2) a silane compound represented by following formula (II):

$$R^1R^2_aSi(R^3)_{3-a} \qquad (I)$$

{wherein $R^1$ is a monovalent organic group containing a carboxyl group or a dicarboxylic acid anhydride group and having a carbon number of 4 to 20, $R^2$ is a methyl group, each $R^3$ is independently at least one monovalent organic group selected from the group consisting of a methoxy group, an ethoxy group, a propoxy group and an isopropoxy

group, a hydroxyl group or chloro group(Cl), and a is an integer of 0 or 1};

$$R^4_bR^5_cSi(R^3)_{4-b-c} \qquad (II)$$

{wherein each of $R^4$ and $R^5$ is independently a group containing a photopolymerizable unsaturated double bond group or a polymerizable cyclic ether bond group and having a carbon number of 2 to 20, an aryl group having a carbon number of 6 to 20, an alkylaryl group having a carbon number of 2 to 20, an alkyl group having a carbon number of 1 to 20, which may be substituted with a mercapto group or an amino group, a cycloalkyl group having a carbon number of 5 to 20, or a group containing a carboxyl group or a dicarboxylic acid anhydride group and having a carbon umber of 4 to 20, $R^4$ and $R^5$ may be the same or different and may be bonded to each other through a covalent bond, each $R^3$ is independently at least one monovalent organic group selected from the group consisting of a methoxy group, an ethoxy group, a propoxy group and an isopropoxy group, a hydroxyl group or Cl, b is an integer selected from 0 to 2, c is an integer of 0 or 1, but b+c does not exceed 2}.

The alkali-soluble silicone resin (A) is not particularly limited as long as it has a carboxyl group or a dicarboxylic acid anhydride group in one molecule, but it is preferred that $R^1$ of the silane compound (A-1) represented by formula (I) is a monovalent organic group containing a carboxyl group or a dicarboxylic acid anhydride, group represented by following formula (1) and having a carbon number of 4 to 20.

[Chem. 1]

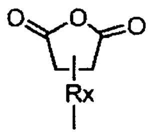
$R^1-1$

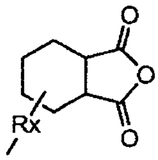
$R^1-2$

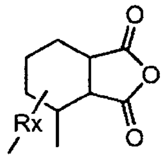
$R^1-3$

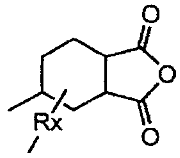
$R^1-4$

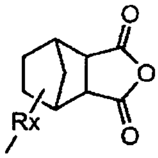
$R^1-5$

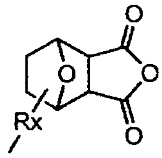
$R^1-6$

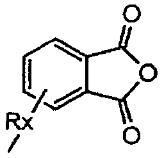
$R^1-7$

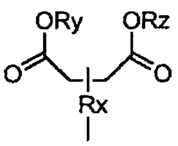
$R^1-8$

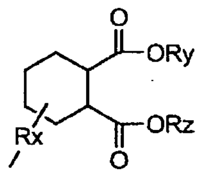
$R^1-9$

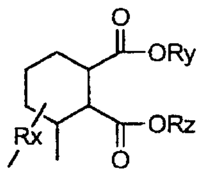
$R^1-10$

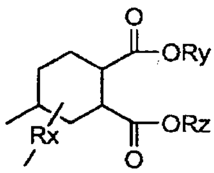
$R^1-11$

(1)

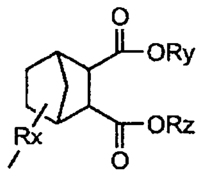
$R^1-12$

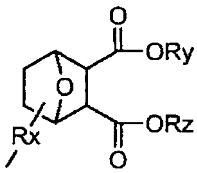
$R^1-13$

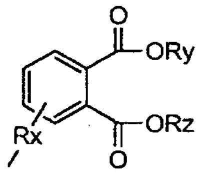
$R^1-14$

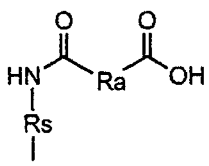
$R^1-15$

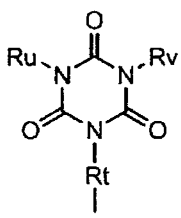
$R^1-16$

{wherein Rx is a linear or branched divalent organic group having a carbon number of 1 to 6, each of Ry and Rz is at least one member selected from the group consisting of a methyl group, an ethyl group, a propyl group, an isopropyl group and hydrogen, one or both of Ry and Rz are hydrogen, Ra is a linear, branched or cyclic divalent organic group having a carbon number of 2 to 16, Rs is a linear, branched or cyclic divalent organic group having a carbon number of 1 to 20, Rt is a linear, branched or cyclic divalent organic group having a carbon number of 1 to 18, and each of Ru and Rv is a linear, branched or cyclic monovalent organic group having a carbon number of 1 to 20 or a monovalent organic group represented by following formula (2)}:

[Chem. 2]

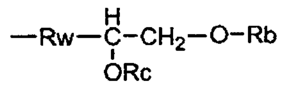

(2)

{wherein Rw is a linear, branched or cyclic divalent organic group having a carbon number of 1 to 16, Rb is a linear, branched or cyclic monovalent organic group having a carbon number of 1 to 20 or a monovalent organic group having a photopolymerizable unsaturated double bond group, and Rc is a group represented by following formula (3) or hydrogen}:

[Chem. 3]

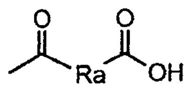

(3)

{wherein Ra is a linear, branched or cyclic divalent organic group having a carbon number of 2 to 16}.

In formula (I), the organic group preferred as $R^1$ includes, for example, a succinic acid anhydride group ($R^1$-1), a cyclohexanedicarboxylic acid anhydride group ($R^1$-2), a 4-methyl-cyclohexanedicarboxylic acid anhydride group ($R^1$-3), a 5-methyl-cyclohexanedicarboxylic acid anhydride group ($R^1$-4), a bicycloheptanedicarboxylic acid anhydride group ($R^1$-5), a 7-oxa-bicycloheptanedicarboxylic acid anhydride group ($R^1$-6), a phthalic acid anhydride group ($R^1$-7), a succinic acid group or a half ester group thereof ($R^1$-8), a cyclohexanedicarboxylic acid group or a half ester group thereof ($R^1$-9), a 4-methyl-cyclohexanedicarboxylic acid group or a half ester group thereof ($R^1$-10), a 5-methyl-cyclohexanedicarboxylic acid group or a half ester group thereof ($R^1$-11), bicycloheptanedicarboxylic acid group or a half ester group thereof ($R^1$-12), a 7-oxa-bicycloheptanedicarboxylic acid group or a half ester group thereof ($R^1$-13), a phthalic acid group or a half ester group thereof ($R^1$-14), a group having an amide bond by a reaction of an amino group and a dicarboxylic acid anhydride ($R^1$-15), and a group having an isocyanuric structure ($R^1$-16). These groups may be used individually or two or more thereof may be used in combination.

Rx in formula (1) is a linear or branched divalent organic group having a carbon number of 1 to 6. Among these, in view of ease of synthesis, Rx is preferably a hydrocarbon group. The hydrocarbon group includes, for example, a methylene group, an ethylene group, a propylene group, an isopropylene group, an n-butylene group, an isobutylene group, a sec-butylene group, a tert-butylene group, an n-pentylene group, an isopentylene group, a neopentylene group, and a tert-pentylene group. These groups may contain a double bond and/or a triple bond and may be used individually or two or more thereof may be used in combination. Among these, a propylene group is most preferred.

The group having an amide bond ($R^1$-15) in formula (1) is a carboxyl group-containing group obtained by a reaction of an amino group with a dicarboxylic acid anhydride. Rs is a linear, branched or cyclic divalent organic group having a carbon number of 1 to 20. The dicarboxylic acid anhydride includes, for example, a polybasic acid anhydride, such as succinic acid anhydride, cyclohexanedicarboxylic acid anhydride, 4-methyl-cyclohexanedicarboxylic acid anhydride, 5-methyl-cyclohexanedicarboxylic acid anhydride, bicycloheptanedicarboxylic acid anhydride, 7-oxabicycloheptanedicarboxylic acid anhydride, tetrahydrophthalic acid anhydride, trimellitic acid anhydride, pyromellitic acid anhydride, adipic acid anhydride, phthalic acid anhydride, (3-trimethoxysilylpropyl)succinic acid anhydride and (3-triethoxysilylpropyl)succinic acid anhydride. These may be used individually or two or more thereof may be used in combination.

The group having an isocyanuric structure ($R^1$-16) in formula (1) is a carboxyl group-containing group obtained by reacting a dicarboxylic acid anhydride with a hydroxyl group generated from an isocyanuric structure having a glycidyl group through a ring-opening reaction of glycidyl triggered by a reaction with a carboxyl group or a hydroxyl group.

In formula (I), the group most preferred as $R^1$ is a propylsuccinic acid anhydride group ($R^1$-1), or a propylsuccinic acid group or its half methyl ester group or half ethyl ester group ($R^1$-8).

In formula (I), the group most preferred as $R^3$ is a methoxy group or an ethoxy group.

Among the alkoxysilane compounds containing a carboxyl group or a dicarboxylic acid anhydride group represented by formula (I), most preferred compounds are (3-trimethoxysilylpropyl)succinic acid anhydride, (3-triethoxysilylpropyl)succinic acid anhydride, (3-trimethoxysilylpropyl)succinic acid, (3-triethoxysilylpropyl)succinic acid, the half methyl ester of (3-trimethoxysilylpropyl)succinic acid, the half methyl ester of (3-triethoxysilylpropyl)succinic acid, the half

ethyl ester of (3-trimethoxysilylpropyl)succinic acid, and the half ethyl ester of (3-triethoxysilylpropyl)succinic acid.

In formula (II), $R^4$ and $R^5$ are as defined above.

Among specific examples of the silane compound (A-2) represented by formula (II), the photopolymerizable unsaturated double bond group-containing compound includes 3-(meth)acryloxypropyltrimethoxysilane, 3-(meth)acryloxypropyltriethoxysilane, 3-(meth)acryloxypropylmethyldimethoxysilane, 3-(meth)acryloxypropylmethyldiethoxysilane, p-styryltrimethoxysilane, p-styryltriethoxysilane, p-(1-propenylphenyl)trimethoxysilane, p-(1-propenylphenyl)triethoxysilane, p-(2-propenylphenyl)trimethoxysilane, p-(2-propenylphenyl)triethoxysilane, etc. Incidentally, the "(meth)acryl" as used in the description of the present invention means acryl or methacryl.

Among specific examples of the silane compound (A-2) represented by formula (II), the polymerizable cyclic ether bond group-containing compound includes 3-glycidoxypropyltrimethoxysilane, 3-glycidoxypropyltriethoxysilane, 3-glycidoxypropylmethyldimethoxysilane, 3-glycidoxypropylmethyldiethoxysilane, 2-(3,4-epoxycyclohexyl)trimethoxysilane, 2-(3,4-epoxycyclohexyl)triethoxysilane, 2-(3,4-epoxycyclohexyl)methyldimethoxysilane, 2-(3,4-epoxycyclohexyl)methyldiethoxysilane, etc..

Specific examples of the compound represented by formula (II) other than those described above include methyltrimethoxysilane, methyltriethoxysilane, dimethyldimethoxysilane, dimethyldiethoxysilane, ethyltrimethoxysilane, ethyltriethoxysilane, diethyldimethoxysilane, diethyldiethoxysilane, vinyltrimethoxysilane, vinyltriethoxysilane, cyclohexyltrimethoxysilane, cyclohexyltriethoxysilane, cyclohexylmethyldimethoxysilane, cyclohexylmethyldiethoxysilane, phenyltrimethoxysilane, phenyltriethoxysilane, phenylmethyldimethoxysilane, phenylmethyldiethoxysilane, dicyclopentyldimethoxysilane, dicyclopentyldiethoxysilane, diphenyldimethoxysilane, diphenyldiethoxysilane, octadecyltrimethoxysilane, octadecyltriethoxysilane, N-2-(aminoethyl)-3-aminopropyltrimethoxysilane, N-2-(aminoethyl)-3-aminopropyltriethoxysilane, N-2-(aminoethyl)-3-aminopropylmethyldimethoxysilane, N-2-(aminoethyl)-3-aminopropylmethyldiethoxysilane, 3-aminopropyltrimethoxysilane, 3-aminopropyltriethoxysilane, 3-aminopropylmethyldimethoxysilane, 3-aminopropyldiethoxysilane, N-phenyl-3-aminopropyltrimethoxysilane, N-phenyl-3-aminopropyltriethoxysilane, a hydrochloride of N-(vinylbenzyl)-2-aminoethyl-3-aminopropyltrimethoxysilane, 3-mercaptopropyltrimethoxysilane, 3-mercaptopropyltriethoxysilane, 3-mercaptopropylmethyldimethoxysilane, 3-mercaptopropylmethyldiethoxysilane, methyltrichlorosilane, phenyltrichlorosilane, dimethyldichlorosilane, trimethylchlorosilane, triethylchlorosilane, tert-butyldimethylchlorosilane, and tri-i-propylchlorosilane, etc. These compounds may be used individually or two or more thereof may be used in combination.

The alkali-soluble silicone resin (A) is obtained, for example, by hydrolyzing the silane compound (A-1) represented by formula (I) and the silane compound (A-2) represented by formula (II) by the addition of water and a catalyst, and then condensing the hydrolysate in presence or absence of a solvent.

The hydrolysis reaction is carried out by adding an acidic catalyst and water to the silane compound over 1 to 180 minutes in a solvent. The temperature in the process of obtaining the hydrolysate is, in view of reactivity of the hydrolysis, preferably 10°C or more, more preferably 20°C or more, and in view of protection of a functional group, is preferably 150°C or less, more preferably 120°C or less. The reaction time in the process of obtaining the hydrolysate is, in view of reactivity of the hydrolysis, preferably 0.1 hours or more, more preferably 0.5 hours or more, and in view of protection of a functional group, is preferably 10 hours or less, more preferably 5 hours or less.

The hydrolysis reaction is preferably carried out in the presence of an acidic catalyst. The acidic catalyst is preferably an acidic aqueous solution containing hydrochloric acid, nitric acid, sulfuric acid, formic acid, acetic acid or phosphoric acid. The preferred content of the acidic catalyst is, in view of reactivity of the hydrolysis, preferably 0.01 parts by mass or more and in view of protection of a functional group, is preferably 10 parts by mass or less, per 100 parts by mass of all silane compounds used at the hydrolysis reaction.

After obtaining a silanol compound by the hydrolysis reaction of silane compound, the reaction solution is preferably heated as it is at from 50°C to a boiling point of the solvent for 1 to 100 hours to carry out a condensation reaction. Also, in order to increase the polymerization degree of the alkali-soluble silicone resin (A), reheating and/or pressure reduction and/or addition of a basic catalyst may be carried out.

The solvent used for the hydrolysis reaction of silane compound and the condensation reaction of the hydrolysate is not particularly limited and may be appropriately selected by taking into account the stability, wettability, volatility, etc. of the resin composition. Also, two or more kinds of solvents may be combined, or the reaction may be carried out without solvent.

Specific examples of the solvent include alcohols such as, methanol, ethanol, propyl alcohol, isopropyl alcohol, butyl alcohol, isobutyl alcohol, tert-butyl alcohol, pentyl alcohol, isopentyl alcohol and diacetone alcohol; glycols, such as ethylene glycol and propylene glycol; ethers, such as ethylene glycol monomethyl ether, ethylene glycol monoethyl ether, propylene glycol monomethyl ether, propylene glycol monoethyl ether, ethylene glycol dimethyl ether and ethylene glycol diethyl ether; ketones, such as methyl ethyl ketone, acetylacetone, methyl propyl ketone, methyl butyl ketone, methyl isobutyl ketone and cyclopentanone; acetates, such as ethylene glycol monoethyl ether acetate, propylene glycol monoethyl ether acetate, methyl lactate, ethyl lactate and butyl lactate; $\gamma$-butyrolactone; N-methyl-2-pyrrolidone; dimethylsulfoxide; and dimethylacetamide.

In the case where a solvent is produced by the hydrolysis reaction, it is also possible to carry out the hydrolysis without a solvent. After the completion of reaction, further addition of a solvent so as to adjust the concentration of the resin composition to an appropriate concentration is also preferred. Furthermore, after the hydrolysis according to the purpose, an appropriate amount of a resulting alcohol, etc., produced may be removed by distillation and thereafter, a proper solvent may be added.

The amount of the solvent used for the hydrolysis is preferably from 80 to 500 parts by mass per 100 parts by mass of all silane compounds.

The water used for the hydrolysis is preferably ion-exchanged water. The amount of water may be arbitrarily selected but is preferably from 1.0 to 4.0 mol per mol of silane atom.

As regards the production method of the alkali-soluble silicone resin (A) for use in the present invention, in addition to the reaction above, the reaction may be carried out without adding water in the case of dealing with silanol, because water is generated by the dehydration condensation of silanols, and may be carried out without adding a catalyst in the case of dealing with chlorosilane.

In the alkali-soluble silicone resin (A), from the standpoint of reducing shrinkage due to condensation of silanols during baking or reducing degassing from water generated by the condensation, the remaining silanol amount is preferably smaller, and it is more preferred that the remaining silanol is substantially nulled.

More preferably, the alkali-soluble silicone resin

(A) is obtained by reacting:

(A-1) an alkoxysilane containing a carboxyl group and/or an carboxylic acid anhydride group represented by formula (I);
(A-2) an alkoxysilane represented by formula (II); and
(A-3) a silanediol compound represented by following formula (III),
in the presence of a catalyst,
or preferably by a method of causing condensation without positively adding water:

$$R^6{}_2Si(OH)_2 \qquad (III)$$

{wherein each $R^6$ is independently an aryl group having a carbon number of 6 to 20, an alkylaryl group having a carbon number of 2 to 20, an alkyl group having a carbon number of 1 to 20, or a cycloalkyl group having a carbon number of 5 to 20, and a plurality of $R^6$ may be the same or different and may be bonded to each other through a covalent bond}.

In the silanediol compound represented by formula (III), $R^6$ is as defined above. $R^6$ includes, for example, a phenyl group, a tolyl group, a xylyl group, a trimethylphenyl group, a naphthyl group, a methyl group, an ethyl group, a cyclopentyl group, and a cyclohexyl group.

Specific examples of the silanediol compound include diphenylsilanediol, di-p-toluoylsilanediol, dixylylsilanediol, ditrimethylphenylsilanediol, di-p-styrylsilanediol, dinaphthylsilanediol, dicyclopentylsilanediol, and cyclohexylmethylsilanediol, and in view of copolymerization and heat resistance, diphenylsilanediol, dicyclopentylsilanediol and cyclohexylmethylsilanediol are particularly preferred.

The alkali-soluble silicon resin (A) for use in the present invention, in which the remaining silanol amount is small or the remaining silanol is substantially nulled, is obtained, for example, by a method of condensing the alkoxysilane compound (A-1) represented by formula (I), the alkoxysilane compound (A-2) represented by formula (II) and the silanediol compound (A-3) represented by formula (III) in the presence of a catalyst without positively adding water.

The reaction temperature when condensing the silane compounds (A-1), (A-2) and/or (A-3) without positively adding water is, in view of reactivity of condensation, preferably 40°C or more, more preferably 50°C or more, and in view of protection of a functional group, is preferably 150°C or less, more preferably 120°C or less.

The reaction time when carrying out condensation without positively adding water is, in view of reactivity of condensation, preferably 0.5 hours or more, more preferably 1 hour or more, and in view of protection of a functional group, is preferably 15 hours or less, more preferably 10 hours or less.

In the reaction of causing condensation without positively adding water, a catalyst is used, and water is not positively added. As the catalyst, a metal alkoxide-based catalyst, a basic catalyst or an acidic catalyst can be used.

As the metal alkoxide-based catalyst, a trivalent or tetravalent metal alkoxide can be used. Specifically, this metal alkoxide includes trimethoxy aluminum, triethoxy aluminum, tri-n-propoxy aluminum, tri-iso-propoxy aluminum, tri-n-butoxy aluminum, tri-iso-butoxy aluminum, tri-sec-butoxy aluminum, tri-tert-butoxy aluminum, trimethoxy boron, triethoxy boron, tri-n-propoxy boron, tri-iso-propoxy boron, tri-n-butoxy boron, tri-iso-butoxy boron, tri-sec-butoxy boron, tri-tert-butoxy boron, tetramethoxysilane, tetraethoxysilane, tetra-n-propoxysilane, tetra-iso-propoxysilane, tetra-n-butoxysilane, tetra-iso-butoxysilane, tetra-sec-butoxysilane, tetra-tert-butoxysilane, tetramethoxy germanium, tetraethoxy

germanium, tetra-n-propoxy germanium, tetra-iso-propoxy germanium, tetra-n-butoxy germanium, tetra-iso-butoxy germanium, tetra-sec-butoxy germanium, tetra-tert-butoxy germanium, tetramethoxy titanium, tetraethoxy titanium, tetra-n-propoxy titanium, tetra-iso-propoxy titanium, tetra-n-butoxy titanium, tetra-iso-butoxy titanium, tetra-sec-butoxy titanium, tetra-tert-butoxy titanium, tetramethoxy zirconium, tetraethoxy zirconium, tetra-n-propoxy zirconium, tetra-iso-propoxy zirconium, tetra-n-butoxy zirconium, tetra-iso-butoxy zirconium, tetra-sec-butoxy zirconium, and tetra-tert-butoxy zirconium.

Also, a hydroxide of alkali metal or a hydroxide of alkaline earth metal, such as barium hydroxide, sodium hydroxide, potassium hydroxide, strontium hydroxide, calcium hydroxide and magnesium hydroxide, may be used as the basic catalyst. Furthermore, $NH_4F$, i.e., ammonium fluoride, may be also used as the basic catalyst. Among these, barium hydroxide, sodium hydroxide, strontium hydroxide, tetra-tert-butoxy titanium and tetra-iso-propoxy titanium are preferred. In order to achieve a rapid and uniform polymerization reaction, the basic catalyst is preferably liquid in the reaction temperature region.

The preferred content of the metal alkoxide-based catalyst or basic catalyst is, in view of condensation reactivity, preferably 0.01 parts by mass or more and in view of protection of a functional group, is preferably 10 parts by mass or less, per 100 parts by mass of all silane compounds.

As for the acidic catalyst, an organic acidic catalyst containing no water can be used. Specifically, this acidic catalyst includes acetic acid, trifluoroacetic acid, acrylic acid, methacrylic acid, citric acid, malic acid, succinic acid, phthalic acid, (3-trimethoxysilylpropyl)succinic acid or a half ester thereof, and (3-triethoxysilylpropyl)succinic acid or a half ester thereof, etc.

The preferred content of the acidic catalyst is, in view of condensation reactivity, preferably 0.01 parts by mass or more, and in view of protection of a functional group, is preferably 10 parts by mass or less, per 100 parts by mass of all silane compounds.

<(B) Alkali-Soluble Resin>

The alkali-soluble resin (B) is an alkali-soluble resin containing an alkali-soluble group and having an acid value of 10 to 200 mgKOH/g.

The acid value of the alkali-soluble resin (B) is, from the standpoint of reducing residue during development, 10 mgKOH/g or more, preferably 20 mgKOH/g or more, and in view of pattern adherence, is 200 mgKOH/g or less, preferably 190 mgKOH/g or less.

The alkali-soluble resin (B) is not particularly limited as long as it contains an alkali-soluble group and has an acid value of 10 to 200 mgKOH/g, but the resin preferably has a carboxyl group or a dicarboxylic acid anhydride group in one molecule. By virtue of having a carboxyl group in the alkali-soluble resin (B), the photosensitive alkali-soluble silicone resin composition exhibits alkali solubility while maintaining heat-resistant transparency, and good physical film properties are obtained.

The alkali-soluble resin (B) is not particularly limited as long as it contains an alkali-soluble group and has an acid value of 10 to 200 mgKOH/g, but the resin preferably has photopolymerizable double bond group in one molecule. By virtue of having a photopolymerizable double bond group in the alkali-soluble resin, the alkali-soluble silicone resin composition exhibits alkali solubility while maintaining heat-resistant transparency and furthermore, the adherence of pattern, the film hardness and the crack resistance are increased, so that good physical film properties are obtained. The photopolymerizable double bond group includes, for example, an acryl group and a methacryl group.

Regarding the content of the photopolymerizable unsaturated double bond group of the alkali-soluble resin (B), from the standpoint of obtaining sufficient resolution, the molar concentration is preferably 0.2 mmol/g or more, more preferably 0.4 mmol/g or more, and from the standpoint of reducing the residue, the molar concentration is preferably 6.0 mmol/g or less, more preferably 5.0 mmol/g or less.

The weight average molecular weight (Mw) of the alkali-soluble resin (B) for use in the present invention is, in terms of polystyrene measured by gel permeation chromatography (GPC), preferably 600 or more, more preferably 1,000 or more, from the standpoint of solidifying the alkali-soluble resin and maintaining the strength of the cured film, and is preferably 100,000 or less, more preferably 80,000 or less, from the standpoint of obtaining compatibility with the alkali-soluble silicone resin and sufficient resolution of the photosensitive resin composition.

A general silicone resin has low compatibility with an organic component, particularly with an organic resin having a high molecular weight, and therefore, when mixed and used for film production, phase separation occurs in forming a uniform film, and the transparency is also greatly reduced. Furthermore, when the silicone component becomes excessive in the cured film, cracks are likely to occur in a thick film at a high temperature, and thus result in reduction in transparency.

In the photosensitive alkali-soluble silicone resin composition for use in the present invention, for the purpose of eliminating the phenomenon above, the structure of the substituent of the alkali-soluble silicone resin (A) and the structure of the substituent of the alkali-soluble resin (B) are preferably designed to belong to the same class and the

molar numbers of the substituents are preferably designed to lie at the same level. As an example of designing the structures so as to belong to the same class, when the alkali-soluble silicone resin (A) has an aromatic substituent and a carboxyl group, the alkali-soluble resin (B) preferably also has an aromatic substituent and a carboxyl group, and when the alkali-soluble silicone resin (A) has an aliphatic substituent and a carboxyl group, the alkali-soluble resin (B) preferably also has an aliphatic substituent and a carboxyl group. The resin may have one or more of these substituents or may have a plurality of substituents.

In the photosensitive alkali-soluble silicone resin composition of the present invention, the content of the alkali-soluble resin (B) is not particularly limited and may be arbitrarily selected according to the desired film thickness or usage, but the content is, in view of thermal crack resistance, preferably 1 mass% or more, more preferably 5 mass% or more, still more preferably 10 mass% or more, and in view of heat-resistant transparency, is preferably 50 mass% or less, more preferably 45 mass% or less, still more preferably 40 mass% or less, based on the mass of all components except for the solvent in the photosensitive alkali-soluble silicone resin composition.

The alkali-soluble resin (B) contains an alkali-soluble group and is preferably at least one polymer selected from the group consisting of the following (1) to (5):

(1) a vinyl polymer mainly composed of a reaction product of a compound having a polymerizable unsaturated double bond,
(2) an epoxy polymer mainly composed of an addition reaction product of an epoxy group and a hydroxyl group,
(3) an aromatic methylene polymer mainly composed of a reaction product of phenol and formaldehyde,
(4) a urethane polymer mainly composed of a reaction product of dialcohol and diisocyanate, and
(5) an ester polymer mainly composed of a reaction product of dicarboxylic acid and diepoxide. In the polymers (1) to (5) above, "mainly composed of" means to contain the component at a ratio of 70 mol% or more in the molecule.

The polymers (1) to (5) are described in detail below.

(1) vinyl polymer mainly composed of a reaction product of a polymerizable unsaturated double bond

This polymer includes, for example, a carboxyl group-containing vinyl polymer represented by following formula (4) or (6):

[Chem. 4]

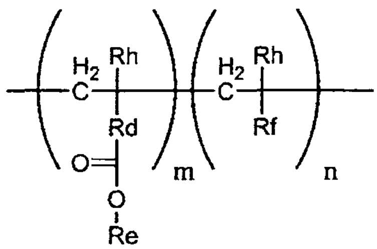

(4)

{wherein Rd is a linear, branched or cyclic divalent organic group having a carbon number of 0 to 20, Re is a monovalent organic group represented by following formula (5) :

[Chem. 5]

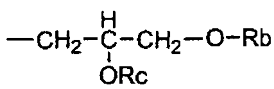

(5)

(wherein Rb is a linear, branched or cyclic monovalent organic group having a carbon number of 1 to 20 or a monovalent organic group having a photopolymerizable unsaturated double bond group, Rc is a group represented by above formula (3) or hydrogen) or hydrogen, Rf is a linear, branched or cyclic monovalent organic group having a carbon number of 1 to 20, Rh is a methyl group or hydrogen, m is an integer selected from 1 to 500, and n is an integer selected from 10 to

1,000};

[Chem. 6]

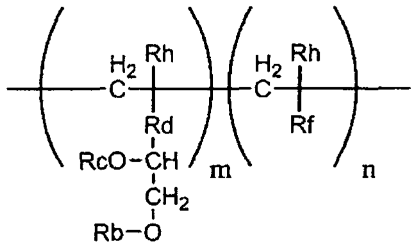

(6)

{wherein Rb is a linear, branched or cyclic monovalent organic group having a carbon number of 1 to 20 or a monovalent organic group having a photopolymerizable unsaturated double bond group, Rc is a group represented by above formula (3) or hydrogen, Rd is a linear, branched or cyclic divalent organic group having a carbon number of 0 to 20 or a divalent organic group which may have a photopolymerizable unsaturated double bond, Rf is a linear, branched or cyclic monovalent organic group having a carbon number of 1 to 20, Rh is a methyl group or hydrogen, m is an integer selected from 1 to 500, and n is an integer selected from 10 to 1,000}.

The method for obtaining a carboxyl group-containing vinyl polymer includes, for example, the following three methods:

(i) a method of vinyl-copolymerizing (a) at least one compound selected from α,β-unsaturated carboxylic acids and (b) at least one compound selected from an alkyl (meth)acrylate, hydroxyalkyl (meth)acrylate, (meth)acrylamide or a compound obtained by replacing hydrogen on nitrogen thereof by an alkyl group or an alkoxy group, styrene or a styrene derivative, (meth)acrylonitrile, and glycidyl (meth)acrylate,
(ii) a method of vinyl-copolymerizing the compound (a) and the compound (b) and thereafter, addition-reacting a carboxyl group of the vinyl-copolymerization product with (c) at least one compound selected from the compounds containing an epoxy group and a (meth)acryl group in one molecule, and
(iii) a method of vinyl-polymerizing the compound (b) and the compound (c), addition-reacting an epoxy group of the vinyl polymerization product with the compound (a), and further addition-reacting the produced hydroxyl group with (d) a dicarboxylic acid anhydride.

The compound (a) for use in the preparation of the carboxy-containing vinyl polymer includes, for example, (meth)acrylic acid, (meth)acrylic acid, carboxyethyl (meth)acrylate, carboxypentyl (meth)acrylate, 2-(meth)acryloxyethylsuccinic acid, 2-(meth)acryloxyethylhexahydrophthalic acid, 2-(meth)acryloxyethylphthalic acid, fumaric acid, cinnamic acid, crotonic acid, itaconic acid, and a maleic acid half ester. These compounds may be used individually or two or more thereof may be used in combination.

The compound (b) for use in the preparation of the carboxyl group-containing vinyl polymer includes, for example, methyl (meth)acrylate, ethyl (meth)acrylate, n-propyl (meth)acrylate, lauryl (meth)acrylate, cyclohexyl (meth)acrylate, n-butyl (meth)acrylate, 2-ethylhexyl (meth)acrylate, 2-hydroxyethyl (meth)acrylate, 2-hydroxypropyl (meth)acrylate, 4-hydroxybutyl (meth)acrylate, caprolactone (meth)acrylate, nonylphenoxypolypropylene glycol (meth)acrylate, polyethylene glycol mono(meth)acrylate, polypropylene glycol mono(meth)acrylate, (meth)acrylamide, N-methylolacrylamide, N-butoxymethylacrylamide, styrene, α-methylstyrene, p-methylstyrene, p-chlorostyrene, benzyl (meth)acrylate, 4-hydroxybenzyl (meth)acrylate, 4-methoxybenzyl (meth)acrylate, 4-methylbenzyl (meth)acrylate, 4-chlorobenzyl (meth)acrylate, (meth)acrylonitrile, glycidyl (meth)acrylate, 3-methyl-3-(meth)acrylate, 3-ethyl-3-(meth)acryloxymethyloxetane, hexafluoropropyl (meth)acrylate, 3-(meth)acryloylpropyltrimethoxysilane, and 3-(meth)acryloylpropyltriethoxysilane, etc. These compounds may be used individually or two or more thereof may be used in combination.

The compound (c) for use in the preparation of the carboxyl group-containing vinyl polymer is not particularly limited as long as it is a half ester of epoxy (meth)acrylate obtained by reacting an epoxy resin having two epoxy groups with a (meth)acrylic acid by a conventional method, and includes, for example, glycidyl (meth)acrylate; 3,4-epoxycyclohexylmethyl (meth)acrylate; 3,4-epoxycyclohexylethyl (meth)acrylate; vinyl cyclohexene monoxide; a half ester of (meth)acrylic acid with a phenyl diglycidyl ether, such as hydroquinone diglycidyl ether, catechol diglycidyl ether and resorcinol diglycidyl ether; a half ester of (meth)acrylic acid with a bisphenol-type epoxy compound, such as bisphenol A-type epoxy resin, bisphenol F-type epoxy resin, bisphenol S-type epoxy resin and an epoxy compound of 2,2-bis(4-hydroxyphenyl)-1,1,1,3,3,3-hexafluoropropane; a half ester of (meth)acrylic acid with a hydrogenated bisphenol-type

epoxy compound, such as hydrogenated bisphenol A-type epoxy resin, hydrogenated bisphenol F-type epoxy resin, hydrogenated bisphenol S-type epoxy resin and an epoxy compound of hydrogenated 2,2-bis(4-hydroxyphenyl)-1,1,1,3,3,3-hexafluoropropane; a half ester of (meth)acrylic acid with an alicyclic diglycidyl ether compound, such as cyclohexanedimethanol diglycidyl ether compound; and a half ester of (meth)acrylic acid with an aliphatic diglycidyl ether compound, such as 1,6-hexanediol diglycidyl ether, 1,4-butanediol diglycidyl ether and diethylene glycol diglycidyl ether. These compounds may be used individually or two or more thereof may be used in combination.

The compound (d) for use in the preparation of the carboxyl group-containing vinyl polymer includes, for example, a polybasic acid anhydride, such as succinic acid anhydride, cyclohexanedicarboxylic acid anhydride, 4-methyl-cyclohexanedicarboxylic acid anhydride, 5-methyl-cyclohexanedicarboxylic acid anhydride, bicycloheptane-dicarboxylic acid anhydride, 7-oxabicycloheptane-dicarboxylic acid anhydride, tetrahydrophthalic acid anhydride, trimellitic acid anhydride, pyromellitic acid anhydride, adipic acid anhydride, phthalic acid anhydride, (3-trimethoxysilylpropyl)succinic acid anhydride and (3-triethoxysilylpropyl)succinic acid anhydride. These compounds may be used individually or two or more thereof may be used in combination.

The vinyl copolymerization in the preparation of the carboxyl group-containing vinyl polymer can be carried out by a conventional method, and a known method, such as solution polymerization, suspension polymerization and emulsion polymerization method can be used, but solution polymerization is preferred in view of ease of handling. In this case, the polymerization initiator that can be used is preferably a polymerization initiator whose 10-hour half-life temperature is from 60 to 120°C. Such a polymerization initiator includes azo group-containing compuonds, such as 2,2'-azobisisobutyronitrile, 2,2'-azobis(2,4-dimethylvaleronitrile), 2,2'-azobis(2-methylbutylnitrile), 2,2'-azobis(2-methylpropionate), 2,2'-azobis(N-cyanohexyl-2-methylpropionamide) and 2,2'-azobis(N-(2-propenyl)-2-methylpropionamide); peroxyesters, such as 1,1,3,3-tetramethylbutylperoxy-2-ethylhexanoate, tert-hexylperoxy-2-ethylhexanoate, tert-amylperoxy-2-ethylhexanoate, tert-butylperoxy-2-ethylhexanoate, tert-butyl peroxyisobutyrate, tert-butylperoxymaleic acid, tert-amylperoxy-3,5,5-trimethylhexanoate, tert-butyl peroxylaurate, tert-hexyl peroxybenzoate, tert-butyl peroxyacetate, tert-butylperoxy-m-toluylbenzoate and tert-butyl peroxybenzoate; peroxymonocarbonates, such as tert-hexylperoxyisopropyl monocarbonate, tert-butylperoxyisopropyl monocarbonate and tert-butylperoxy-2-ethylhexyl monocarbonate; diacyl peroxides, such as bis-3,5,5-trimethylhexanoyl peroxide, octanoyl peroxide, lauroyl peroxide, benzoyl peroxide and p-chlorobenzoyl peroxide; and dialkyl peroxides, such as dicumyl peroxide and tert-butylcumyl peroxide. These compounds may be used individually or two or more thereof may be used in combination.

As for the addition reaction of a carboxyl group with a compound containing an epoxy group and a (meth)acryl group, the reaction is preferably carried out in a solvent by using a polymerization inhibitor and a catalyst, and the reaction temperature is preferably from 50 to 120°C.

The reaction solvent includes, for example, ketones, such as methyl ethyl ketone and cyclohexanone; aromatic hydrocarbons, such as toluene, xylene and tetramethylbenzene; glycol ethers, such as ethylene glycol monoethyl ether, ethylene glycol monomethyl ether, ethylene glycol monobutyl ether, diethylene glycol monoethyl ether, diethylene glycol monomethyl ether, diethylene glycol monobutyl ether, propylene glycol monomethyl ether, propylene glycol monoethyl ether, dipropylene glycol diethyl ether and triethylene glycol monoethyl ether; acetic acid esters, such as ethyl acetate, butyl acetate, ethylene glycol monoethyl ether acetate, ethylene glycol monobutyl ether acetate, diethylene glycol monoethyl ether acetate, diethylene glycol monobutyl ether acetate, propylene glycol monomethyl ether acetate and dipropylene glycol monomethyl ether acetate; alcohols, such as ethanol, propanol, ethylene glycol and propylene glycol; aliphatic hydrocarbons, such as octane and decane; and petroleum-based solvents, such as petroleum ether, petroleum naphtha, hydrogenated petroleum naphtha and solvent naphtha. These solvents may be used individually or two or more thereof may be used in combination.

The reaction catalyst for the reaction above in the preparation of the carboxyl group-containing vinyl polymer includes, for example, a tertiary amine, such as triethylamine; a quaternary ammonium salt, such as triethylbenzylammonium chloride; an imidazole compound, such as 2-ethyl-4-methylimidazole; a phosphorus compound, such as triphenylphosphine; and a metal salt of an organic acid, such as lithium, chromium, zirconium, potassium or sodium salt of naphthenic acid, lauric acid, stearic acid, oleic acid or octenoic acid. These compounds may be used individually or two or more thereof may be used in combination.

The polymerization inhibitor in the preparation of the carboxyl group-containing vinyl polymer includes, for example, hydroquinone, methyl hydroquinone, hydroquinone monomethyl ether, catechol, pyrogallol, phenothiazine, etc. These compounds may be used individually or two or more thereof may be used in combination.

Furthermore, a dicarboxylic acid anhydride can be partially added to a hydroxyl group of the reaction product material above, and the reaction temperature is preferably from 50 to 120°C.

(2) Epoxy polymer mainly composed of an addition reaction product of an epoxy group and a hydroxyl group

The polymer includes, for example, a carboxyl group-containing epoxy polymer represented by following formula (7):

[Chem. 7]

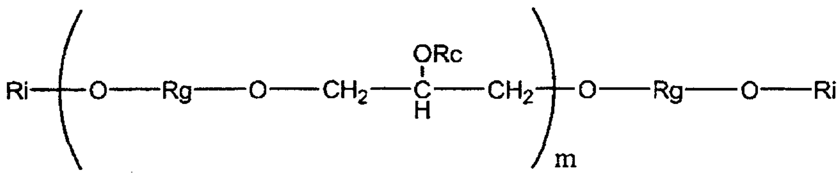

(7)

{wherein Rc is a group represented by formula (3) or hydrogen, Rg is a linear, branched or cyclic divalent organic group having a carbon number of 2 to 20, Ri is a monovalent organic group represented by above formula (5) or following formula (8):

[Chem. 8]

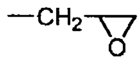

(8)

and m is an integer selected from 0 to 1,000}.

The carboxyl group-containing epoxy polymer for use in the present invention is obtained by reacting a dialcohol compound and epihalohydrin to form a both-ends epoxy compound having, in the skeleton, an ether bond occurring as a result of a reaction of an epoxy group and an alcohol group, and reacting a hydroxyl group of the reaction product above with a dicarboxylic acid anhydride. In addition, the both-ends epoxy group of the reaction product above may be addition-reacted with a (meth)acrylate compound having a carboxyl group or a hydroxyl group, or a hydroxyl group of the reaction product may be further reacted with a dicarboxylic acid anhydride.

Examples of the dialcohol compound for use in the preparation of the carboxyl group-containing epoxy polymer include bisphenols, such as bisphenol A, bisphenol F and bisphenol S; hydrogenated bisphenols, such as hydrogenated bisphenol A, hydrogenated bisphenol F and hydrogenated bisphenol S; a both-ends ethylene oxide (molar number of ethylene oxide: from 1 to 10) adduct of bisphenol, such as bisphenol A, bisphenol F and bisphenol S; a both-ends propylene oxide (molar number of propylene oxide: from 1 to 10) adduct of bisphenol, such as bisphenol A, bisphenol F and bisphenol S; a both-ends ethylene oxide (molar number of ethylene oxide: from 1 to 10) adduct of bisphenol, such as hydrogenated bisphenol A, hydrogenated bisphenol F and hydrogenated bisphenol S; a both-ends propylene oxide (molar number of propylene oxide: from 1 to 10) adduct of bisphenol, such as hydrogenated bisphenol A, hydrogenated bisphenol F and hydrogenated bisphenol S; an alkyl ($C_2$-$C_{10}$) dialcohol, a polyethylene glycol (molar number of ethylene oxide: from 1 to 10), and a polypropylene glycol (molar number of propylene oxide: from 1 to 10). These compounds may be used individually or two or more thereof may be used in combination.

Examples of the epihalohydrin for use in the preparation of the carboxyl group-containing epoxy polymer include epichlorohydrin and epibromohydrin. These may be used individually or two or more thereof may be used in combination.

Examples of the compound having a carboxyl group and a (meth)acrylate group in one molecule for use in the preparation of the carboxyl group-containing epoxy polymer include (meth)acrylic acid, (meth)acrylic acid, carboxyethyl (meth)acrylate, carboxypentyl (meth)acrylate, 2-(meth)acryloxyethylsuccinic acid, 2-(meth)acryloxyethylhexahydrophthalic acid, 2-(meth)acryloxyethylphthalic acid, fumaric acid, cinnamic acid, crotonic acid, itaconic acid, and a maleic acid half ester. These compounds may be used individually or two or more thereof may be used in combination.

Examples of the compound having a hydroxyl group and a (meth)acrylate group in one molecule for use in the preparation of the carboxyl group-containing epoxy polymer include 2-hydroxyethyl (meth)acrylate, 3-hydroxypropyl (meth)acrylate, 4-hydroxybutyl (meth)acrylate, glycerol mono(meth)acrylate, 4-hydroxyvinylbenzene, 2-hydroxy-3-phenoxypropyl (meth)acrylate, glycerol di(meth)acrylate, trimethylolpropane di(meth)acrylate, glycerol methacrylate acrylate, pentaerythritol tri(meth)acrylate, and a caprolactone adduct of these monomers.

Examples of the epoxy (meth)acrylate compound obtained by modifying an epoxy group with (meth)acrylate include an epoxy (meth)acrylate of a phenyl diglycidyl ether, such as hydroquinone diglycidyl ether, catechol diglycidyl ether and resorcinol diglycidyl ether; an epoxy (meth)acrylate of a bisphenol-type epoxy compound, such as bisphenol A-type epoxy resin, bisphenol F-type epoxy resin, bisphenol S-type epoxy resin and an epoxy compound of 2,2-bis(4-hydroxyphenyl)-1,1,1,3,3,3-hexafluoropropane; an epoxy (meth)acrylate of a hydrogenated bisphenol-type epoxy compound, such as hydrogenated bisphenol A-type epoxy resin, hydrogenated bisphenol F-type epoxy resin, hydrogenated

bisphenol S-type epoxy resin and an epoxy compound of hydrogenated 2,2-bis(4-hydroxyphenyl)-1,1,1,3,3,3-hexafluoropropane; an epoxy (meth)acrylate of an alicyclic diglycidyl ether compound, such as cyclohexanedimethanol diglycidyl ether compound; and an epoxy (meth)acrylate of an aliphatic diglycidyl ether compound, such as 1,6-hexanediol diglycidyl ether, 1,4-butanediol diglycidyl ether and diethylene glycol diglycidyl ether.

The dicarboxylic acid anhydride for use in the preparation of the carboxyl group-containing epoxy polymer includes a polybasic acid anhydride, such as succinic acid anhydride, cyclohexanedicarboxylic acid anhydride, 4-methyl-cyclohexanedicarboxylic acid anhydride, 5-methyl-cyclohexanedicarboxylic acid anhydride, bicycloheptane-dicarboxylic acid anhydride, 7-oxabicycloheptane-dicarboxylic acid anhydride, tetrahydrophthalic acid anhydride, trimellitic acid anhydride, pyromellitic acid anhydride, adipic acid anhydride, phthalic acid anhydride, (3-trimethoxysilylpropyl)succinic acid anhydride and (3-triethoxysilylpropyl)succinic acid anhydride. These compounds may be used individually or two or more thereof may be used in combination.

The reaction of an epihalohydrin in the preparation of the carboxyl group-containing epoxy polymer can be carried out by a conventional method. After or while adding an alkali metal hydroxide, such as sodium hydroxide and potassium hydroxide to a dissolved mixture of a dialcohol compound and an epihalohydrin, such as epichlorohydrin and epibromohydrin, the reaction is allowed to proceed at 20 to 120°C for 1 to 10 hours, whereby an epoxy resin can be obtained. After washing the reaction product of such an epoxidation reaction with water or not washing it with water, the epihalohydrin and other added solvents are removed with heating under reduced pressure at 110 to 250°C and a pressure of 10 mmHg or less. Furthermore, in order to reduce a content of the hydrolyzable halogen in an epoxy resin, the obtained epoxy resin may be again dissolved in a solvent, such as toluene and methyl isobutyl ketone, and be further reacted by adding an aqueous solution of an alkali metal hydroxide, such as sodium hydroxide and potassium hydroxide to thereby completely achieve ring-closing. The reaction temperature is usually from 50 to 120°C, and the reaction time is usually from 0.5 to 2 hours.

After the completion of reaction, the produced salt is removed by filtration, water washing, etc., and a solvent, such as toluene and methyl isobutyl ketone is further removed by distillation with heating under pressure reduction, whereby the epoxy compound of the present invention is obtained.

As for the addition reaction of the epoxy group with a compound having a carboxyl group or a hydroxyl group and a (meth)acryl group in the preparation of the carboxyl group-containing epoxy polymer, the reaction is preferably carried out in a solvent by using a polymerization inhibitor and a catalyst, and the reaction temperature is preferably from 50 to 120°C.

In the preparation of the carboxyl group-containing epoxy polymer, the reaction solvent, reaction catalyst and polymerization inhibitor which can be used are the same as the reaction solvent, reaction catalyst and polymerization inhibitor, respectively, described in the preparation of (1) a vinyl polymer mainly composed of a reaction product of a polymerizable unsaturated double bond.

Furthermore, a dicarboxylic acid anhydride can be partially added to a hydroxyl group of the reaction product above, and the reaction temperature is preferably from 50 to 120°C.

(3) Aromatic methylene polymer mainly composed of a reaction product of phenol and formaldehyde

The polymer (3) includes, for example, a novolak-type phenol polymer represented by formula (9):

[Chem. 9]

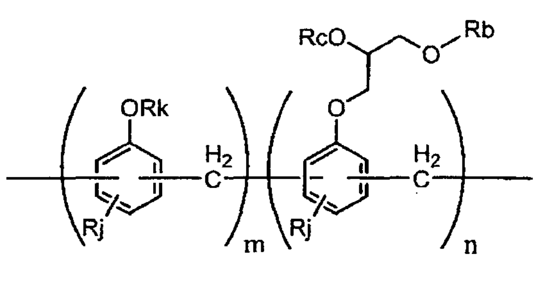

(9)

{wherein Rb is a linear, branched or cyclic monovalent organic group having a carbon number of 1 to 20 or a monovalent organic group having a photopolymerizable unsaturated double bond group, Rc is a group represented by formula (3)

or hydrogen, Rj is a methyl group, a hydroxyl group or hydrogen, Rk is a monovalent organic group represented by formula (5) or (8) or hydrogen, m is an integer selected from 0 to 100, and n is an integer selected from 4 to 1,000}.

The novolak-type phenol polymer for use in the present invention is obtained by reacting an epihalohydrin with a condensation reaction product of phenol and formaldehyde. Furthermore, an epoxy group of the reaction product may be addition-reacted with a (meth)acrylate compound having a carboxyl group or a hydroxyl group, and a hydroxyl group of the reaction product may be reacted with a dicarboxylic acid anhydride.

Examples of the phenol used for the preparation of the novolak-type phenol polymer include phenol, cresol, xylenol and trimethylphenol. These phenols may be used individually or two or more thereof may be used in combination.

Examples of the epihalohydrin used for the novolak-type phenol polymer include epichlorohydrin and epibromohydrin. These may be used individually or two or more thereof may be used in combination.

Examples of the compound having a.carboxyl group and a (meth)acrylate group in one molecule for use in the preparation of the novolak-type phenol polymer include (meth)acrylic acid, (meth)acrylic acid, carboxyethyl (meth)acrylate, carboxypentyl (meth)acrylate, 2-(meth)acryloxyethylsuccinic acid, 2-(meth)acryloxyethylhexahydrophthalic acid, 2-(meth)acryloxyethylphthalic acid, fumaric acid, cinnamic acid, crotonic acid, itaconic acid, and a maleic acid half ester. These compounds may be used individually or two or more thereof may be used in combination.

Examples of the compound having a hydroxyl group and a (meth)acrylate in one molecule for use in the preparation of the novolak-type phenol polymer include 2-hydroxyethyl (meth)acrylate, 3-hydroxypropyl (meth)acrylate, 4-hydroxybutyl (meth)acrylate, glycerol mono(meth)acrylate, 4-hydroxyvinylbenzene, 2-hydroxy-3-phenoxypropyl (meth)acrylate, glycerol di(meth)acrylate, trimethylolpropane di(meth)acrylate, glycerol methacrylate acrylate, pentaerythritol tri(meth)acrylate, and a caprolactone adduct of these monomers.

Examples of the epoxy (meth)acrylate compound obtained by modifying an epoxy group with (meth)acrylate include an epoxy (meth)acrylate of a phenyl diglycidyl ether, such as hydroquinone diglycidyl ether, catechol diglycidyl ether and resorcinol diglycidyl ether; an epoxy (meth)acrylate of a bisphenol-type epoxy compound, such as bisphenol A-type epoxy resin, bisphenol F-type epoxy resin, bisphenol S-type epoxy resin and an epoxy compound of 2,2-bis(4-hydroxyphenyl)-1,1,1,3,3,3-hexafluoropropane; an epoxy (meth)acrylate of a hydrogenated bisphenol-type epoxy compound, such as hydrogenated bisphenol A-type epoxy resin, hydrogenated bisphenol F-type epoxy resin, hydrogenated bisphenol S-type epoxy resin and an epoxy compound of hydrogenated 2,2-bis(4-hydroxyphenyl)-1,1,1,3,3,3-hexafluoropropane; an epoxy (meth)acrylate of an alicyclic diglycidyl ether compound, such as cyclohexanedimethanol diglycidyl ether compound; and an epoxy (meth)acrylate of an aliphatic diglycidyl ether compound, such as 1,6-hexanediol diglycidyl ether, 1,4-butanediol diglycidyl ether and diethylene glycol diglycidyl ether.

The dicarboxylic acid anhydride for use in the preparation of the novolak-type phenol polymer includes a polybasic acid anhydride, such as succinic acid anhydride, cyclohexanedicarboxylic acid anhydride, 4-methyl-cyclohexanedicarboxylic acid anhydride, 5-methyl-cyclohexanedicarboxylic acid anhydride, bicycloheptane-dicarboxylic acid anhydride, 7-oxabicycloheptane-dicarboxylic acid anhydride, tetrahydrophthalic acid anhydride, trimellitic acid anhydride, pyromellitic acid anhydride, adipic acid anhydride, phthalic acid anhydride, (3-trimethoxysilylpropyl)succinic acid anhydride and (3-triethoxysilylpropyl)succinic acid anhydride. These compounds may be used individually or two or more thereof may be used in combination.

In the case of carrying out a condensation reaction of phenol and formaldehyde in the preparation of the novolak-type phenol polymer, an acid catalyst is preferably used, and various acid catalysts may be used, but hydrochloric acid, sulfuric acid, p-toluenesulfonic acid, oxalic acid, boron trifluoride, anhydrous aluminum chloride, zinc chloride, etc., are preferred, and p-toluenesulfonic acid, sulfuric acid and hydrochloride acid are more preferred.

The condensation reaction of phenol and formaldehyde can be carried out without a solvent or in the presence of an organic solvent. In the case of using an organic solvent, specific examples thereof include methyl cellosolve, ethyl cellosolve, toluene, xylene, methyl isobutyl ketone. The amount of the organic solvent used is usually from 50 to 300 mass%, preferably from 100 to 250 mass%, based on the total mass of raw materials charged. The reaction temperature is usually from 40 to 180°C, and the reaction time is usually from 1 to 10 hours. These solvents may be used individually or two or more thereof may be used in combination.

After the completion of reaction, a water washing treatment is carried out until the pH value of the washing water becomes from 3 to 7, preferably from 5 to 7. In the case of carrying out a water washing treatment, a treatment may be carried out by using various basic substances as the neutralizer, for example, an alkali metal hydroxide, such as sodium hydroxide and potassium hydroxide; an alkaline earth metal hydroxide, such as calcium hydroxide, magnesium hydroxide, ammonia, sodium dihydrogen phosphate; and an organic amine, such as diethyltriamine, triethyltetramine, aniline and phenylenediamine. Also, in the case of a water washing treatment, the treatment may be carried out by a conventional method, for example, water having dissolved therein the above-described neutralizer is added to the reaction mixture and after repeating a separation/extraction operation, the solvent is removed by distillation under reduced pressure with heating, whereby the product can be obtained.

After or while adding an alkali metal hydroxide, such as sodium hydroxide and potassium hydroxide to a dissolved mixture of the condensate of phenol and formaldehyde obtained in the reaction above and an epihalohydrin,

such as epichlorohydrin and epibromohydrin, the reaction is allowed to proceed at 20 to 120°C for 1 to 10 hours, whereby an epoxy resin can be obtained. The reaction product of such an epoxidation reaction is, after water washing or without water washing, subjected to removal of the epihalohydrin, other added solvents, etc., with heating under reduced pressure at 110 to 250°C and a pressure of 10 mmHg or less. Furthermore, in order to make up an epoxy resin reduced in the hydrolyzable halogen, the obtained epoxy resin may be again dissolved in a solvent, such as toluene and methyl isobutyl ketone, and be further reacted by adding an aqueous solution of an alkali metal hydroxide, such as sodium hydroxide and potassium hydroxide to thereby unfailingly achieve ring-closing. The reaction temperature is usually from 50 to 120°C, and the reaction time is usually from 0.5 to 2 hours.

After the completion of reaction, the produced salt is removed by filtration, water washing, etc., and a solvent, such as toluene and methyl isobutyl ketone is further removed by distillation with heating under pressure reduction, whereby the epoxy compound of the present invention is obtained.

As for the addition reaction of the epoxy group with a compound having a carboxyl group or a hydroxyl group and a (meth)acryl group in the preparation of the novolak-type phenol polymer, the reaction is preferably carried out in a solvent by using a polymerization inhibitor and a catalyst, and the reaction temperature is preferably from 50 to 120°C.

In the preparation of the novolak-type phenol polymer, the reaction solvent, reaction catalyst and polymerization inhibitor which can be used are the same as the reaction solvent, reaction catalyst and polymerization inhibitor, respectively, described in the preparation of (1) a vinyl polymer mainly composed of a reaction product of a polymerizable unsaturated double bond.

Furthermore, a dicarboxylic acid anhydride can be partially added to a hydroxyl group of the reaction product above, and the reaction temperature is preferably from 50 to 120°C.

(4) Urethane polymer mainly composed of a reaction product of dialcohol and diisocyanate

The polymer (4) includes, for example, a carboxyl group-containing urethane polymer represented by following formula (10):

[Chem. 10]

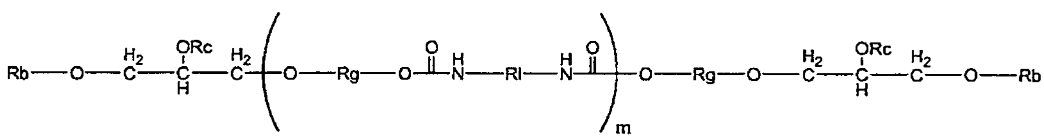

(1 0)

{wherein Rb is a linear, branched or cyclic monovalent organic group having a carbon number of 1 to 20 or a monovalent organic group having a photopolymerizable unsaturated double bond group, Rc is a group represented by formula (3) or hydrogen, Rg is a linear, branched or cyclic divalent organic group having a carbon number of 2 to 20, R1 is a linear, branched or cyclic divalent organic group having a carbon number of 4 to 20, and m is an integer selected from 1 to 600}.

The carboxyl group-containing urethane polymer for use in the present invention is obtained by addition-polymerization of a compound having two hydroxyl groups in one molecule and a compound having two isocyanate groups in one molecule, addition-reacting the hydroxyl group at both ends of the polymerization product and a compound having an epoxy group and a (meth)acryl group in one molecule, and further addition-reacting a carboxylic acid anhydride to the hydroxyl group produced.

Examples of the compound having two hydroxyl groups in one molecule for use in the preparation of the carboxyl group-containing urethane polymer include the following compounds (1) to (3):

(1) a dialcohol compound: for example, bisphenols, such as bisphenol A, bisphenol F and bisphenol S; hydrogenated bisphenols, such as hydrogenated bisphenol A, hydrogenated bisphenol F and hydrogenated bisphenol S; a both-ends ethylene oxide (molar number of ethylene oxide: from 1 to 10) adduct of bisphenol, such as bisphenol A, bisphenol F and bisphenol S; a both-ends propylene oxide (molar number of propylene oxide: from 1 to 10) adduct of bisphenol, such as bisphenol A, bisphenol F and bisphenol S; a both-ends ethylene oxide (molar number of ethylene oxide: from 1 to 10) adduct of bisphenol, such as hydrogenated bisphenol A, hydrogenated bisphenol F and hydrogenated bisphenol S; a both-ends propylene oxide (molar number of propylene oxide: from 1 to 10) adduct of bisphenol, such as hydrogenated bisphenol A, hydrogenated bisphenol F and hydrogenated bisphenol S; an alkyl

($C_2$-$C_{10}$) dialcohol, a polyethylene glycol (molar number of ethylene oxide: from 1 to 10), a polypropylene glycol (molar number of propylene oxide: from 1 to 10), a hydroxyl group-terminated liquid polybutadiene (Poly bd, produced by Idemitsu Kosan Co., Ltd.), a hydroxyl group-terminated polyolefin-based polyol (Epol, produced by Idemitsu Kosan Co., Ltd.), a hydroxyl group-terminated liquid polybutadiene hydrogenation product (POLYTAIL H, produced by Mitsubishi Chemical Corporation), and a polycarbonate diol (DURANOL T-5651, produced by Asahi Kasei Chemicals Corporation);

(2) an epoxy (meth)acrylate compound obtained by modifying a both-ends epoxy group with a (meth)acrylate: for example, an epoxy (meth)acrylate of a phenyl diglycidyl ether, such as hydroquinone diglycidyl ether, catechol, diglycidyl ether and resorcinol diglycidyl ether; an epoxy (meth)acrylate of a bisphenol-type epoxy compound, such as bisphenol A-type epoxy resin, bisphenol F-type epoxy resin, bisphenol S-type epoxy resin and an epoxy compound of 2,2-bis(4-hydroxyphenyl)-1,1,1,3,3,3-hexafluoropropane; an epoxy (meth)acrylate of a hydrogenated bisphenol-type epoxy compound, such as hydrogenated bisphenol A-type epoxy resin, hydrogenated bisphenol F-type epoxy resin, hydrogenated bisphenol S-type epoxy resin; and an epoxy compound of hydrogenated 2,2-bis(4-hydroxyphenyl)-1,1,1,3,3,3-hexafluoropropane; an epoxy (meth)acrylate of an alicyclic diglycidyl ether compound, such as cyclohexanedimethanol diglycidyl ether compound; and an epoxy (meth)acrylate of an aliphatic diglycidyl ether compound, such as 1,6-hexanediol diglycidyl ether, 1,4-butanediol diglycidyl ether and diethylene glycol diglycidyl ether; and

(3) a dialcohol compound having a carboxyl group: for example, dimethylolpropionic acid and dimethylolbutanoic acid.

These compounds (1) to (3) may be used individually or two or more thereof may be used in combination.

The both-ends diisocyanate for use in the preparation of the carboxyl group-containing urethane polymer includes, for example, an aromatic, aliphatic, cycloaliphatic or alicyclic polyisocyanate. Examples thereof include tolylene diisocyanate, diphenylmethane-4,4'-diisocyanate, hexamethylene diisocyanate, isophorone diisocyanate, o-xylylene diisocyanate, m-xylylene diisocyanate, p-xylylene diisocyanate, $\alpha,\alpha'$-dimethyl-o-xylylene diisocyanate, $\alpha,\alpha'$-dimethyl-m-xylylene diisocyanate, $\alpha,\alpha'$-dimethyl-p-xylylene diisocyanate, $\alpha,\alpha,\alpha'$-trimethyl-o-xylylene diisocyanate, $\alpha,\alpha,\alpha'$-trimethyl-m-xylylene diisocyanate, $\alpha,\alpha,\alpha'$-trimethyl-p-xylylene diisocyanate, $\alpha,\alpha,\alpha',\alpha'$-tetramethyl-o-xylylene diisocyanate, $\alpha,\alpha,\alpha',\alpha'$-tetramethyl-m-xylylene diisocyanate, $\alpha,\alpha,\alpha',\alpha'$-tetramethyl-p-xylylene diisocyanate, and cyclohexane diisocyanate. Other examples include a compound obtained by hydrogenating the aromatic ring of a diisocyanate compound, such as a hydrogenation product of m-xylylene diisocyanate (TAKENATE 600, produced by Mitsui Takeda Chemicals, Inc.) and a hydrogenated diphenylmethane diisocyanate. These compounds may be used individually or two or more thereof may be used in combination.

The compound having an epoxy group and a (meth)acryl group in one molecule for use in the preparation of the carboxyl group-containing urethane compound is not particularly limited as long as it is a (meth)acrylate obtained by reaction en epoxy group-containing epoxy resin and a (meth)acrylic acid by a conventional method, and includes, for example, glycidyl (meth)acrylate; 3,4-epoxycyclohexylmethyl (meth)acrylate; 3,4-epoxycyclohexylethyl (meth)acrylate; vinyl cyclohexene monoxide; a half ester of (meth)acrylic acid with a phenyl diglycidyl ether, such as hydroquinone diglycidyl ether, catechol diglycidyl ether and resorcinol diglycidyl ether; a half ester of (meth)acrylic acid with a bisphenol-type epoxy compound, such as bisphenol A-type epoxy resin, bisphenol F-type epoxy resin, bisphenol S-type epoxy resin and an epoxy compound of 2,2-bis(4-hydroxyphenyl)-1,1,1,3,3,3-hexafluoropropane; a half ester of (meth)acrylic acid with a hydrogenated bisphenol-type epoxy compound, such as hydrogenated bisphenol A-type epoxy resin, hydrogenated bisphenol F-type epoxy resin, hydrogenated bisphenol S-type epoxy resin and an epoxy compound of hydrogenated 2,2-bis(4-hydroxyphenyl)-1,1,1,3,3,3-hexafluoropropane; a half ester of (meth)acrylic acid with an alicyclic diglycidyl ether compound, such as cyclohexanedimethanol diglycidyl ether compound; and a half ester of (meth)acrylic acid with an aliphatic diglycidyl ether compound, such as 1,6-hexanediol diglycidyl ether, 1,4-butanediol diglycidyl ether and diethylene glycol diglycidyl ether. These compounds may be used individually or two or more thereof may be used in combination.

The dicarboxylic acid anhydride for use in the preparation of the carboxyl group-containing urethane polymer includes, for example, a polybasic acid anhydride, such as succinic acid anhydride, cyclohexanedicarboxylic acid anhydride, 4-methyl-cyclohexanedicarboxylic acid anhydride, 5-methyl-cyclohexanedicarboxylic acid anhydride, bicycloheptane-dicarboxylic acid anhydride, 7-oxabicycloheptane-dicarboxylic acid anhydride, tetrahydrophthalic acid anhydride, trimellitic acid anhydride, pyromellitic acid anhydride, adipic acid anhydride, phthalic acid anhydride, (3-trimethoxysilylpropyl)succinic acid anhydride and (3-triethoxysilylpropyl)succinic acid anhydride. These compounds may be used individually or two or more thereof may be used in combination.

The copolymerization of the carboxyl group-containing urethane polymer can be carried out by a conventional method. A dialcohol and a diisocyanate are reacted in a nitrogen atmosphere. The reaction temperature is usually from 30 to 140°C and from the standpoint of enhancing the reactivity and preventing a side reaction, preferably from 50 to 120°C. This reaction is usually carried out without a solvent but may be carried out, if desired, in an inert solvent having no reactivity with an isocyanate group [for example, an aromatic hydrocarbon (e.g., toluene, xylene), a ketone (e.g.,

methyl ethyl ketone, methyl isobutyl ketone), and a mixture of two or more kinds thereof], and such a solvent may be later removed by distillation.

As for the addition reaction of a both-ends hydroxyl group obtained by the reaction above with a compound having an epoxy group and a (meth)acryl group in one molecule in the preparation of the carboxyl group-containing urethane polymer, the reaction is preferably carried out in a solvent by using a polymerization inhibitor and a catalyst. This reaction is preferably carried out at a reaction temperature of 50 to 120°C.

In the preparation of the carboxyl group-containing urethane polymer, the reaction solvent, reaction catalyst and polymerization inhibitor which can be used are the same as the reaction solvent, reaction catalyst and polymerization inhibitor, respectively, described in the preparation of (1) a vinyl polymer mainly composed of a reaction product of a polymerizable unsaturated double bond.

Furthermore, a dicarboxylic acid anhydride can be partially added to a hydroxyl group of the reaction product above, and the reaction temperature is preferably from 50 to 120°C.

(5) Ester polymer mainly composed of a reaction product of dicarboxylic acid and diepoxide

The polymer (5) includes, for example, a carboxyl group-containing ester polymer represented by following formula (11):

[Chem. 11]

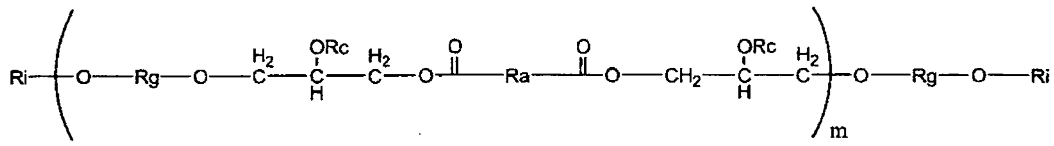

(11)

{wherein Ra is a linear, branched or cyclic divalent organic group having a carbon number of 2 to 16, Rc is a group represented by above formula (3) or hydrogen, Rg is a linear, branched or cyclic divalent organic group having a carbon number of 2 to 20, Ri is a monovalent organic group represented by above formula (5) or (8), and m is an integer selected from 1 to 600}.

The carboxyl group-containing ester polymer for use in the present invention is obtained by addition-polymerizing a compound having two carboxyl groups in one molecule and a compound having two epoxy groups in one molecule. Furthermore, the terminal epoxy group of the reaction product may be addition-reacted with a compound having a carboxyl group or a hydroxyl group and a (meth)acryl group in one molecule, and a hydroxyl group of the reaction product and a carboxylic acid anhydride may be reacted.

Examples of the compound having two carboxyl groups in one molecule for use in the preparation of the carboxyl group-containing ester polymer include succinic acid, cyclohexanedicarboxylic acid, 4-methyl-cyclohexanedicarboxylic acid, 5-methyl-cyclohexanedicarboxylic acid, bicycloheptane-dicarboxylic acid, 7-oxabicycloheptane-dicarboxylic acid, tetrahydrophthalic acid, trimellitic acid, pyromellitic acid, adipic acid, phthalic acid, (3-trimethoxysilylpropyl)succinic acid and (3-triethoxysilylpropyl)succinic acid. These compounds may be used individually or two or more thereof may be used in combination.

Examples of the compound having two epoxy groups in one molecule for use in the preparation of the carboxyl group-containing ester polymer include a phenyl diglycidyl ether, such as hydroquinone diglycidyl ether, catechol diglycidyl ether and resorcinol diglycidyl ether; a bisphenol-type epoxy compound, such as bisphenol A-type epoxy resin, bisphenol F-type epoxy resin, bisphenol S-type epoxy resin and an epoxy compound of 2,2-bis(4-hydroxyphenyl)-1,1,1,3,3,3-hexafluoropropane; a hydrogenated bisphenol-type epoxy compound, such as hydrogenated bisphenol A-type epoxy resin, hydrogenated bisphenol F-type epoxy resin, hydrogenated bisphenol S-type epoxy resin and an epoxy compound of hydrogenated 2,2-bis(4-hydroxyphenyl)-1,1,1,3,3,3-hexafluoropropane; an alicyclic diglycidyl ether compound, such as cyclohexanedimethanol diglycidyl ether compound; and an aliphatic diglycidyl ether compound, such as 1,6-hexanediol diglycidyl ether, 1,4-butanediol diglycidyl ether, diethylene glycol diglycidyl ether and polyethylene glycol diglycidyl ether. These compounds may be used individually or two or more thereof may be used in combination.

Examples of the compound having a carboxyl group and a (meth)acrylate group in one molecule for use in the preparation of the carboxyl group-containing ester polymer include (meth)acrylic acid, (meth)acrylic acid, carboxyethyl (meth)acrylate, carboxypentyl (meth)acrylate, 2-(meth)acryloxyethylsuccinic acid, 2-(meth)acryloxyethylhexahydrophthalic acid, 2-(meth)acryloxyethylphthalic acid, fumaric acid, cinnamic acid, crotonic acid, itaconic acid, and a maleic acid half ester. These compounds may be used individually or two or more thereof may be used in combination.

Examples of the compound having a hydroxyl group and a (meth)acrylate group in one molecule for use in the carboxyl group-containing ester polymer include 2-hydroxyethyl (meth)acrylate, 3-hydroxypropyl (meth)acrylate, 4-hydroxybutyl (meth)acrylate, glycerol mono(meth)acrylate, 4-hydroxyvinylbenzene, 2-hydroxy-3-phenoxypropyl (meth)acrylate, glycerol di(meth)acrylate, trimethylolpropane di(meth)acrylate, glycerol methacrylate acrylate, pentaerythritol tri(meth)acrylate, and a caprolactone adduct of these monomers.

Examples of the epoxy (meth)acrylate compound obtained by modifying an epoxy group with (meth)acrylate include an epoxy (meth)acrylate of a phenyl diglycidyl ether, such as hydroquinone diglycidyl ether, catechol diglycidyl ether and resorcinol diglycidyl ether; an epoxy (meth)acrylate of a bisphenol-type epoxy compound, such as bisphenol A-type epoxy resin, bisphenol F-type epoxy resin, bisphenol S-type epoxy resin and an epoxy compound of 2,2-bis(4-hydroxyphenyl)-1,1,1,3,3,3-hexafluoropropane; an epoxy (meth)acrylate of a hydrogenated bisphenol-type epoxy compound, such as hydrogenated bisphenol A-type epoxy resin, hydrogenated bisphenol F-type epoxy resin, hydrogenated bisphenol S-type epoxy resin and an epoxy compound of hydrogenated 2,2-bis(4-hydroxyphenyl)-1,1,1,3,3,3-hexafluoropropane; an epoxy (meth)acrylate of an alicyclic diglycidyl ether compound, such as cyclohexanedimethanol diglycidyl ether compound; and an epoxy (meth)acrylate of an aliphatic diglycidyl ether compound, such as 1,6-hexanediol diglycidyl ether, 1,4-butanediol diglycidyl ether and diethylene glycol diglycidyl ether.

The dicarboxylic acid anhydride for use in the preparation of the carboxyl group-containing ester polymer includes a polybasic acid anhydride, such as succinic acid anhydride, cyclohexanedicarboxylic acid anhydride, 4-methyl-cyclohexanedicarboxylic acid anhydride, 5-methyl-cyclohexanedicarboxylic acid anhydride, bicycloheptane-dicarboxylic acid anhydride, 7-oxabicycloheptane-dicarboxylic acid anhydride, tetrahydrophthalic acid anhydride, trimellitic acid anhydride, pyromellitic acid anhydride, adipic acid anhydride, phthalic acid anhydride, (3-trimethoxysilylpropyl)succinic acid anhydride and (3-triethoxysilylpropyl)succinic acid anhydride. These compounds may be used individually or two or more thereof may be used in combination.

The reaction for the carboxyl group-containing ester polymer for use in the present invention can be carried out by a conventional method. The addition reaction of a compound having two carboxyl groups in one molecular and a compound having two epoxy groups in one molecule in the preparation of the carboxyl-containing ester polymer is preferably carried out in a solvent by using a polymerization inhibitor and a catalyst. This reaction is preferably carried out at a reaction temperature of 50 to 120°C.

In the preparation of the carboxyl group-containing ester polymer, the reaction solvent, reaction catalyst and polymerization inhibitor which can be used are the same as the reaction solvent, reaction catalyst and polymerization inhibitor, respectively, described in the preparation of (1) a vinyl polymer mainly composed of a reaction product of a polymerizable unsaturated double bond.

Furthermore, a dicarboxylic acid anhydride can be partially added to a hydroxyl group of the reaction product above, and the reaction temperature is preferably from 50 to 120°C.

The alkali-soluble resin (B) for use in the present invention is, in view of heat resistance of the reaction product constituting the main part of the polymer, preferably at least one polymer selected from the group consisting of a vinyl polymer mainly composed of a reaction product of a polymerizable unsaturated double bond, an epoxy polymer mainly composed of an addition reaction product of an epoxy group and a hydroxyl group, an aromatic methylene polymer mainly composed of a reaction product of phenol and formaldehyde, and an ester polymer mainly composed of a reaction product of dicarboxylic acid and diepoxide.

In view of compatibility of the alkali-soluble silicone reins (A) with the alkali-soluble resin (B) by polarity, the ratio of the acid value (mgKOH/g) of the alkali-soluble silicone resin (A) to the acid value (mgKOH/g) of the alkali-soluble resin (B) for use in the present invention, i.e., the acid value (A)/acid value (B), is preferably 0.1 or more, more preferably 0.2 or more, still more preferably 0.3 or more, but is preferably 5.0 or less, more preferably 4.0 or less, still more preferably 3.0 or less.

<(C) Photopolymerization Initiator>

It is important that the photopolymerization initiator (C) be added for the purpose of providing photosensitive pattern formation.

The photopolymerization initiator (C) includes the following photopolymerization initiators (1) to (10):

(1) a benzophenone derivative: for example, benzophenone, methyl o-benzoylbenzoate, 4-benzoyl-4'-methyl phenyl ketone, dibenzyl ketone and fluorenone;
(2) an acetophenone derivative: for example, 2,2'-diethoxyacetophenone, 2-hydroxy-2-methylpropiophenone, 2,2-dimethoxy-1,2-diphenylethan-1-one (IRGACURE 651, produced by Ciba Specialty Chemicals Inc.), 1-hydroxycyclohexyl phenyl ketone (IRGACURE 184, produced by Ciba Specialty Chemicals Inc.), 2-methyl-1-[4-(methylthio)phenyl]-2-morpholinopropan-1-one (IRGACURE 907, produced by Ciba Specialty Chemicals Inc.), 2-hydroxy-1-{4-[4-(2-hydroxy-2-methylpropionyl)-benzyl]-phenyl}-2-methylpropan-1-one (IRGACURE 127, produced by Ciba Specialty Chemicals Inc.) and methyl phenyl glyoxylate;
(3) a thioxanthone derivative: for example, thioxanthone, 2-methylthioxanthone, 2-isopropylthioxanthone and diethylthioxanthone;
(4) a benzyl derivative: for example, benzyl, benzyl dimethyl ketal and benzyl-β-methoxyethyl acetal;
(5) a benzoin derivative: for example, benzoin, benzoin methyl ether and 2-hydroxy-2-methyl-1-phenylpropan-1-one (DAROCURE 1173, produced by Ciba Specialty Chemicals Inc.);
(6) an oxime-based compound: for example, 1-phenyl-1,2-butanedione-2-(O-methoxycarbonyl)oxime, 1-phenyl-1,2-propanedione-2-(O-methoxycarbonyl)oxime, 1-phenyl-1,2-propanedione-2-(O-ethoxycarbonyl)oxime, 1-phenyl-1,2-propanedione-2-(O-benzoyl)oxime, 1,3-diphenylpropanetrione-2-(O-ethoxycarbonyl)oxime, 1-phenyl-3-ethoxypropanetrione-2-(O-benzoyl)oxime, 1,2-octanedione, 1-[4-(phenylthio)-2-(O-benzoyloxime)] (IRGACURE OXE01, produced by Ciba Specialty Chemicals Inc.), ethanone and 1-[9-ethyl-6-(2-methylbenzoyl)-9H-carbazol-3-yl]-1-(O-acetyloxime) (IRGACURE OXE02, produced by Ciba Specialty Chemicals Inc.);
(7) an α-hydroxy ketone-based compound: for example, 2-hydroxy-2-methyl-1-phenylpropan-1-one, 1-[4-(2-hydroxyethoxy)phenyl]-2-hydroxy-2-methyl-1-propan-1-one and 2-hydroxy-1-{4-[4-(2-hydroxy-2-methylpropionyl)-benzyl]phenyl}-2-methylpropane;
(8) an α-aminoalkylphenone-based compound: for example, 2-benzyl-2-dimethylamino-1-(4-morpholinophenyl)-butanone-1 (IRGACURE 369, produced by Ciba Specialty Chemicals Inc.) and 2-dimethylamino-2-(4-methylbenzyl)-1-(4-morpholin-4-yl-phenyl)butan-1-one (IRGACURE 379, produced by Ciba Specialty Chemicals Inc.);
(9) a phosphine oxide-based compound: for example, bis(2,4,6-trimethylbenzoyl)-phenyl phosphine oxide (IRGACURE 819, produced by Ciba Specialty Chemicals Inc.), bis(2,6-dimethoxybenzoyl)-2,4,4-trimethyl-pentylphosphine oxide and 2,4,6-trimethylbenzoyl-diphenyl-phosphine oxide (DAROCURE TPO, produced by Ciba Specialty Chemicals Inc.); and,
(10) a titanocene compound: for example, bis(η5-2,4-cyclopentadien-1-yl)-bis(2,6-difluoro-3-(1H-pyrrol-1-yl)phenyl)titanium (IRGACURE 784, produced by Ciba Specialty Chemicals Inc.).

These photopolymerization initiators (1) to (10) may be used individually or two or more thereof may be used in combination.
Among the photopolymerization initiators above, from the standpoint of enhancing the photosensitivity and transparency, (5) a benzoin derivative and (9) a phosphine oxide-based compound are preferred.
The content of the photopolymerization initiator (C) is, from the standpoint of obtaining sufficient sensitivity, preferably 0.01 mass% or more, more preferably 0.1 mass% or more, and from the standpoint of fully curing the bottom portion of the photosensitive resin layer, is preferably 15 mass% or less, more preferably 10 mass% or less, based on the mass of all components except for the solvent in the photosensitive resin composition.

<(D) Photopolymerizable Unsaturated Double Bond-Containing Compound>

The (D) photopolymerizable unsaturated double bond-containing compound is a polymerizable monomer having at least one photopolymerizable unsaturated double bond group in one molecule. In the embodiment of the present invention, the component (A) or (B) in the photosensitive alkali-soluble silicone resin composition contains a photopolymerizable unsaturated double bond group, or the photosensitive alkali-soluble silicone resin composition further contains (D) a photopolymerizable unsaturated double bond-containing compound.
Both the component (A) and the component (B) may have a photopolymerizable unsaturated double bond group. Even in the case where the component (A) or the component (B) contains a photopolymerizable unsaturated double bond group, the composition may further contain (D) a photopolymerizable unsaturated double bond-containing compound. In view of the thermal crack resistance, it is most preferred that both the component (A) and the component (B) have a photopolymerizable unsaturated double bond group and at the same time, the composition contains (D) a photopolymerizable unsaturated double bond-containing compound.
The (D) photopolymerizable unsaturated double bond-containing compound includes, for example, a polyethylene glycol di(meth)acrylate [number of ethylene glycol units: from 2 to 20], a poly(1,2-propylene glycol) di(meth)acrylate [number of 1,2-propylene glycol units: from 2 to 20], a polytetramethylene glycol di(meth)acrylate [number of tetramethylene glycol units: from 2 to 10], a tri-2-hydroxyethylisocyanurate tri(meth)acrylate, a methylenebisacrylamide, an ethylene glycol diglycidyl ether-(meth)acrylic acid adduct, a glycerol diglycidyl ether-(meth)acrylic acid adduct, a bisphenol A diglycidyl ether-(meth)acrylic acid adduct, N,N'-bis(2-methacryloyloxyethyl)urea, a succinic acid-modified pentaerythritol tri(meth)acrylate, a phthalic acid-modified pentaerythritol tri(meth)acrylate, an isophthalic acid-modified pentaerythritol tri(meth)acrylate, a terephthalic acid-modified pentaerythritol tri(meth)acrylate, a dimethacrylate of a polyalkylene glycol in which 2 mol on average of propylene oxide and 6 mol on average of ethylene oxide are added respectively to

both ends of bisphenol A, a dimethacrylate of a polyethylene glycol in which 5 mol on average of ethylene oxide is added to each of both ends of bisphenol A, 1,6-hexanediol di(meth)acrylate, neopentyl glycol di(meth)acrylate, 3-methyl-1,5-pentanediol di(meth)acrylate, 2-butyl-2-ethyl-1,3-propanediol di(meth)acrylate, 1,9-nonanediol di(meth)acrylate, 1,10-decanediol di(meth)acrylate, glycerin di(meth)acrylate, tricyclodecanedimethanol (meth)acrylate, 1,4-cyclohexanediol di(meth)acrylate, 2-di(p-hydroxyphenyl)propane di(meth)acrylate, glycerol tri(meth)acrylate, trimethylolpropane tri(meth)acrylate, polyoxypropyltrimethylolpropane tri(meth)acrylate, polyoxyethyltrimethylolpropane triacrylate, pentaerythritol tetra(meth)acrylate, dipentaerythritol penta(meth)acrylate, trimethylolpropane triglycidyl ether tri(meth)acrylate, bisphenol A diglycidyl ether di(meth)acrylate, β-hydroxypropyl-β'-(acryloyloxy)propyl phthalate, phenoxypolyethylene glycol (meth)acrylate, nonylphenoxypolyethylene glycol (meth)acrylate, nonylphenoxypolyalkylene glycol (meth)acrylate, polypropylene glycol mono(meth)acrylate, 2-hydroxyethyl (meth)acrylate, 3-hydroxypropyl (meth)acrylate, 4-hydroxybutyl (meth)acrylate, glycerol mono(meth)acrylate, 4-hydroxyvinylbenzene, 2-hydroxy-3-phenoxypropyl acrylate, and a caprolactone adduct of these monomers.

The photopolymerizable unsaturated double bond-containing compound (D) further containing a carboxylic acid includes, for example, (meth)acrylic acid, carboxyethyl (meth)acrylate, carboxypentyl (meth)acrylate, 2-(meth)acryloxyethylsuccinic acid, 2-(meth)acryloxyethylhexahydrophthalic acid, 2-(meth)acryloxyethylphthalic acid, and 2,2,2-triacryloyloxy-methylethylsuccinic acid. These compounds may be used individually or two or more thereof may be used in combination.

The content of the (D) photopolymerizable unsaturated double bond-containing compound is, from the standpoint of fully crosslinking the compound to exert adherence to the substrate, preferably 5 mass% or more, more preferably 10 mass% or more, and from the standpoint of reducing the scrum after development, is preferably 60 mass% or less, more preferably 45 mass% or less, based on the mass of all components except for the solvent in the photosensitive resin composition.

As for the concentration of the photopolymerizable unsaturated double bond group of the photopolymerizable unsaturated double bond-containing compound (D), from the standpoint of obtaining sufficient resolution, the molar concentration is preferably 0.5 mmol/g or more, more preferably 0.7 mmol/g or more, and from the standpoint of reducing the residue after development, the molar concentration is preferably 20.0 mmol/g or less, more preferably 15.0 mmol/g or less.

<(E) Solvent>

In the embodiment of the present invention, the viscosity of the photosensitive alkali-soluble silicone resin composition is preferably adjusted by adding (E) a solvent thereto. Preferred solvents include, for example, the following solvents (1) to (6):

(1) an aliphatic alcohol: for example, methanol, ethanol, n-propanol, iso-propanol, n-butanol, isobutanol, sec-butanol, tert-butanol, 1-pentanol, isoamyl alcohol, s-amyl alcohol, tert-amyl alcohol, 2-methyl-1-butanol, 1-hexanol, 2-ethyl-1-butanol, 4-methyl-2-pentanol, isohexyl alcohol, methyl-1-pentanol, s-hexanol, 1-heptanol, isoheptyl alcohol, 2,3-dimethyl-1-pentanol, 1-octanol, 2-ethylhexanol, isooctyl alcohol, 2-octanol, 3-octanol, 1-nonanol, isononyl alcohol, 3,5,5-trimethylhexanol, 1-decanol, isodecyl alcohol, 3,7-dimethyl-1-octanol, 1-hendecanol, 1-dodecanol, isododecyl alcohol, allyl alcohol, propargyl alcohol and hexynol;

(2) an aromatic alcohol: for example, benzyl alcohol, (2-hydroxyphenyl)methanol, (methoxyphenyl)methanol, (3,4-dihydroxyphenyl)methanol, 4-(hydroxymethyl)benzene-1,2-diol, (4-hydroxy-3-methoxyphenyl)methanol, (3,4-dimethoxyphenyl)methanol, (4-isopropylphenyl)methanol, 2-phenylethanol, 1-phenylethanol, 2-phenyl-1-propanol, p-tolyl alcohol, 2-(4-hydroxy-3-methoxyphenyl)ethan-1-ol, 2-(3,4-dimethoxyphenyl)ethan-1-ol, 3-phenylpropan-1-ol, 2-phenylpropan-2-ol, cinnamyl alcohol, 3-(4-hydroxy-3-methoxyphenyl)prop-2-en-1-ol, 3-(4-hydroxy-3,5-methoxyphenyl)prop-2-en-1-ol, diphenyl methanol, trityl alcohol, 1,2-diphenylethane-1,2-diol, 1,1,2,2-tetraphenylethane-1,2-diol, benzene-1,2-dimethanol, benzene-1,3-dimethanol and benzene-1,4-dimethanol;

(3) an alicyclic alcohol: for example, cyclohexanol, methylcyclohexanol, furfuryl alcohol, tetrahydrofurfuryl alcohol and tetrahydro-2-furanemethanol;

(4) glycol and the derivative thereof: for example, ethylene glycol, an ethylene glycol monoalkyl (carbon number: from 1 to 8) ether, ethylene glycol monovinyl ether, ethylene glycol monophenyl ether, dioxane, diethylene glycol monoalkyl (carbon number: from 1 to 6) ether, diethylene glycol monovinyl ether, diethylene glycol monophenyl ether, triethylene glycol monoalkyl (carbon number: from 1 to 3) ether, triethylene glycol monovinyl ether, triethylene glycol monophenyl ether, tetraethylene glycol monophenyl ether, propylene glycol, propylene glycol monoalkyl (carbon number: from 1 to 4) ether, propylene glycol monophenyl ether, dipropylene glycol monoalkyl (carbon number: from 1 to 3) ether, ethylene glycol monoacetate, propylene glycol monoacrylate and propylene glycol monoacetate;

(5) a ketone compound: for example, acetone, methyl ethyl ketone, 3-butyn-2-one, methyl-n-propyl ketone, methyl

isopropyl ketone, 3-pentyn-2-one, methyl isopropenyl ketone, methyl-n-butyl ketone, methyl isobutyl ketone, mesityl oxide, 4-hydroxy-4-methyl-2-pentanone, methyl-n-amyl ketone, methyl isoamyl ketone, ethyl-n-butyl ketone, di-n-propyl ketone, diisopropyl ketone, 2-octanone, 3-octanone, 5-methyl-3-heptanone, 5-nonanone, diisobutyl ketone, trimethyl nonanone, 2,4-pentanedione, 2,5-hexanedione, cyclopentanone, cyclohexanone, methylcyclohexanone, acetophenone, propiophenone and isophorone;

(6) others: for example, N,N-dimethylformamide, N-methyl-2-pyrrolidone, N-ethyl-2-pyrrolidone, N,N-dimethylacetamide, dimethylsulfoxide, pyridine, γ-butyrolactone, α-acetyl-y-butyrolactone, tetramethylurea, 1,3-dimethyl-2-imidazolinone and N-cyclohexyl-2-pyrrolidone.

One of these may be used alone, or two or more thereof may be used in combination. Among these, propylene glycol monomethyl ether acetate, ethyl lactate, gamma-butyrolactone, diethylene glycol monomethyl ether, diethylene glycol dimethyl ether, propylene glycol monomethyl ether, etc., are preferred.

Such a solvent can be appropriately added to the photosensitive alkali-soluble silicone resin composition according to the thickness of coated film and the viscosity but is preferably used in a ratio of 5 to 1,000 mass% based on the mass of all components except for the solvent in the photosensitive resin composition.

<(F) Hindered Amine-Based Stabilizer>

The hindered amine-based stabilizer (F) is an amine-based compound having a radical-trapping action and is a compound containing a group represented by following formula:

[Chem. 12]

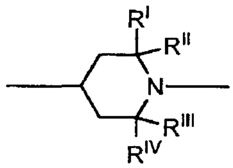

{wherein each of $R^I$, $R^{II}$, $R^{III}$ and $R^{IV}$ is independently at least one member selected from the group consisting of a methyl group, an ethyl group, a propyl group and an isopropyl group}.

In general, a phenol-based antioxidant is used for preventing an oxidative deterioration reaction that proceeds under heat in the presence of oxygen. However, when a phenol-based antioxidant is added to a composition, because of having a hydroxyl group of the phenol skeleton and in turn showing high affinity for an alkali, the phenol-based antioxidant readily dissolves out from the transparent film during alkali development. In this connection, the hindered amine-based stabilizer is low in the affinity for an alkali as compared with the phenol-based antioxidant and therefore, likely to stay in the transparent film during alkali development and can suppress transmission due to an oxidative deterioration reaction that proceeds under heat in the presence of oxygen.

Examples of the hindered amine-based stabilizer (F) include an N-H type hindered amine-based stabilizer, an N-R type hindered amine-based stabilizer, and an N-OR type hindered amine-based stabilizer.

Specific examples of the N-H type hindered amine-based stabilizer include bis(2,2,6,6-tetramethyl-4-piperidyl)sebacate (TINUVIN 770DF, produced by BASF), N,N'-bis(2,2,6,6-tetramethyl-4-piperidyl)-N,N'-diformylhexamethylenediamine (UVINUL 4050FF, produced by BASF), a polycondensate of 1,3,5-triazine, N,N'-bis(2,2,6,6-tetramethyl-4-piperidyl)-1,6-hexamethylenediamine and N-(2,2,6,6-tetramethyl-4-piperidyl)butylamine (Chimassorb 2020FDL, produced by BASF), poly[{6-(1,1,3,3-tetramethylbutyl)amino-1,3,5-triazine-2,4-diyl}{(2,2,6,6-tetramethyl-4-piperidyl)imino}hexamethylene{(2,2,6,6-tetramethyl-4-piperidyl)imino}] (Chimassorb 944FDL, produced by BASF), and a copolymerization product of olefin ($C_{20}$-$C_{24}$) /maleic acid anhydride/4-amino-2,2,6,6-tetramethylpiperidine (UVINUL 5050H, produced BASF).

Specific examples of the N-R type hindered amine-based stabilizer include bis(1,2,2,6,6-pentamethyl-4-piperidyl)[[3,5-bis(1,1-dimethylethyl)-4-hydroxyphenyl]methyl]butyl malonate (TINUVIN 144 produced by BASF), (a mixture of) bis(1,2,2,6,6-pentamethyl-4-piperidyl)sebacate and methyl-1,2,2,6,6-pentamethyl-4-piperidyl sebacate (TINUVIN 765, produced by BASF), a polymerization product of dimethyl succinate and 4-hydroxy-2,2,6,6-tetramethyl-1-piperidine ethanol (TINUVIN 622SF, LD, produced by BASF), an N,N'-bis(3-aminopropyl)ethylenediamine-2,4-bis[N-butyl-N-(1,2,2,6,6-pentamethyl-4-piperidyl)amino]-6-chloro-1,3,5-triazine condensate (SABOSTABUV 119, Produced by SABO S. r. l), tetrakis(1,2,2,6,6-pentamethyl-4-piperidyl)1,2,3,4-butanetetracarboxylate (ADEKASTAB LA-52, produced

by Asahi Denka Co., Ltd.), 1,2,2,6,6-pentamethyl-4-piperidyl/tridecyl-1,2,3,4-butanetetracarboxylate (ADEKASTAB LA-62, produced by Asahi Denka Co., Ltd.), a mixed ester of 1,2,3,4-butanetetracarboxylic acid, 1,2,2,6,6-pentamethyl-4-piperidinol and 3,9-bis(2-hydroxy-1,1-dimethylethyl)-2,4,8,10-tetraoxaspiro[5,5]undecane (ADEKASTAB LA-63, produced by Asahi Denka Co., Ltd.), and 1,2,2,6,6-pentamethyl-4-piperidyl methacrylate.

Specific examples of the N-OR type hindered amine-based stabilizer include an NOR type hindered amine-based light stabilizer system (TINUVIN XT850FF, produced by BASF), a weather-resistant stabilizer system based on an NOR type hindered amine-based stabilizer system (TINUVIN 855FF, produced by BASF), and a reaction product of peroxide-treated 4-butylamino-2,2,6,6-tetramethylpiperidine, 2,4,6-trichloro-1,3,5-triazine, cyclohexane and N,N'-ethane-1,2-diylbis(1,3-propanediamine) (Flamestab NOR 116FF, produced by BASF).

One of these hindered amine-based stabilizers (F) may be used alone, or two or more thereof may be used as a mixture.

The molecular weight of the hindered amine-based stabilizer (F) is, in terms of polystyrene measured by gel permeation chromatography (GPC), preferably 50,000 or less in view of solubility for the resin composition, but is preferably 200 or more from the standpoint of reducing the component volatilizing during heating.

The content of the hindered amine-based stabilizer (F) is, from the standpoint of bringing out the thermal stability effect in the presence of oxygen, preferably 0.001 mass% or more, more preferably 0.01 mass% or more, still more preferably 0.1 mass% or more, and in view of pattern formability by radical generation upon exposure, is preferably 15 mass% or less, more preferably 10 mass% or less, still more preferably 5 mass% or less, based on the mass of all components except for the solvent in the photosensitive resin composition.

<Other Additives>

The photosensitive alkali-soluble silicone resin composition preferably contains other additives, in addition to the above-described components (A) to (F). Other additives include, for example, (J) a silane coupling agent, (K) an ultraviolet absorber, a polymerization inhibitor, an antioxidant, a surfactant, and a plasticizer.

(J) Silane Coupling Agent

In order to enhance the adherence of the cured film and the substrate after exposure and development of the photosensitive alkali-soluble silicone resin composition, it is preferable to add (J) a silane coupling agent to the photosensitive alkali-soluble silicone resin composition.

The silane coupling agent (J) includes, for example, 3-(meth)acryloxypropyltrimethoxysilane, 3-(meth)acryloxypropyltriethoxysilane, 3-(meth)acryloxypropylmethyldimethoxysilane, 3-(meth)acryloxypropylmethyldiethoxysilane, p-styryltrimethoxysilane, p-styryltriethoxysilane, p-(1-propenylphenyl)trimethoxysilane, p-(1-propenylphenyl)triethoxysilane, p-(2-propenylphenyl)trimethoxysilane, p-(2-propenylphenyl)triethoxysilane, 3-glycidoxypropyltrimethoxysilane, 3-glycidoxypropyltriethoxysilane, 3-glycidoxypropylmethyldimethoxysilane, 3-glycidoxypropylmethyldiethoxysilane, 2-(3,4-epoxycyclohexyl)trimethoxysilane, 2-(3,4-epoxycyclohexyl)triethoxysilane, 2-(3,4-epoxycyclohexyl)methyldimethoxysilane, 2-(3,4-epoxycyclohexyl)methyldiethoxysilane, vinyltrimethoxysilane, vinyltriethoxysilane, N-2-(aminoethyl)-3-aminopropyltrimethoxysilane, N-2-(aminoethyl)-3-aminopropyltriethoxysilane, N-2-(aminoethyl)-3-aminopropylmethyldimethoxysilane, N-2-(aminoethyl)-3-aminopropylmethyldiethoxysilane, 3-aminopropyltrimethoxysilane, 3-aminopropyltriethoxysilane, 3-aminopropylmethyldimethoxysilane, 3-aminopropyldiethoxysilane, N-phenyl-3-aminopropyltrimethoxysilane, N-phenyl-3-aminopropyltriethoxysilane, a hydrochloride of N-(vinylbenzyl)-2-aminoethyl-3-aminopropyltrimethoxysilane, 3-ureidopropyltrimethoxysilane, 3-ureidopropyltriethoxysilane, 3-mercaptopropyltrimethoxysilane, 3-mercaptopropyltriethoxysilane, 3-mercaptopropylmethyldimethoxysilane, 3-mercaptopropylmethyldiethoxysilane, bis(trimethoxysilylpropyl)tetrasulfide, bis(triethoxysilylpropyl)tetrasulfide, 3-isocyanatopropyltrimethoxysilane, 3-isocyanatopropyltriethoxysilane, 3-trimethoxysilylpropylsuccinic acid anhydride, and 3-triethoxysilylpropylsuccinic acid anhydride.

In the case of adding the silane coupling agent (J), the amount added thereof is, from the standpoint of bringing out the adherence to the substrate, preferably 0.1 mass% or more, more preferably 0.5 mass% or more, and in view of curing reactivity of the photosensitive composition, is preferably 20 mass% or less, more preferably 15 mass% or less, based on the mass of all components except for the solvent in the photosensitive resin composition.

(K) Ultraviolet Absorber

In order to enhance the light resistance of the photosensitive alkali-soluble silicone resin composition and reduce the residue at the development, (K) an ultraviolet absorber may be incorporated into the photosensitive alkali-soluble silicone resin composition. The ultraviolet absorber (K) includes, for example, a benzotriazole-based compound and a benzophenone-based compound. More specifically, the ultraviolet absorber (K) includes, for example, a reaction

product of 2-(2,4-dihydroxyphenyl)-4,6-bis(2,4-dimethylphenyl)-1,3,5-triazine and (2-ethylhexyl)-glycidic acid ester (TINUVIN 405, produced by BASF), 2-(2H-benzotriazol-2-yl)phenol, 2-(2H-benzotriazol-2-yl)-4,6-tert-pentylphenol, 2-(2H-benzotriazol-2-yl)-4-(1,1,3,3-tetramethylbutyl)phenol, 2-(2H-benzotriazol-2-yl)-6-dodecyl-4-methylphenol, 2-(2'-hydroxy-5'-methacryloxyethylphenyl)-2H-benzotriazole, 2-hydroxy-4-methoxybenzophenone, etc.

In the case of adding the ultraviolet absorber (K), the amount added thereof is, from the standpoint of preventing curing of the unexposed area, preferably 0.01 mass% or more, more preferably 0.1 mass% or more, and in view of pattern formability by radical generation upon exposure, is preferably 10 mass% or less, more preferably 5 mass% or less, based on the mass of all components except for the solvent in the photosensitive resin composition.

Polymerization Inhibitor:

In order enhance the thermal stability and storage stability of the photosensitive alkali-soluble silicone resin composition, a radical polymerization inhibitor may be incorporated into the photosensitive alkali-soluble silicone resin composition. The polymerization inhibitor which can be used includes, for example, hydroquinone, N-nitrosodiphenylamine, p-tert-butyl catechol, phenothiazine, N-phenylnaphthylamine, ethylenediaminetetraacetic acid, 1,2-cyclohexanediaminetetraacetic acid, glycol ether diaminetetraacetic acid, 2,6-di-tert-butyl-p-methylphenol, 5-nitroso-8-hydroxyquinoline, 1-nitoso-2-naphthol, 2-nitroso-1-naphthol, 2-nitroso-5-(N-ethyl-N-sulfopropylamino)phenol, N-nitroso-N-phenylhydroxyamine ammonium salt, N-nitroso-N-phenylhydroxylamine ammonium salt, N-nitroso-N-(1-naphthyl)hydroxylamine ammonium salt, bis(4-hydroxy-3,5-di-tert-butyl)phenylmethane, etc.

In the case of adding the polymerization inhibitor, the amount added thereof is, from the standpoint of bringing out the effect of inhibiting polymerization of the photopolymerizable unsaturated double bond, preferably 0.001 mass% or more, more preferably 0.01 mass% or more, and in view of pattern formability by radical generation upon exposure, is preferably 5 mass% or less, more preferably 1 mass% or less, based on the mass of all components except for the solvent in the photosensitive resin composition.

Antioxidant:

In order to enhance the thermal stability of the photosensitive alkali-soluble silicone resin composition in the presence of oxygen, an antioxidant can be added. Such an antioxidant includes a hindered phenol-based antioxidant, a phosphorus-based antioxidant, a lactone-based antioxidant, a vitamin E-based antioxidant, a sulfur-based antioxidant, etc.

Specifically, the antioxidant includes, but is not limited to, triethylene glycol-bis[3-(3-tert-butyl-5-methyl-4-hydroxyphenyl)propionate] (IRGANOX 245, produced by BASF), 1,6-hexanediol-bis[3-(3,5-di-tert-butyl-4-hydroxyphenyl)propionate (IRGANOX 259, produced by BASF), 2,4-bis-(n-octylthio)-6-(4-hydroxy-3,5-di-tert-butylanilino)-1,3,5-triazine (IRGANOX 565, produced by BASF),pentaerythrityl-tetrakis[3-(3,5-di-tert-butyl-4-hydroxyphenyl)propionate (IRGANOX 1010, produced by BASF), 2,2-thio-diethylenebis[3-(3,5-di-tert-butyl-4-hydroxyphenyl)propionate] (IRGANOX 1035, produced by BASF), octadecyl-3-(3,5-di-tert-butyl-4-hydroxyphenyl)propionate (IRGANOX 1076, produced by BASF), N,N'-hexamethylenebis(3,5-di-tert-butyl-4-hydroxyhydrocinnamide) (IRGANOX 1098, produced by BASF), 3,5-di-tert-butyl-4-hydroxy-benzylphosphonate-diethyl ester (IRGAMOD 295, produced by BASF), 1,3,5-trimethyl-2,4,6-tris(3,5-di-tert-butyl-4-hydroxybenzyl)benzene (IRGANOX 1330, produced by BASF), tris-(3,5-di-tert-butyl-4-hydroxybenzyl)isocyanurate (IRGANOX 3114, produced by BASF), octylated diphenylamine (IRGANOX 5057, produced by BASF), 2,4-bis[(octylthio)methyl)-o-cresol (IRGANOX 1520L, produced by BASF), isooctyl-3-(3,5-di-tert-butyl-4-hydroxyphenylpropionate (IRGANOX 1135, produced by BASF), 2,4-bis(dodecylthiomethyl)-6-methylphenol (IRGANOX 1726, produced by BASF), 2,5,7,8-tetramethyl-2-(4,8,12-trimethyltridecyl)chroman-6-ol (IRGANOX E201, produced by BASF), 5,7-di-tert-butyl-3-(3,4-dimethylphenyl)benzofuran-2(3H)-one (IRGANOX HP-136), tris(2,4-di-tert-butylphenyl)phosphite (IRGAFOS 168, produced by BASF), tris[2-[[2,4,8,10-tetrakis(1,1-dimethylethyl)dibenzo[d,f][1,3,2]dioxaphosphepin-6-yl]oxy]ethyl]amine (IRGAFOS 12, produced by BASF), bis(2,4-di-tert-butyl-6-methylphenyl)ethyl phosphite (IRGAFOS 38, produced by BASF), didodecyl 3,3-thiobispropionate (IRGANOX PS800, produced by BASF), dioctadecyl 3,3-thiobispropionate (IRGANOX PS802, produced by BASF), etc.

Also, specifically, the antioxidant includes, but is not limited to, 3,9-bis[2-[3-(3-tert-butyl-4-hydroxy-5-methylphenyl)propionyloxy]-1,1-dimethylethyl]-2,4,8,10-tetraoxaspiro[5,5]undecane (SUMILIZER GA-80, produced by Sumitomo Chemical Co., Ltd.), 2,2'-methylenebis(6-tert-butyl-4-methylphenol) (SUMILIZER MDP-S, produced by Sumitomo Chemical Co., Ltd.), 4,4'-butylidenebis(6-tert-butyl-3-methylphenol) (SUMILIZER BBM-S, produced by Sumitomo Chemical Co., Ltd.), 4,4'-thiobis(6-tert-butyl-3-methylphenol) (SUMILIZER WX-R, produced by Sumitomo Chemical Co., Ltd.), pentaerythrityl-tetrakis(3-laurylthiopropionate (SUMILIZER TP-D, produced by Sumitomo Chemical Co., Ltd.), 2-mercaptobenzimidazole (SUMILIZER MB, produced by Sumitomo Chemical Co., Ltd.), biphenyl-4,4'-diyl-bis[bis(2,4-di-tert-butyl-5-methylphenoxy)phosphine] (GSY-P101, produced by Osaki Industry Co., Ltd.), a reactive product of 2-aminoethanol with a reactive product of cyclohexane and peroxidized N-butyl-2,2,6,6-tetramethyl-4-piperidineamine-2,4,6-trichloro-1,3,5-triazine (TINUVIN 152, produced by BASF), etc.

One of these antioxidants may be used alone, or two or more thereof may be used as a mixture. In the case of adding an antioxidant, the amount added thereof is, from the standpoint of bringing out the thermal stability effect in the presence of oxygen, preferably 0.001 mass% or more, more preferably 0.01 mass% or more, still more preferably 0.1 mass% or more, and in view of pattern formability by radical generation upon exposure, is preferably 15 mass% or less, more preferably 10 mass% or less, still more preferably 5 mass% or less, based on the mass of all components except for the solvent in the photosensitive resin composition.

Surfactant:

In order to ensure coating suitability of the photosensitive alkali-soluble silicone resin composition and film smoothness after drying, a surfactant may be incorporated into the photosensitive alkali-soluble silicone resin composition. The surfactant includes polyoxyethylene alkyl ethers, such as polyoxyethylene lauryl ether, polyoxyethylene stearyl ether and polyoxyethylene oleyl ether; polyoxyethylene arylalkyl ethers, such as polyoxyethylene octylphenyl ether and polyoxyethylene nonylphenyl ether; polyoxyethylene dialkyl esters, such as polyoxyethylene ethylene dilaurate and polyoxyethylene distearate; a fluorine-containing surfactant, such as Megaface F171, 172, 173 (produced by DIC Corporation), Florad FC430, 431 (produced by Sumitomo Ltd.), Asahi Guard AG710, Surflon S-382, SC-101, 102, 103, 104, and 105 (produced by Asahi Glass Co., Ltd.); a silicone-containing surfactant, such as DBE-712 and DBE 821 (produced by DAICEL-CYTEC Company Ltd.), etc.

The amount of such a surfactant added is, in view of coating suitability and reduction in the residue, preferably 0.01 mass% or more, more preferably 0.1 mass% or more, and in view of adherence of pattern after development, is preferably 10 mass% or less, more preferably 5 mass% or less, based on the mass of all components except for the solvent in the photosensitive resin composition.

Plasticizer:

Furthermore, an additive, such as plasticizer may be incorporated into the photosensitive alkali-soluble silicone resin composition, if desired. Such an additive includes, for example, phthalic acid esters, such as diethyl phthalate, o-toluenesulfonic acid amide, p-toluenesulfonic acid amide, tributyl citrate, triethyl citrate, triethyl acetylcitrate, tri-n-propyl acetylcitrate, tri-n-butyl acetylcitrate, polypropylene glycol, polyethylene glycol, polyethylene glycol alkyl ether, and polypropylene glycol alkyl ether.

<Properties of Photosensitive Alkali-Soluble Silicone Resin Composition>

As for the acid value of the photosensitive alkali-soluble silicone resin composition for use in the present invention, in view of reduction in the residue after development and crack resistance of the cured film, the acid value is preferably 0.1 mgKOH/g or more, more preferably 1 mgKOH/g or more, still more preferably 5 mgKOH/g or more, and in view of pattern adherence, the acid value is preferably 200 mgKOH/g or less, more preferably 170 mgKOH/g or less, still more preferably 150 mgKOH/g or less.

The molar concentration of the photopolymerizable unsaturated double bond group of the photosensitive alkali-soluble silicone resin composition for use in the present invention is, from the standpoint of obtaining sufficient resolution, preferably 0.5 mmol/g or more, more preferably 0.1 mmol/g or more, and in view of reduction in the residue during development, the molar concentration is preferably 10.0 mmol/g or less, more preferably 5.0 mmol/g or less. This concentration of the photopolymerizable unsaturated double bond group can be calculated by dividing the number of unsaturated bonds contained in the alkali-soluble silicone resin, alkali-soluble resin and photopolymerizable unsaturated double bond-containing compound in the photosensitive resin composition, by the total mass of the photosensitive resin composition.

The method for quantitatively determining silanol includes, for example, FT-IR spectrum measurement, Karl-Fischer titration method, and $^1$H-NMR spectrum measurement.

The method for specifying the amount of silanol in the alkali-soluble silicone resin composition by FT-IR spectrum measurement includes a method of calculating the amount from the ratio of the intensity ($I_x$) in the region of 1,000 to 1,100 $cm^{-1}$ in which an Si-O stretching vibration peak mainly appears, selected from the highest intensity when a maximum peak is not present, the intensity of one maximum peak when only one maximum peak is present, and the intensity of a highest maximum peak when a plurality of maximum peaks are present, to the intensity ($I_y$) in the region of 880 to 920 $cm^{-1}$ that is a bending vibration peak of Si-O-H, selected from the highest intensity when a maximum peak is not present, the intensity of one maximum peak when only one maximum peak is present, and the intensity of a highest maximum peak when a plurality of maximum peaks are present.

In the alkali-soluble silicone resin composition, for obtaining cold-heat shock resistance, the proportion of a

silanol group of the silicone resin contained in the alkali-soluble silicone resin composition is preferably smaller, and in the FT-IR spectrum, the ratio ($I_y/I_x$) of the intensity ($I_y$) to the intensity ($I_x$) is preferably from 0.01 to 0.4, more preferably from 0.01 to 0.25.

While not being bound by theory, it is presumed that the remaining amount of silanol is preferably small, because in this case, the remaining stress due to silanol-to-silanol contraction during heating is reduced, and it is presumed that the main-chain skeleton structure of the silicone resin contained in the alkali-soluble silicone resin composition greatly affects physical properties, such as cold-heat shock test resistance.

The method for specifying the Si-O-Si skeleton structure of the silicone resin includes a three-dimensional crosslinking degree (T) calculated from the $^{29}$Si-NMR spectrum. The three-dimensional crosslinking degree (T) can be calculated according to following formula (IV) and, in view of crack resistance and cold-heat shock test resistance, is preferably 0.15 or less, more preferably 0.1 or less.

$$\text{Three-dimensional crosslinking degree (T)} = (A_{T3}+A_{Q3}+A_{Q4}*2)/\{(A_{M0}+A_{M1})+(A_{D0}+A_{D1}+A_{D2})+(A_{T0}+A_{T1}+A_{T2}+A_{T3})+(A_{Q0}+A_{Q1}+A_{Q2}+A_{Q3}+A_{Q4})\} \quad \text{(formula IV)}$$

In formula IV, out of Si atoms, when the number of atoms bonded to O atom is one is designated as "component M"; when the number of atoms bonded to O atom is two is designated as "component D"; when the number of atoms bonded to O atom is three is designated as "component T"; and when the number of atoms bonded to O atom is four is designated as "component Q". Furthermore, out of component M, when one existing Si-O bond is Si-O-Si bond is designated as "component M1", and when having no Si-O-Si bond is designated as "component MO". Out of two Si-O bonds existing in the component D, when having no Si-O-Si bond is designated as "component D0"; when having one is designated as "component D1"; and when having two is designated as "component D2". Out of three Si-O bonds existing in the component T, when having no Si-O-Si bond is designated as "component T0"; when having one is designated as "component T1"; when having two is designated as "component T2"; and when having three is designated as "component T3". Out of four Si-O bonds existing in the component T, when having no Si-O-Si bond is designated as "component Q0"; when having one is designated as "component Q1"; when having two is designated as "component Q2"; when having three is designated as "component Q3"; and when having four is designated as "component Q4". $A_X$ represents the integral value of component X in the $^{29}$Si-NMR spectrum, and X is any one of "M0", "M1", "D0", "D1", "D2", "T0", "T1", "T2", "T3", "Q0", "Q1", "Q2", "Q3" and "Q4".

Separately from formula (IV), there is a three-dimensional crosslinking degree T' indicating how much component T, out of "component T" in which the number of atoms bonded to O atom is three, participates in the three-dimensional crosslinking. The three-dimensional crosslinking degree (T') can be calculated according to following formula (V) and, in view of crack resistance and cold-heat shock test resistance, is preferably 0.3 or less, more preferably 0.25 or less, still more preferably 0.2 or less.

$$\text{Three-dimensional crosslinking degree (T')} = (A_{T3})/(A_{T0}+A_{T1}+A_{T2}+A_{T3}) \quad \text{(formula V)}$$

<Cured Product of Photosensitive Alkali-Soluble Silicone Resin Composition>

In the cured product obtained by curing the photosensitive alkali-soluble silicone resin composition for use in the present invention, the transmittance of light at a wavelength of 400 nm after baking the cured product having a thickness of 10 μm at 220°C for 3 hours in an atmosphere is preferably 70% or more.

Also, the present invention relates to a cured product or transparent insulating film obtained by curing the photosensitive alkali-soluble silicone resin composition above.

Furthermore, the present invention relates to a cured product obtained by curing a resin composition comprising (G) a polyorganosiloxane, (H) an alkali-soluble resin except for the component G, and (C) a photopolymerization initiator, wherein the three-dimensional crosslinking degree (T) calculated from the integration ratio in the solid $^{29}$Si-NMR spectrum of the cured product according to formula (IV) is 0.2 or less or the three-dimensional crosslinking degree (T') calculated according to formula (V) is 0.45 or less.

The polyorganosiloxane (G) is a polymer compound having a skeleton by a siloxane bond, and the polyorganosiloxane (G) may be synthesized by any method but is preferably obtained by a method of reacting an alkoxysilane compound and a silanediol compound in the presence of a catalyst or more preferably by a method of causing condensation without positively adding water. Also, the polyorganosiloxane (G) preferably contains, out of Si structures, the component D or the component T, more preferably both the component D and the component D.

The polyorganosiloxane (G) includes, for example, the above-described alkali-soluble silicone resin (A), and the raw material of the polyorganosiloxane (G) includes, for example, the above-described silane compounds (A-1) to (A-3).

The alkali-soluble resin (H) except for the polyorganosiloxane (G) includes, for example, the above-described alkali-soluble resin (B).

The resin composition preferably further contains at least one member selected from the group consisting of (F) a hindered amine-based stabilizer, (I) a photocrosslinkable monomer, (J) a silane coupling agent and (K) an ultraviolet absorber, in addition to the polyorganosiloxane (G), the alkali-soluble resin (H) except for the component G, and the photopolymerization initiator (C). The photocrosslinkable monomer (I) is a compound undergoing crosslinking by light and includes, for example, the above-described photopolymerizable unsaturated double bond-containing compound (D).

When the cured product of the present invention has a thickness of 10 μm, the transmittance of light at a wavelength of 400 nm under the conditions after baking the cured product at 220°C for 3 hours in an atmosphere is preferably 70% or more.

The cured product of the present invention, similarly to the resin composition, varies in the physical properties according to the main-chain skeleton (Si-O-Si) structure of the silicon resin. In the case of a cured product, since condensation generally more proceeds due to an external stimulation, such as heat, in the process until curing and in the process after curing, than in the case of a resin composition, the cure product has a structure different from the resin composition.

The main-chain skeleton structure of the silicone resin in the cured product can be measured by solid $^{21}$Si-NMR spectrum.

In the cured product, in view of crack resistance and cold-heat shock resistance, the three-dimensional crosslinking degree (T) is preferably 0.2 or less, more preferably 0.18 or less.

Also, the three-dimensional crosslinking degree (T') is preferably 0.45 or less, more preferably 0.4 or less, still more preferably 0.35 or less.

While not being bound by theory, it is presumed that when the three-dimensional crosslinking degree (T) is high, the flexibility of the cured product is reduced and the crack resistance decreases.

The glass transition temperature (Tg) of the cured product is preferably higher, so that deformation during heat process increases. The glass transition temperature (Tg) of the cured product is preferably 80°C or more, more preferably 90°C or more.

A suitable example of the method for forming a cured relief pattern by using the photosensitive alkali-soluble silicone composition is described below.

First, the above-described photosensitive alkali-soluble silicon composition is coated on various desired base materials, such as silicon wafer, ceramic substrate and aluminum substrate. As for the coating device or coating method, a spin coater, a die coater, a spray coater, dipping, printing, a blade coater, roll coating, etc., can be used. The coated base material is softbaked at 80 to 200°C for 1 to 15 minutes and thereafter, irradiated with an actinic ray through a desired photomask by using an exposure projection device, such as a contact aligner, mirror projection and stepper.

As the actinic ray, an X-ray, an electron beam, an ultraviolet light, a visible light, etc., may be utilized, but in the present invention, an actinic ray having a wavelength of 200 to 500 nm is preferably used. In view of resolution of pattern and handleability, the wavelength of the light source is preferably UV-i line (365 nm), among these, and a stepper is particularly preferred as the exposure projection device.

Thereafter, if desired, post-exposure baking (PEB) or pre-development baking by an arbitrary combination of temperature and time (preferably at a temperature of 40 to 200°C for a time of 10 to 360 seconds) may be carried out for the purpose of improving photosensitivity.

Subsequently, a cure product is developed, and this can be carried out by a method selected from a dipping method, a puddle method, a shower method, a rotational spray method, etc. The developer is preferably an alkaline developer. A good solvent for the composition of the present invention may be used alone, or a good solvent and a poor solvent may be appropriately mixed and used. Suitable examples of the alkali developer include an aqueous solution of an alkali metal or alkaline earth metal carbonate; an aqueous solution of an alkali metal hydroxide; an aqueous solution of ammonium hydroxides, such as tetramethyl ammonium hydroxide, tetraethyl ammonium hydroxide and tetrapropyl ammonium hydroxide; amines, such as diethylamine, triethylamine, diethanolamine and triethanolamine, and an aqueous solution thereof. In particular, it is preferable to carry out the development at a temperature of 20 to 35°C by using an aqueous weakly alkaline solution containing from 0.05 to 10 mass% of carbonates, such as sodium carbonate, potassium carbonate and lithium carbonate; ammonium hydroxides, such as tetramethyl ammonium hydroxide and tetraethylammonium hydroxide; or amines, such as diethylamine and diethanolamine.

After development, washing with a rinsing solution is carried out to remove the developer, whereby a coating film with a relief pattern is obtained. As the rinsing solution, distilled water, methanol, ethanol, isopropanol, propylene

glycol monomethyl ether, etc., may be used individually or as an appropriate mixture, or the washing may be carried out by stepwise combining these.

The thus-obtained relief pattern is converted to a cured relief pattern at a curing temperature of 150 to 250°C that is by far lower than that for the conventional polyimide precursor composition. This heating/curing can be carried out using a hot plate, an inert oven, or a temperature-programmed oven in which a temperature program can be set. As for the gas of the atmosphere when heating/curing the relief pattern, air may be used, or an inert gas, such as nitrogen and argon may be used, if desired.

The cured relief pattern described above is used as any one selected from the group consisting of a surface protective film, an interlayer insulating film, an α-ray shielding film, which are for a semiconductor device formed on a base material, such as silicon wafer, and a support (partition) between a microstructure, such as microlens array and a package material, and a known manufacturing method of a semiconductor device is applied to other processes, whereby various semiconductor devices including an optical element, such as CMOS image sensor can be manufactured. Also, an electronic component or semiconductor device having a coating film composed of a resin obtained by curing the photosensitive alkali-soluble silicon resin composition can be obtained.

EXAMPLES

The method of the present invention is described in greater detail below by referring to Examples. However, the present invention is not limited to the following

Examples.

[Synthesis Example 1]

(Synthesis of Alkali-Soluble Silicone Resin P-1)

A 500-ml oblique flask was charged with 0.67 mol (144.2 g) of DPD (diphenylsilanediol) as the silanediol compound, 0.47 mol (116.7 g) of MEMO (3-methacryloxypropyltrimethoxysilane) as the alkoxysilane compound, 0.20 mol (52.5.g) of (3-trimethoxysilylpropyl)succinic acid anhydride as the dicarboxylic acid anhydride structure-containing alkoxysilane compound, and 0.0015 mol (0.28 g) of barium hydroxide as the catalyst. In the state of a condenser being fixed to the oblique flask, the temperature was gradually raised from room temperature to 100°C by using an oil bath and after confirming reflux by methanol generated at 100°C, reflux was continued for 1 hour at the same temperature. Thereafter, the condenser was removed and by connecting a cold trap and a vacuum pump, methanol was removed while gradually reducing the pressure to avoid bumping. When the degree of vacuum reached approximately from 1 to 3 torr, vacuum drawing was continued at 100°C with stirring for 10 hours and thereafter, the system was gradually returned to the atmospheric pressure to obtain a transparent alkali-soluble silicone resin (P-1, viscosity at 40°C: 80 Poise).

[Synthesis Example 2]

(Synthesis of Alkali-Soluble Silicone Resin P-2)

A 500-ml oblique flask was charged with 0.67 mol (144.2 g) of DPD (diphenylsilanediol) as the silanediol compound, 0.54 mol (134.1 g) of MEMO (3-methacryloxypropyltrimethoxysilane) as the alkoxysilane compound, 0.13 mol (34.1 g) of (3-trimethoxysilylpropyl)succinic acid anhydride as the dicarboxylic acid anhydride structure-containing alkoxysilane compound, and 0.0015 mol (0.28 g) of barium hydroxide as the catalyst. In the state of a condenser being fixed to the oblique flask, the temperature was gradually raised from room temperature to 100°C by using an oil bath and after confirming reflux by methanol generated at 100°C, reflux was continued for 1 hour at the same temperature. Thereafter, the condenser was removed and by connecting a cold trap and a vacuum pump, methanol was removed while gradually reducing the pressure to avoid bumping. When the degree of vacuum reached approximately from 1 to 3 torr, vacuum drawing was continued at 100°C with stirring for 10 hours and thereafter, the system was gradually returned to the atmospheric pressure to obtain a transparent alkali-soluble silicone resin (P-2, viscosity at 40°C: 70 Poise).

[Synthesis Example 3]

(Synthesis of Alkali-Soluble Silicone Resin P-3)

An alkali-soluble silicone resin (P-3, viscosity at 40°C: 20 Poise) was obtained in the same manner as in Synthesis Example 1 except that DPD in Synthesis Example 1 was changed to DCPD (dicyclopentylsilanediol).

[Synthesis Example 4]

(Synthesis of Alkali-Soluble Silicone Resin P-4)

An alkali-soluble silicone resin (P-4, viscosity at 40°C: 100 Poise) was obtained in the same manner as in Synthesis Example 1 except that MEMO in Synthesis Example 1 was changed to phenylmethoxysilane.

[Synthesis Example 5]

(Synthesis of Alkali-Soluble Silicone Resin P-5)

An alkali-soluble silicone resin (P-5, viscosity at 40°C: 140 Poise) was obtained in the same manner as in Synthesis Example 1 except that MEMO in Synthesis Example 1 was changed to 3-glycidoxypropyltrimethoxysilane.

[Synthesis Example 6]

(Synthesis of Alkali-Soluble Silicone Resin P-6)

A 500-ml oblique flask was charged with 0.67 mol (132.9 g) of phenyltrimethoxysilane as the alkoxysilane compound, 0.47 mol (122.4 g) of MEDMO (3-methacryloxypropylmethyldimethoxysilane) as the alkoxysilane compound, 0.20 mol (52.5 g) of (3-trimethoxysilylpropyl)succinic acid anhydride as the dicarboxylic acid anhydride structure-containing alkoxysilane compound, and 70 g of isopropyl alcohol, and an aqueous solution obtained by mixing 70.0 g of distilled water, 0.1 g of 36% hydrochloric acid and 30 g of isopropyl alcohol was added dropwise with stirring at room temperature. Thereafter, in the state of a condenser being fixed to the oblique flask, the solution was stirred at 70°C for 5 hours. Subsequently, the condenser was removed and by connecting a cold trap and a vacuum pump, methanol and isopropyl alcohol were removed while gradually reducing the pressure to avoid bumping. When the degree of vacuum reached approximately from 1 to 3 torr, vacuum drawing was continued at 100°C with stirring for 1 hour and thereafter, the system was gradually returned to the atmospheric pressure to obtain a transparent alkali-soluble silicone resin (P-6, viscosity at 40°C: 120 Poise).

[Synthesis Example 7]

(Synthesis of Alkali-Soluble Silicone Resin P-7)

An alkali-soluble silicone resin (P-7, viscosity at 40°C: 40 Poise) was obtained in the same manner as in Synthesis Example 1 except that (3-trimethoxysilylpropyl)succinic acid anhydride in Synthesis Example 1 was changed to phenyltrimethoxysilane.

[Synthesis Example 8]

(Synthesis of Alkali-Soluble Silicone Resin P-8)

A 500-ml oblique flask was charged with 0.10 mol (21.5 g) of DPD (diphenylsilanediol) as the silanediol compound (a), 0.10 mol (24.8 g) of MEDMO (3-methacryloxypropylmethyldimethoxysilane) as the alkoxysilane compound, 1.1 mol (288.5 g) of (3-trimethoxysilylpropyl)succinic acid anhydride as the dicarboxylic acid anhydride structure-containing alkoxysilane compound, and 70 g of isopropyl alcohol, and an aqueous solution obtained by mixing 70.0 g of distilled water, 0.1 g of 36% hydrochloric acid and 30 g of isopropyl alcohol was added dropwise with stirring at room temperature. Thereafter, in the state of a condenser being fixed to the oblique flask, the solution was stirred at 70°C for 5 hours. Subsequently, the condenser was removed and by connecting a cold trap and a vacuum pump, methanol and isopropyl alcohol were removed while gradually reducing the pressure to avoid bumping. When the degree of vacuum reached approximately from 1 to 3 torr, vacuum drawing was continued at 100°C with stirring for 1 hour and thereafter, the system was gradually returned to the atmospheric pressure to obtain a transparent alkali-soluble silicone resin (P-8, viscosity at 40°C: 420 Poise).

[Synthesis Example 9]

(Synthesis of Alkali-Soluble Silicone Resin P-9)

A 300-ml oblique flask was charged with 0.214 mol (52.33 g) of dimethoxydiphenylsilane as the alkoxysilane compound (a), 0.150 mol (37.22 g) of MEMO (3-methacryloxypropyltrimethoxysilane), 0.0642 mol (18.53 g) of (3-trimethoxysilylpropyl)succinic acid anhydride as the dicarboxylic acid anhydride structure-containing alkoxysilane compound, and 86 g of propylene glycol monomethyl ether acetate (PGMEA), and an aqueous solution obtained by mixing 7.7 g of distilled water and 1.0 g of 5 mol/L hydrochloric acid was added dropwise with stirring at room temperature. Thereafter, in the state of a condenser being fixed to the oblique flask, the solution was stirred at 95°C for 2 hours. Subsequently, the condenser was removed and by connecting a cold trap and a vacuum pump, methanol, water and PGMEA were removed while gradually reducing the pressure to avoid bumping. When the degree of vacuum reached about 6 hPa, vacuum drawing was continued with stirring for 2 hours and thereafter, the system was gradually returned to the atmospheric pressure to obtain a transparent alkali-soluble silicone resin (P-9, viscosity at 40°C: 200 Poise or more).

Alkali-soluble organic resins (O-1 to O-12) used were fabricated or prepared as shown in Table 1.

[Table 1]

| | Name of Alkali-Soluble Resin | Acid Value (mgKOH/g) |
|---|---|---|
| O-1 | A methyl ethyl ketone solution with a solid content of 50 mass% of a copolymer having a structure of methacrylic acid/methyl methacrylate/benzyl methacrylate/styrene (mass ratio: 15/15/60/10) and having a weight average molecular weight of 30,000. | 98 |
| O-2 | A methyl ethyl ketone solution with a solid content of 50 mass% of a copolymer having a structure of methyl methacrylate/methacrylic acid/n-butyl methacrylate (mass ratio: 55/15/30) and having a weight average molecular weight of 30,000. | 98 |
| O-3 | A methyl ethyl ketone solution with a solid content of 50 mass% of a copolymer having a structure of methyl methacrylate/methacrylic acid/n-butyl methacrylate (mass ratio: 40/30/30) and having a weight average molecular weight of 50,000. | 196 |
| O-4 | Cyclomer P 230 AA (carboxyl group-containing vinyl polymer, produced by DAICEL-CYTEC Company Ltd.) | 40 |
| O-5 | Ripoxy SPC-1000 (carboxyl group-containing vinyl polymer, produced by Showa Denko K.K.) | 51 |
| O-6 | EA-6340 (novolak-type phenol polymer, produced by Shin-Nakamura Chemical Co., Ltd.) | 85 |
| O-7 | Ripoxy PR-300 (novolak-type phenol polymer, produced by Showa Denko K.K.) | 80 |
| O-8 | KAYARAD PCR-1069 (carboxyl group-containing epoxy polymer, produced by Nippon Kayaku Co., Ltd.) | 69 |
| O-9 | EXP-1421 (novolak-type phenol polymer, produced by Nippon Kayaku Co., Ltd.) | 72 |
| O-10 | DAUA-167 (carboxyl group-containing urethane polymer, produced by Kyoeisha Chemical Co., Ltd.) | 27 |
| O-11 | Ripoxy SPN (carboxyl group-containing ester polymer, produced by Showa Denko K.K.) | 60 |
| O-12 | Ripoxy SPC-1001 (carboxyl group-containing vinyl polymer, produced by Showa Denko K.K.) | 87 |

[Examples 1 to 25 and Comparative Examples 1 and 2]

(Preparation of Photosensitive Alkali-Soluble Silicon Resin Composition)

Various components were prepared and mixed as shown in Tables 2 to 4. The mixture was filtered under pressure through a PP-made filter having a pore size of 2.5 microns to obtain a liquid composition.

[Table 1]

| | | AV (mgKOH/g) | EX. 1 | EX. 2 | EX. 3 | EX. 4 | EX. 5 | EX. 6 | EX. 7 | EX. 8 | EX. 9 |
|---|---|---|---|---|---|---|---|---|---|---|---|
| (A) Silicone resin | P-1 | 32 | 40 | | | | | | 30 | | |
| | P-2 | 21 | | 40 | | | | | | | |
| | P-3 | 32 | | | 35 | | | | | 30 | 30 |
| | P-4 | 32 | | | | 30 | | | | | |
| | P-5 | 32 | | | | | 30 | | | | |
| | P-6 | 32 | | | | | | 40 | | | |
| | P-7 | 0 | | | | | | | | | |
| | P-8 | 171 | | | | | | | | | |
| (B) Alkali-soluble resin (in terms of solid content) | 0-1 | 98 | | | | | | | 40 | | 35 |
| | 0-2 | 98 | | | | | | | | 40 | |
| | 0-3 | 196 | | | | | | | | | 5 |
| | 0-4 | 40 | 30 | 30 | 30 | 40 | 40 | 30 | | | |
| | 0-5 | 51 | | | | | | | | | |
| | 0-6 | 85 | | | | | | | | | |
| | 0-7 | 80 | | | | | | | | | |
| | 0-8 | 69 | | | | | | | | | |
| | 0-9 | 72 | | | | | | | | | |
| | 0-10 | 27 | | | | | | | | | |
| | 0-11 | 60 | | | | | | | | | |
| (C) Initiator | Irg819 | | 0.4 | 0.4 | 0.4 | 0.4 | 0.4 | 0.4 | 0.4 | 0.4 | 0.4 |
| (D) Photopolymerizable unsaturated double bond-containing compound | EA-1020 | | 20 | 20 | | 20 | 20 | 20 | 5 | 5 | 5 |
| | BPE500 | | | | 15 | | | 10 | 10 | 10 | 10 |
| | M-510 | | 10 | 10 | 20 | 10 | 10 | | 15 | 15 | 15 |
| (E) Solvent | PGMEA | | 60 | 60 | 60 | 60 | 60 | 60 | | | |
| | | | | | | | | | 40 | 40 | 40 |
| | | | | | | | | | 40 | 40 | 40 |
| Additive | TIN405 | | 0.5 | 0.5 | 0.5 | 0.5 | 0.5 | 0.5 | 0.5 | 0.5 | 0.5 |
| | Irg245 | | 0.3 | 0.3 | 0.3 | 0.3 | 0. 3 | 0.3 | 0.3 | 0.3 | 0.3 |
| | MEMO | | 5 | 5 | 5 | 5 | 5 | 5 | 5 | 5 | 5 |
| Acid value (A)/acid value (B) | | | 0.80 | 0.54 | 0.80 | 0.80 | 0.80 | 0.80 | 0.33 | 0.33 | 0.29 |
| EX.: Example, AV: acid value, M.E.K.: methyl ethyl ketone, E.A.: ethyl acetate | | | | | | | | | | | |

[Table 3]

| | | AV (mgKOH/g) | EX. 10 | EX. 11 | EX. 12 | EX. 13 | EX. 14 | EX. 15 | EX. 16 | EX. 17 | EX. 18 |
|---|---|---|---|---|---|---|---|---|---|---|---|
| (A) Silicone resin | P-1 | 32 | 40 | 50 | 50 | | 40 | | 40 | 40 | 30 |
| | P-2 | 21 | | | | | | | | | |
| | P-3 | 32 | | | | 40 | | 30 | | | |
| | P-4 | 32 | | | | | | | | | |
| | P-5 | 32 | | | | | | | | | |
| | P-6 | 32 | | | | | | | | | |
| | P-7 | 0 | | | | | | | | | 10 |
| | P-8 | 171 | | | | | | | | | |
| (B) Alkali-soluble resin (in terms of solid content) | 0-1 | 98 | | | | | | | | | |
| | 0-2 | 98 | | | | | | | | | |
| | 0-3 | 196 | | | | | | | | | |
| | 0-4 | 40 | | | | | | | | | 30 |
| | 0-5 | 51 | 40 | | | | | | | | |
| | 0-6 | 85 | | 10 | | | | | | | |
| | 0-7 | 80 | | | 10 | 20 | | | | | |
| | 0-8 | 69 | | | | | 30 | | | | |
| | 0-9 | 72 | | | | | | 20 | | | |
| | 0-10 | 27 | | | | | | | 30 | | |
| | 0-11 | 60 | | | | | | | | 30 | |
| (C) Initiator | Irg819 | | 0.4 | 0.4 | 0.4 | 0.4 | 0.4 | 0.4 | 0.4 | 0.4 | 0.4 |
| (D) Photopolymerizable unsaturated double bond-containing compound | EA-1020 | | 10 | 30 | 30 | 30 | 20 | 10 | | 10 | 20 |
| | BPE500 | | | 10 | 10 | | 10 | 10 | 20 | 10 | 10 |
| | M-510 | | 10 | | | 10 | | 20 | 10 | 10 | |
| (E) Solvent | PGMEA | | | 60 | 60 | 60 | 60 | 60 | 60 | 60 | 60 |
| | M.E.K. | | | | | | | | | | |
| | E.A. | | 40 | | | | | | | | |
| Additive | TIN405 | | 0.5 | 0.5 | 0.5 | 0.5 | 0.5 | 0.5 | 0.5 | 0.5 | 0.5 |
| | Irg245 | | 0.3 | 0.3 | 0.3 | 0.3 | 0.3 | 0.3 | 0.3 | 0.3 | 0.3 |
| | MEMO | | 5 | 5 | 5 | 5 | 5 | 5 | 5 | 5 | 5 |
| Acid value (A)/acid value (B) | | | 0.63 | 0.38 | 0.40 | 0.40 | 0.47 | 0.45 | 1.19 | 0.54 | 0.60 |
| EX.: Example, AV: acid value, M.E.K.: methyl ethyl ketone, E.A.: ethyl acetate | | | | | | | | | | | |

[Table 4]

| | | AV (mgKOH/g) | EX. 19 | EX. 20 | EX. 21 | EX. 22 | EX. 23 | EX. 24 | EX. 25 | EX. 1 | C. EX. 2 |
|---|---|---|---|---|---|---|---|---|---|---|---|
| (A) Silicone resin | P-1 | 32 | | 80 | 40 | | | | | 70 | |
| | P-2 | 21 | 30 | | | 40 | | | | | |
| | P-3 | 32 | | | | | 35 | | | | |
| | P-4 | 32 | | | | | | 30 | | | |
| | P-5 | 32 | | | | | | | 30 | | |
| | P-6 | 32 | | | | | | | | | |
| | P-7 | 0 | | | | | | | | | |
| | P-8 | 171 | 10 | | | | | | | | |
| (B) Alkali-soluble resin (in terms of solid content) | 0-1 | 98 | | | | | | | | | |
| | 0-2 | 98 | | | | | | | | | |
| | 0-3 | 196 | | | | | | | | | |
| | 0-4 | 40 | 30 | | 30 | 30 | 30 | 40 | 40 | | 50 |
| | 0-5 | 51 | | | | | | | | | |
| | 0-6 | 85 | | 20 | | | | | | | |
| | 0-7 | 80 | | | | | | | | | |
| | 0-8 | 69 | | | | | | | | | |
| | 0-9 | 72 | | | | | | | | | |
| | 0-10 | 27 | | | | | | | | | |
| | 0-11 | 60 | | | | | | | | | |
| (C) Initiator | Irg819 | | 0.4 | 0.4 | 0.75 | 0.75 | 0. 75 | 0.75 | 0.75 | 0.4 | 0.4 |
| (D) Photopolymerizable unsaturated double bond-containing compound | EA-1020 | | 20 | | 20 | 20 | | 20 | 20 | 10 | 30 |
| | BPE500 | | | | | | 15 | | | 10 | 10 |
| | M-510 | | 10 | | 10 | 10 | 20 | 10 | 10 | 10 | 10 |
| (E) Solvent | PGMEA | | 60 | 60 | 60 | 60 | 60 | 60 | 60 | 60 | 60 |
| | M.E.K. | | | | | | | | | | |
| | E.A. | | | | | | | | | | |
| Additive | TIN405 | | 0.5 | 0.5 | 0.5 | 0.5 | 0.5 | 0.5 | 0.5 | 0.5 | 0.5 |
| | Irg245 | | 0.3 | 0.3 | 0.3 | 0.3 | 0.3 | 0.3 | 0.3 | 0.3 | 0.3 |
| | MEMO | | 5 | 5 | 5 | 5 | 5 | 5 | 5 | 5 | 5 |
| Acid value (A)/acid value (B) | | | 1.47 | 0.38 | 0.80 | 0.54 | 0. 80 | 0.80 | 0.80 | 0.00 | 0.00 |
| EX.: Example, C.EX: Comparative Example, AV: acid value, M.E.K.: methyl ethyl ketone, E.A.: ethyl acetate | | | | | | | | | | | |

Description of Abbrevation in Tables 2 to 4:

Irg819: IRGACURE 819
EA-1020: epoxy acrylate "NK OLIGO EA-1020" (produced by Shin-Nakamura Chemical Co., Ltd.)
BPE500: ethoxylated bisphenol A dimethacrylate "BPE500" (produced by Shin-Nakamura Chemical Co., Ltd.)
M-510: polybasic acid-modified acryl oligomer "ARONIX M-510" (produced by Toagosei Co., Ltd.)
PGMEA: propylene glycol monomethyl ether acetate
TIN405: TINUVIN 405
Irg245: IRGANOX 245
MEMO: 3-methacryloxypropyltrimethoxysilane

[Evaluation of Composition]

The varnish-like compositions obtained in Examples 1 to 25 and Comparative Examples 1 and 2 were evaluated for the following items, and the results are shown in Tables 5 to 7.

1. Alkali Developability

The obtained liquid composition was spin-coated on a glass substrate previously washed with an aqueous alkali solution, and the solvent was volatilized by prebake at 95°C. The glass substrate with a coating film was exposed at an exposure dose of 400 mJ/$cm^2$ through a reticle with a test pattern by using an i-line stepper exposure machine (model name: NSR2005i8A, manufactured by Nikon Corp.). The exposure was carried out in an atmosphere. Thereafter, development was carried out using an alkali developer (Developer produced by AZ Electronic Materials; an aqueous 2.38% tetramethylammonium hydroxide solution) under the conditions of 23°C and 30 secondsxtwo times, and rinsing with pure water was carried out to remove the unexposed area of the coating film. Incidentally, the thickness of the coating film was adjusted to 10 μm after development by controlling the rotation speed at the spin coating. The obtained pattern was observed by an optical microscope and evaluated according to the following criteria.

A: Undeveloped portion was not observed in between the pattern.
B: Undeveloped portion was partially observed in between the pattern.
C: Many undeveloped portions were observed in between the pattern.

2. Pattern Formability

The cross-section of the pattern obtained above was observed by SEM and evaluated according to the following criteria.

A: The pattern was formed in a perpendicular or forward tapered shape.
B: The pattern was partially distorted or reverse tapered.
C: The pattern was formed in a distorted or reverse tapered shape.

3. Residual Film Ratio

The ratio of the thickness of the coating film obtained by prebake to the thickness of the pattern obtained through exposure in an atmosphere (in the presence of oxygen) and alkali development is defined as the residual film ratio and evaluated as follows.

Residual film ratio = (thickness of pattern after alkali development/thickness of coating film after coating and removal of solvent)×100 (%)

4. Light Transmittance

The coating film obtained after alkali development was baked at 220°C for 30 minutes in an atmosphere, and the transmittance of light in 800 to 300 nm was measured using a spectrophotometer UV-1600PC (manufactured by Shimadzu Corporation) by placing a glass substrate with no coating film in the reference part, whereby the transmittance

of light with 400 nm was confirmed.

5. Thermal Crack Resistance

The coating film obtained after alkali development was baked at 220°C for 180 minutes in an atmosphere, and whether a crack was formed or not in the coating film was confirmed with an eye.

A: A crack was not confirmed.
B: A crack was rarely formed.
C: A crack was formed.

6. Heat-Resistant Transparency

The coating film obtained after alkali development was baked at 220°C for 180 minutes in an atmosphere, and the transmittance of light with 400 nm was measured using a spectrophotometer by placing a glass substrate with no coating film in the reference part.

[Table 5]

| | EX. 1 | EX. 2 | EX. 3 | EX. 4 | EX. 5 | EX. 6 | EX. 7 | EX. 8 | EX. 9 |
|---|---|---|---|---|---|---|---|---|---|
| 1. Alkali developability | **A** | **A** | **A** | **A** | **A** | **A** | **A** | **A** | **A** |
| 2. Pattern formability | **A** | **A** | **A** | **A** | **B** | **A** | **B** | **B** | **B** |
| 3. Residual film ratio (%) | **91%** | **93%** | **92%** | **93%** | **92%** | **91%** | **97%** | **97%** | **95%** |
| 4. L.T. (λ=400 nm, %) | **98%** | **98%** | **96%** | **96%** | **95%** | **96%** | **97%** | **97%** | **94%** |
| 5. Thermal crack resistance (after 220°C, 180 min, atm) | **A** | **A** | **A** | **A** | **A** | **A** | **A** | **A** | **A** |
| 6. Heat-resistant transparency (after 220°C, 180 min, atm, λ=400 nm, %) | **95%** | **95%** | **93%** | **89%** | **91%** | **94%** | **89%** | **89%** | **87%** |
| EX.: Example, L.T.: light transmittance, atm: in an atmosphere | | | | | | | | | |

[Table 6]

| | EX. 10 | EX. 11 | EX. 12 | EX. 13 | EX. 14 | EX. 15 | EX. 16 | EX. 17 | EX. 18 |
|---|---|---|---|---|---|---|---|---|---|
| 1. Alkali developability | **A** | **A** | **A** | **A** | **A** | **A** | **A** | **A** | **A** |
| 2. Pattern formability | **A** | **A** | **A** | **A** | **A** | **A** | **A** | **A** | **A** |
| 3. Residual film ratio (%) | **97%** | **92%** | **91%** | **90%** | **91%** | **90%** | **91%** | **91%** | **91%** |
| 4. L.T. (λ=400 nm, %) | **98%** | **97%** | **97%** | **97%** | **96%** | **95%** | **90%** | **96%** | **97%** |
| 5. Thermal crack resistance (after 220°C, 180 min, atm) | **A** | **A** | **A** | **A** | **A** | **A** | **A** | **A** | **A** |
| 6. Heat-resistant transparency (after 220°C, 180 min, atm, λ=400 nm, %) | **96%** | **95%** | **94%** | **93%** | **92%** | **81%** | **79%** | **93%** | **95%** |
| EX.: Example, L.T.: light transmittance, atm: in an atmosphere | | | | | | | | | |

[Table 7]

| | EX. 19 | EX. 20 | EX. 21 | EX. 22 | EX. 23 | EX. 24 | EX. 25 | EX. 1 | EX. 2 |
|---|---|---|---|---|---|---|---|---|---|
| 1. Alkali developability | **A** | **A** | **A** | **A** | **A** | **A** | **A** | **A** | **A** |

(continued)

| | EX. 19 | EX. 20 | EX. 21 | EX. 22 | EX. 23 | EX. 24 | EX. 25 | EX. 1 | EX. 2 |
|---|---|---|---|---|---|---|---|---|---|
| 2. Pattern formability | **A** | **B** | **A** | **A** | **A** | **A** | **A** | **A** | **A** |
| 3. Residual film ratio (%) | **91%** | **90%** | **93%** | **94%** | **93%** | **94%** | **94%** | **81%** | **81%** |
| 4. L.T. (λ=400 nm, %) | **97%** | **95%** | **97%** | **98%** | **96%** | **95%** | **95%** | **98%** | **93%** |
| 5. Thermal crack resistance (after 220°C, 180 min, atm) | **A** | **B** | **A** | **A** | **A** | **A** | **A** | **B** | **C** |
| 6. Heat-resistant transparency (after 220°C, 180 min, atm, λ=400 nm, %) | **92%** | **85%** | **95%** | **94%** | **93%** | **89%** | **91%** | **96%** | **69%** |
| EX.: Example, C.EX.: Comparative Example, L.T.: light transmittance, atm: in an atmosphere | | | | | | | | | |

[Examples 26 to 28]

(Preparation of Photosensitive Alkali-Soluble Silicone

Resin Composition)

Various components were prepared and mixed as shown in Table 8. The mixture was filtered under pressure through a PP-made filter having a pore size of 2.5 microns to obtain a liquid composition.

[Table 8]

| | | A.V. (mgKOH/g) | EX. 26 | EX. 27 | EX. 28 |
|---|---|---|---|---|---|
| (A) Silicone resin | **P-1**<br>**P-9** | **32**<br>**52** | **70** | **70** | <br>**70** |
| (B) Alkali-soluble resin (in term of solid content) | **0-6**<br>**0-12** | **85**<br>**60** | <br>**10** | **10** | <br>**10** |
| (C) Initiator | **Irg819** | | **0.55** | **0.55** | **0.55** |
| (D) Photopolymerizable unsaturated double bond-containing compound | **EA-1020**<br>**A-14G** | | <br>**20** | **20** | <br>**20** |
| (E) Solvent | **PGMEA** | | **60** | **60** | **60** |
| Additive | **TIN405**<br>**TiN152**<br>**ACM0** | | **2.25**<br>**0.25**<br>**5** | **2.25**<br>**0.25**<br>**5** | **2.25**<br>**0.25**<br>**5** |
| A.V. (A)/A.V. (B) | | | **0.54** | **0.38** | **0.87** |
| EX.: Example, A.V.: acid value | | | | | |

Description of Abbreviation in Table 8:

Irg819: IRGACURE 819
EA1020: epoxy acrylate "NK OLIGO EA-1020" (produced by Shin-Nakamura Chemical Co., Ltd.)
A-14G: polyethylene glycol (EO) diacrylate (number of EO chains repeated: 14, produced by Shin-Nakamura Chemical Co., Ltd.)
PGMEA: propylene glycol monomethyl ether acetate
TIN405: TINUVIN 405
TIN152: 2,4-bis[N-butyl-N-(1-cyclohexyloxy-2,2,6,6-tetramethylpiperidin-4-yl)amino]-6-(2-hydroxyethylamine)-1,3,5-triazine (TINUVIN 152, produced by BASF)
ACMO: 3-acryloxypropyltrimethoxysilane (produced by Shin-Etsu Chemical Co., Ltd.)

[Evaluation of Composition]

The compositions of Examples 26 to 28 and Comparative Example 1 were subjected to the following evaluations. Figs. 1 to 4 show liquid $^{29}$Si-NMR of respective compositions, and Figs. 5 to 8 show FT-IR spectrum.

Liquid $^{29}$Si-NMR Spectrum Measurement:

The measurement was carried out under the following conditions by using JNM-GSX400 manufactured by JEOL Ltd.

OBNUC: 29 Si
EXMOD: BCMA
OBFEQ: 79.30 MHz
OBSET: 115 kHz
OBFIN: 10583 Hz
POINT: 32768
FREQU: 32051.2 Hz
SCAN: 20,000 times
ACQTM: 0.499 sec
PD: 1.2 sec
PW1: 5.6 us
TEMP: room temperature (23°C)
Chemical shift standard: tetramethylsilane, 0 ppm

The specimen was prepared by thoroughly mixing 0.75 g of sample, 1 g of deuterated chloroform containing 1 v/v% of tetramethylsilane, and 0.02 g of chromium(III) tris(2,4-pentanedionate) and putting the mixture in a sample tube of 5 mmϕ to a height of about 4 cm.

For example, in the case of liquid $^{29}$Si-NMR of Example 26 shown in Fig. 1, the peak appearing in the vicinity of -28 to -30 ppm is derived from "D0", the peak appearing in the vicinity of -33 to -40 ppm is derived from "D1", the peak appearing in the vicinity of -40 to - 48 ppm is derived from "D2", the peak appearing in the vicinity of -48 to -53 ppm is derived from "T1", the peak appearing in the vicinity of -53 to -61 ppm is derived from "T2", and the peak appearing in the vicinity of -64 to -70 ppm is derived from the component "T3".

FT-IR Spectrum Measurement

The measurement was carried out under the following conditions by sandwiching the measurement sample between NaCl crystal plates and using FT-720 manufactured by HORIBA.

Number of integrations: 20
Resolution: 2 um
Region: from 400 to 4,000 $cm^{-1}$

(Preparation of Cured Product)

The obtained liquid composition was spin-coated on an Mo sputtered silicon substrate (thickness of Mo film: 180 nm), and the solvent was volatilized by prebake at 95°C. The Mo sputtered silicon substrate with a coating film was exposed at an exposure dose of 300 $mJ/cm^2$ through a reticle with a test pattern by using an i-line stepper exposure machine (model name: NSR2005i8A, manufactured by Nikon Corp.). The exposure was carried out in an atmosphere. Thereafter, development was carried out using an alkali developer (Developer produced by AZ Electronic Materials; an aqueous 2.38% tetramethylammonium hydroxide solution) under the conditions of 23°C and 30 secondsxtwo times, and rinsing with pure water was carried out to remove the unexposed area of the coating film. The obtained Mo sputtered silicon substrate with a pattern was baked at 220°C for 30 minute in air to prepare a substrate with a cured product.

[Evaluation of Cured Product]

The varnish-like compositions obtained in Examples 26 to 28 and Comparative Example 1 were evaluated for the following items, and the results are shown in Table 9. Also, Figs. 9 to 12 show solid $^{29}$Si-NMR spectrum of respective cured products of Examples 26 to 28 and Comparative Example 1, and Figs. 13 to 16 show Tan δ curve by DMA of

cured products of Examples 26 to 28 and Comparative Example 1.

Solid $^{29}$Si-NMR Spectrum Measurement:

The sample film-formed on the substrate was scraped off using a spatula and subjected to solid $^{29}$Si-NMR spectrum measurement. The measurement conditions were as follows.

Apparatus: DSX400 manufactured by Bruker BioSpin
Nuclear species: 29Si
Resonant frequency: 79.49 MHz
NMR Tube: 7 mmϕ
Measurement method: HD/MAS method
Number of data points: 8 K
Spectrum width: 35 kHz
Pulse width: 5.5 μsec (90° pulse)
Repetition time: 30 sec
Integration: 2,000 times
Measurement temperature: room temperature (25°C)
MAS: 5,000 Hz
Chemical shift standard: silicon rubber, -22.4 ppm
Amount of specimen: 200 mg

For example, in the case of solid $^{29}$Si-NMR of Example 26 shown in Fig. 9, the peak appearing in the vicinity of -30 to -38 ppm is derived from "D1", the peak appearing in the vicinity of -38 to -49 ppm is derived from "D2", the peak appearing in the vicinity of -49 to -52 ppm is derived from "T1", the peak appearing in the vicinity of -52 to -62 ppm is derived from "T2", and the peak appearing in the vicinity of -62 to -72 ppm is derived from the component "T3".

Glass Transition Temperature:

The glass transition temperature was measured by the following method on DMA using Vibron. The maximum peak of the Tan δ curve measured was defined as the glass transition temperature.

(Preparation of Sample)

A film was deposited on an Al sputtered Si substrate to have a thickness of 10 to 20 um after development, and the obtained substrate with a cured product was baked at 220°C for 30 minutes in air. After the baking, the substrate was half-cut by a dicing saw to a width of 3 mm, dipped in 10% hydrochloric acid for 24 hours, washed with distilled water three times and then, air-dried to produce a self-standing film with a width of 3 mm for Vibron measurement.

(DMA Measurement)

RHEOVIBRON (RHEO-1021, DDV-01FP) was used for DMA and measured at a rate of 5°C/min from -150°C to 400°C by previously cooling the measurement part with liquid nitrogen. As the measurement specimen, the self-standing film above having a width of 3 mm was cut into a length 3 cm and used. The test was carried out with an excitation frequency of 110 Hz of a single waveform, a vibration amplitude of 16 μm and a preload of 3.0 gf.

[Evaluation of Cured Product]

The obtained substrate with a cured product was charged into a cold-heat shock test (T/C) machine, and the presence or absence of crack or separation was confirmed. As for the test conditions, the test was carried out using TSE-11 manufactured by Espec Corp. and taking -40°C for 15 minutes and +125°C for 15 minutes as one cycle.

A: No separation and no crack in 50 cycles.
B: Separation or crack was generated in 6 to 50 cycles.
C: Separation or crack was generated in 5 cycles.

[Table 9]

| | Example | | | Comparative Example 1 |
|---|---|---|---|---|
| | 26 | 27 | 28 | |
| Three-dimensional crosslinking degree (T) in liquid $^{29}$Si-NMR of resin composition | 0.084 | 0.081 | 0.184 | 0.081 |
| Three-dimensional crosslinking degree (T') in liquid $^{29}$Si-NMR of resin composition | 0.182 | 0.174 | 0.363 | 0.177 |
| $I_y/I_x$ in FT-IR of resin composition | 0.166 | 0.129 | 0.459 | 0.139 |
| Three-dimensional crosslinking degree (T) in solid $^{29}$Si-NMR | 0.163 | 0.142 | 0.242 | 0.224 |
| Three-dimensional crosslinking degree (T') in solid $^{29}$Si-NMR | 0.341 | 0.313 | 0.499 | 0.517 |
| Glass transition temperature (°C) by DMA measurement | 91 | 94 | 94 | 75 |
| 1. Alkali developability | A | A | A | A |
| 2. Pattern formability | A | A | A | A |
| 3. Residual film ratio (%) | 90% | 92% | 91% | 81% |
| 4. Light transmittance ($\lambda$=400 nm, %) | 95% | 96% | 95% | 98% |
| 5. Thermal crack resistance (after 220°C, 180 min, atm) | A | A | A | B |
| 6. Heat-resistant transparency (after 220°C, 180 min, atm, $\lambda$=400 nm, %) | 92% | 93% | 92% | 96% |
| 7. TC Properties: -40°C, 15 min <->+125°C, 15 min | A | A | B | C |
| atm: in an atmosphere | | | | |

[Alkali-soluble Organic Resin]

Alkali-soluble organic resins (0-1 to O-15) shown in Table 10 were fabricated or prepared.

[Table 10]

| | Name of Alkali-Soluble Resin | Acid Value (mgKOH/g) |
|---|---|---|
| O-1 | A methyl ethyl ketone solution with a solid content of 50 mass% of a copolymer having a structure of methacrylic acid/methyl methacrylate/benzyl methacrylate/styrene (mass ratio: 15/15/60/10) and having a weight average molecular weight of 30,000. | 98 |
| O-4 | Cyclomer P 230 AA (carboxyl group-containing vinyl polymer, produced by DAICEL-CYTEC Company Ltd.) | 40 |
| O-5 | Ripoxy SPC-1000 (carboxyl group-containing vinyl polymer, produced by Showa Denko K.K.) | 51 |
| O-6 | EA-6340 (novolak-type phenol polymer, produced by Shin-Nakamura Chemical Co., Ltd.) | 85 |
| O-7 | Ripoxy PR-300 (novolak-type phenol polymer, produced by Showa Denko K.K.) | 80 |
| O-8 | KAYARAD PCR-1069 (carboxyl group-containing epoxy polymer, produced by Nippon Kayaku Co., Ltd.) | 69 |
| O-9 | EXP-1421 (novolak-type phenol polymer, produced by Nippon Kayaku Co., Ltd.) | 72 |
| O-10 | DAUA-167 (carboxyl group-containing urethane polymer, produced by Kyoeisha Chemical Co., Ltd.) | 27 |
| O-11 | Ripoxy SPN (carboxyl group-containing ester polymer, produced by Showa Denko K.K.) | 60 |

(continued)

| | Name of Alkali-Soluble Resin | Acid Value (mgKOH/g) |
|---|---|---|
| O-13 | RA-3728PG (carboxyl group-containing vinyl polymer, produced by Negami Chemical Industrial Co., Ltd.) | 28 |
| O-14 | RA-3962PG (carboxyl group-containing vinyl polymer, produced by Negami Chemical Industrial Co., Ltd.) | 33 |
| O-15 | RA-4103PG (carboxyl group-containing vinyl polymer, produced by Negami Chemical Industrial Co., Ltd.) | 33 |

(Preparation of Transparent Alkali-Soluble Silicon Resin Composition)

Various components were prepared and mixed as shown in Tables 11 to 13 below. The mixture was filtered under pressure through a polypropylene (PP)-made filter having a pore size of 2.5 microns, whereby liquid compositions for Examples 29 to 50 and Comparative Examples 3 to 5 were obtained.

[Table 11]

| | | A.V. (mgKOH/g) | EX. 29 | EX. 30 | EX. 31 | EX. 32 | EX. 33 | EX. 34 | EX. 35 | EX. 36 | EX. 37 | EX. 38 |
|---|---|---|---|---|---|---|---|---|---|---|---|---|
| Silicone resin | P-1 | 32 | 30.0 | | | 20.0 | 40.0 | 40.0 | 50.0 | 30.0 | 30.0 | 50.0 |
| | P-6 | 32 | | 30.0 | | | | | | | | |
| | P-3 | 32 | | | 30. 0 | | | | | | | |
| | P-8 | 171 | | | | 10.0 | | | | | | |
| | P-4 | 32 | | | | | 10.0 | | | | | |
| | P-7 | 0 | | | | | | 10.0 | | | | |
| Hindered amine-based stabilizer | TIN. 144 | | | 0.5 | 0.5 | 0.5 | 0.5 | 0.5 | | | | |
| | TIN. 152 | | 0.5 | | | | | | | | | |
| | TIN. 622 | | | | | | | | 0.5 | | | 0.5 |
| | SAB. 119 | | | | | | | | | 0.3 | | |
| | TIN. XT 855 FF | | | | | | | | | | 0.5 | |
| Initiator | Irg. 819 | | 0.6 | 0.6 | 0.6 | 0.6 | 0.6 | 0.6 | 0.6 | | | 1.0 |
| | Luc. TPO | | | | | | | | | 0.7 | 0.7 | |
| Compound having P.U.D.B. | EA1020 | | 40.0 | 30.0 | 30.0 | 30.0 | 40.0 | | 40.0 | 40.0 | 40.0 | 40.0 |
| | BPE500 | | | 10.0 | | | | 30.0 | | | | |
| | A600 | | | | 10.0 | | | | | | | |
| | M510 | | | | | 10.0 | | 10.0 | | | | |
| AL-soluble resin (in terms of solid content) | 0-1 | 98 | | | | | | | | | | 10.0 |
| | 0-4 | 40 | | | | | | | | | | |
| | 0-5 | 51 | | | | | | | | | | |
| | 0-13 | 28 | 30.0 | 30.0 | 30.0 | 30.0 | 10.0 | 30.0 | 10.0 | 30.0 | 30.0 | |
| | 0-14 | 33 | | | | | | | | | | |
| | 0-15 | 33 | | | | | | | | | | |
| | 0-6 | 85 | | | | | | | | | | |
| | 0-7 | 80 | | | | | | | | | | |
| | 0-8 | 69 | | | | | | | | | | |
| | 0-9 | 72 | | | | | | | | | | |
| | 0-10 | 27 | | | | | | | | | | |
| | 0-11 | 60 | | | | | | | | | | |

(continued)

| | | A.V. (mgKOH/g) | EX. 29 | EX. 30 | EX. 31 | EX. 32 | EX. 33 | EX. 34 | EX. 35 | EX. 36 | EX. 37 | EX. 38 |
|---|---|---|---|---|---|---|---|---|---|---|---|---|
| Solvent | PGMEA | | 33.0 | 33.0 | 33.0 | 33.0 | 51.0 | 33.0 | 51.0 | 33.0 | 33.0 | 50.0 |
| | PGME | | 27.0 | 27.0 | 27.0 | 27.0 | 9.0 | 27.0 | 9.0 | 27.0 | 27.0 | |
| | M.E.K. | | | | | | | | | | | 10.0 |
| | C.A. | | | | | | | | | | | |
| Additive | TIN. 405 | | 2.0 | 2.0 | 2. 0 | 2.0 | 2.0 | 2.0 | 2.0 | 2.0 | 2.0 | 2.0 |
| | MEMO | | | 5.0 | 5.0 | | | | | 5.0 | 5.0 | 5.0 |
| | AcMO | | 5.0 | | | 5.0 | 5.0 | 5.0 | 5.0 | | | |
| Ph-based stabilizer | tBt | | | | | | | | | | | |
| | catechol | | | | | | | | | | | |
| | MEHQ | | | | | | | | | | | |
| A.V. (Q resin)/A.V. (AL-soluble resin) | | | 1.15 | 1.15 | 1.15 | 2.80 | 1.15 | 0.95 | 1.15 | 1.15 | 1.15 | 0.33 |

EX.: Example, A.V.: acid value, P.U.D.B.: photopolymerizable unsaturated double bond, M.E.K.: methyl ethyl ketone, C.A.: carbitol acetate, Ph-based: phenol-based, tBt: tert-butyl, Q resin: silicone resin, AL-soluble: alkali-soluble

[Table 12]

| | | A.V. (mgKOH/g) | EX. 39 | EX. 40 | EX. 41 | EX. 42 | EX. 43 | Ex. 44 | EX. 45 | EX. 46 | EX. 47 | EX. 48 |
|---|---|---|---|---|---|---|---|---|---|---|---|---|
| Silicone resin | P-1 | 32 | 30.0 | 70.0 | 70.0 | 30. 0 | 30.0 | 70.0 | 70.0 | 50.0 | 50.0 | 50.0 |
| | P-6 | 32 | | | | | | | | | | |
| | P-3 | 32 | | | | | | | | | | |
| | P-8 | 171 | | | | | | | | | | |
| | P-4 | 32 | | | | | | | | | | |
| | P-7 | 0 | | | | | | | | | | |
| Hindered amine-based stabilizer | TIN. 144 | | | | | | | | | | | |
| | TIN. 152 | | 0.5 | 0.5 | 0.5 | | | 0.3 | 0.3 | | | |
| | TIN. 622 | | | | | 0.5 | 0.5 | | | | | |
| | SAB. 119 | | | | | | | | | | | |
| | TIN. XT 855 FF | | | | | | | | | 0.5 | 0.5 | 0.5 |
| Initiator | Irg. 819 | | 0.6 | 0.6 | 0.6 | 0.6 | 0.6 | 0.6 | 0.6 | 0.6 | 0.6 | 0.6 |
| | Luc. TP0 | | | | | | | | | | | |
| Compound having P.U.D.B. | EA1020 | | 40.0 | | | 40.0 | 40.0 | | | 30.0 | 30.0 | 30.0 |
| | BPE500 | | | | | | | | | | | |
| | A600 | | | 20.0 | 20.0 | | | 20.0 | 20.0 | | | |
| | M510 | | | | | | | | | 10.0 | 10.0 | 10.0 |
| AL-soluble resin (in terms of solid content) | 0-1 | 98 | | | | | | | | | | |
| | 0-4 | 40 | 30.0 | | | | | | | | | |
| | 0-5 | 51 | | 10.0 | | | | | | | | |
| | 0-13 | 28 | | | | | | | | | | |
| | 0-14 | 33 | | | | 30.0 | | | | | | |
| | 0-15 | 33 | | | | | 30.0 | | | | | |
| | 0-6 | 85 | | | 10.0 | | | | | | | |
| | 0-7 | 80 | | | | | | 10.0 | | | | |
| | 0-8 | 69 | | | | | | | | 10.0 | | |
| | 0-9 | 72 | | | | | | | | | 10.0 | |
| | 0-10 | 27 | | | | | | | | | | 10.0 |
| | 0-11 | 60 | | | | | | | 10.0 | | | |

(continued)

| | | A.V. (mgKOH/g) | EX. 39 | EX. 40 | EX. 41 | EX. 42 | EX. 43 | Ex. 44 | EX. 45 | EX. 46 | EX. 47 | EX. 48 |
|---|---|---|---|---|---|---|---|---|---|---|---|---|
| Solvent | PGMEA | | 60.0 | 60.0 | 60.0 | 60.0 | 60.0 | 60.0 | 60.0 | 60.0 | 60.0 | 50.0 |
| | PGME | | | | | | | | | | | |
| | M.E.K. | | | | | | | | | | | |
| | C.A. | | | | | | | | | | | 10.0 |
| Additive | TIN. 405 | | 2.0 | 2.0 | 2.0 | 2.0 | 2.0 | 2.0 | 2.0 | 2.0 | 2.0 | 2.0 |
| | MEMO | | 5.0 | | | | | | | | | |
| | AcM0 | | | 5.0 | 5.0 | 5.0 | 5.0 | 5.0 | 5.0 | 5.0 | 5.0 | 5.0 |
| Ph-based stabilizer | tBt | | | | | | | | | | | |
| | catechol | | | | | | | | | | | |
| | MEHQ | | | | | | | | | | | |
| A.V. (Q resin) /A.V. (AL-soluble resin) | | | 0.80 | 0.63 | 0.38 | 0.97 | 0.97 | 0.40 | 0.54 | 0.47 | 0. 45 | 1.19 |

EX.: Example, A.V.: acid value, P.U.D.B.: photopolymerizable unsaturated double bond, M.E.K.: methyl ethyl ketone, C.A.: carbitol acetate, Ph-based: phenol-based, tBt: tert-butyl, Q resin: silicone resin, AL-soluble: alkali-soluble

[Table 13]

| | | A.V. (mgKOH/g) | EX. 49 | EX. 50 | C.EX. 3 | C.EX. 4 | C.EX. 5 |
|---|---|---|---|---|---|---|---|
| Silicone resin | P-1 | 32 | 80.0 | 30.0 | | 70.0 | 70.0 |
| | P-6 | 32 | | | | | |
| | P-3 | 32 | | | | | |
| | P-8 | 171 | | | | | |
| | P-4 | 32 | | | | | |
| | P-7 | 0 | | | 50.0 | | |
| Hindered amine-based stabilizer | TIN. 144 | | | | | | |
| | TIN. 152 | | 0.3 | | 0.3 | | |
| | TIN. 622 | | | | | | |
| | SAB. 119 | | | | | | |
| | TIN. XT 855 FF | | | | | | |
| Initiator | rg. 819 | | 2.0 | 0.6 | 0.6 | 0.6 | 0.6 |
| | Luc. TP0 | | | | | | |
| Compound having P.U.D.B. | EA1020 | | | 40.0 | 24.0 | 14.0 | 14.0 |
| | BPE500 | | | | 24.0 | | |
| | A600 | | | | | | |
| | M510 | | | | | 14.0 | 14.0 |
| AL-soluble resin (in terms of solid content) | 0-1 | 98 | | | | | |
| | 0-4 | 40 | 20.0 | | | | |
| | 0-5 | 51 | | | | | |
| | 0-13 | 28 | | 30.0 | | | |
| | 0-14 | 33 | | | | | |
| | 0-15 | 33 | | | | | |
| | 0-6 | 85 | | | | | |
| | 0-7 | 80 | | | | | |
| | 0-8 | 69 | | | | | |
| | 0-9 | 72 | | | | | |
| | 0-10 | 27 | | | | | |
| | 0-11 | 60 | | | | | |
| Solvent | PGMEA | | 60.0 | 33.0 | 60.0 | 60.0 | 60.0 |
| | PGME | | | 27.0 | | | |
| | M.E.K. | | | | | | |
| | C.A. | | | | | | |
| Additive | TIN. 405 | | 2.0 | 2.0 | 2.0 | 2.0 | 2.0 |
| | MEMO | | | 5.0 | 5.0 | 5.0 | 5.0 |
| | AcM0 | | 5. 0 | | | | |
| Ph-based stabilizer | tBt catechol | | | | | 0.3 | |
| | MEHQ | | | | | | 0.3 |
| A.V. (Q resin)/A.V. (AL-soluble resin) | | | 0.80 | 1.15 | - | - | - |

EX.: Example, C.EX.: Comparative Example, A.V.: acid value, P.U.D.B.: photopolymerizable unsaturated double bond, M.E.K.: methyl, ethyl ketone, C.A.: carbitol acetate, Ph-based: phenol-based, tBt: tert-butyl, Q resin: silicone resin, AL-soluble: alkali-soluble

Description of Abbreviations in Tables 11 to 13

TIN.144: TINUVIN 144 (produced by BASF)
TIN.152: TINUVIN 152 (produced by BASF)
TIN.622: TINUVIN 622 (produced by BASF)
SAB.119: SABOSTAB UV119 (produced by SABO)
TIN.XT 855 FF: TINUVIN XT 855 FF (produced by BASF)
Irg.819: IRGACURE 819 (produced by BASF)
Luc.TPO: Lucirin TPO
EA1020: epoxy acrylate "NK OLIGO EA1020" (produced by Shin-Nakamura Chemical Co., Ltd.)
BPE500: ethoxylated bisphenol A dimethacrylate "BPE500" (produced by Shin-Nakamura Chemical Co., Ltd.)
A600: polyethylene glycol #600 diacrylate "A600" (produced by Shin-Nakamura Chemical Co., Ltd.)
M510: polybasic acid-modified acryl oligomer "ARONIX M-510" (produced by Toagosei Co., Ltd.)
PGMEA: propylene glycol monomethyl ether acetate
PGME: propylene glycol monomethyl ether
TIN.405: TINUVIN 405 (produced by BASF)
MEMO: 3-methacryloxypropyltrimethoxysilane (produced by Shin-Etsu Silicone Co., Ltd.)
AcMO: 3-acryloxypropyltrimethoxysilane (produced by Shin-Etsu Silicone Co., Ltd.)
t-butyl catechol: tertiary butyl catechol
MEHQ: methylhydroquinone

[Evaluation of Composition]

The varnish-like compositions obtained in Examples 29 to 50 and Comparative Examples 3 to 5 were evaluated for the following items, and the results are shown in Tables 14 to 16.

1. Alkali Developability

The obtained liquid composition was spin-coated on a glass substrate previously washed with an aqueous alkali solution, and the solvent was volatilized by prebake at 95°C. The obtained glass substrate with a coating film was exposed at an exposure dose of 400 $mJ/cm^2$ through a reticle with a test pattern by using an i-line stepper exposure machine (model name: NSR2005i8A, manufactured by Nikon Corp.). The exposure was carried out in an atmosphere. Thereafter, development was carried out using an alkali developer (Developer produced by AZ Electronic Materials; an aqueous 2.38% tetramethylammonium hydroxide solution) under the conditions of 23°C and 30 secondsxtwo times, and rinsing with pure water was carried out to remove the unexposed area of the coating film, whereby a pattern having a film thickness of 10 μm was obtained. The obtained pattern was observed by an optical microscope and evaluated according to the following criteria.

A: 10 Samples of pattern were prepared and in all of 10 samples, undeveloped portion was not observed in between the pattern.
B: 10 Samples of pattern were prepared and in 8 or 9 samples, undeveloped portion was not observed in between the pattern, but in 1 or 2 samples, undeveloped portion was slightly observed in between pattern.
C: 10 Samples of pattern were prepared and in 1 or 2 samples, undeveloped portion was not observed in between the pattern, but in 8 or 9 samples, undeveloped portion was slightly observed in between pattern.
D: 10 Samples of pattern were prepared and in all of 10 samples, undeveloped portion was observed in between the pattern.

2. Pattern formability

The cross-section of the pattern obtained above was observed by scanning electron microscope (SEM) and evaluated according to the following criteria.

A: 10 Samples of pattern were prepared and in all of 10 samples, the pattern was formed in a perpendicular or forward tapered shape.
B: 10 Samples of pattern were prepared and in 8 or 9 samples, the pattern was formed in a perpendicular or forward tapered shape, but in 1 or 2 samples, the pattern was partially distorted or reverse tapered.
C: 10 Samples of pattern were prepared and in 1 or 2 samples, the pattern was formed in a perpendicular or forward tapered shape, but in 8 or 9 samples, the pattern was partially distorted or reverse tapered.

D: 10 Samples of pattern were prepared and in all of 10 samples, the pattern was distorted or reverse tapered.

3. Light Transmittance

The coating film with a thickness of 10 μm obtained after alkali development was baked at 220°C for 30 minutes in an atmosphere, and the transmittance of light in 800 to 300 nm was measured using a spectrophotometer UV-1600PC (manufactured by Shimadzu Corporation) by placing a glass substrate with no coating film in the reference part, whereby the transmittance of light with 400 nm was confirmed.

4. Thermal Crack Resistance

The coating film obtained after alkali development was baked at 220°C for 360 minutes in an atmosphere, and whether a crack was formed or not in the coating film was confirmed with an eye.

A: 10 Samples of coating film were prepared and in all of 10 samples, a crack was not formed in the coating film.
B: 10 Samples of coating film were prepared and in 8 or 9 samples, a crack was not formed in the coating film, but in 1 or 2 samples, a crack was very slightly formed in the coating film.
C: 10 Samples of coating film were prepared and in 1 or 2 samples, a crack was not formed in the coating film but in 8 or 9 samples, a crack was slightly formed in the coating film.
D: 10 Samples of coating film were prepared and in all of 10 samples, a crack was formed in the coating film.

5. Heat-Resistant Transparency of Film After Alkali Development

The coating film having a thickness of 10 μm obtained after alkali development was baked at 220°C for 360 minutes in an atmosphere, and the transmittance of light with 400 nm was measured using a spectrophotometer UV-1600PC (manufactured by Shimadzu Corporation) by placing a glass substrate with no coating film in the reference part.

[Table 14]

| | Example | | | | | | | | | |
|---|---|---|---|---|---|---|---|---|---|---|
| | 29 | 30 | 31 | 32 | 33 | 34 | 35 | 36 | 37 | 38 |
| 1. Alkali developability | A | A | A | A | A | B | A | A | A | A |
| 2. Pattern formability | A | A | A | B | B | B | A | B | B | B |
| 3. Light transmittance (λ=400 nm, %) | 96% | 95% | 95% | 94% | 97% | 96% | 97% | 94% | 95% | 97% |
| 4. Thermal crack resistance (after 220°C, 360 min, atm) | A | A | A | A | A | A | A | A | A | A |
| 5. Heat-resistant transparency after alkali development (after 220°C, 360 min, atm, λ=400 nm, %) | 91% | 90% | 87% | 88% | 93% | 91% | 92% | 89% | 90% | 92% |
| atm: in an atmosphere | | | | | | | | | | |

[Table 15]

| | Example | | | | | | | | | |
|---|---|---|---|---|---|---|---|---|---|---|
| | 39 | 40 | 41 | 42 | 43 | 44 | 45 | 46 | 47 | 48 |
| 1. Alkali developability | A | A | A | A | A | A | A | A | A | B |
| 2. Pattern formability | A | A | A | A | A | A | A | A | B | B |
| 3. Light transmittance (λ=400 nm, %) | 95% | 97% | 96% | 95% | 95% | 97% | 96% | 95% | 96% | 97% |

(continued)

| | Example | | | | | | | | | |
|---|---|---|---|---|---|---|---|---|---|---|
| | 39 | 40 | 41 | 42 | 43 | 44 | 45 | 46 | 47 | 48 |
| 4. Thermal crack resistance (after 220°C, 360 min, atm) | A | A | A | A | A | A | A | A | A | A |
| 5. Heat-resistant transparency after alkali development (after 220°C, 360 min, atm, $\lambda$=400 nm, %) | 91% | 91% | 88% | 91% | 91% | 92% | 92% | 89% | 90% | 92% |
| atm: in an atmosphere | | | | | | | | | | |

[Table 16]

| | Example | | Comparative Example | | |
|---|---|---|---|---|---|
| | 49 | 50 | 3 | 4 | 5 |
| 1. Alkali developability | A | A | D | A | A |
| 2. Pattern formability | C | A | D | A | A |
| 3. Light transmittance ($\lambda$=400 nm, %) | 98% | 92% | 96% | 93% | 93% |
| 4. Thermal crack resistance (after 220°C, 360 min, atm) | B | A | C | C | C |
| 5. Heat-resistant transparency after alkali development (after 220°C, 360 min, atm, $\lambda$=400 nm, %) | 94% | 78% | 91% | 85% | 82% |
| atm: in an atmosphere | | | | | |

INDUSTRIAL APPLICABILITY

The photosensitive alkali-soluble silicone resin composition of the present invention can be suitably utilized as a resin composition used for an insulating material in a display device, such as touch panel, for formation of a surface protective film, an interlayer insulating film, an $\alpha$-ray shielding film, etc., in a semiconductor device, and for an image sensor, a semiconductor device having mounted therein a micromachine or a microactuator, etc., or for formation thereof.

## Claims

**1.** A photosensitive alkali-soluble silicone resin composition comprising:

(A) an alkali-soluble silicone resin having a carboxyl group or a dicarboxylic acid anhydride group in one molecule;
(B) an alkali-soluble resin (B) having an acid value of 10 to 200 mgKOH/g; and
(C) a photopolymerization initiator,

wherein said component (A) or (B) has a photopolymerizable unsaturated double bond group or said photosensitive alkali-soluble resin composition further contains (D) a photopolymerizable unsaturated double bond-containing compound.

**2.** The photosensitive alkali-soluble silicone resin composition according to claim 1, wherein said alkali-soluble silicone resin (A) further contains a photopolymerizable unsaturated double bond group in one molecule.

**3.** The photosensitive alkali-soluble silicone resin composition according to claim 1 or 2, wherein said alkali-soluble silicone resin (A) is obtained by a reaction of:

(A-1) a silane compound represented by following formula (I):

$$R^1R^2_aSi(R^3)_{3-a} \quad (I)$$

{wherein $R^1$ is a monovalent organic group containing a carboxyl group or a dicarboxylic acid anhydride group and having a carbon number of 4 to 20, $R^2$ is a methyl group, $R^3$ is at least one monovalent organic group selected from the group consisting of a methoxy group, an ethoxy group, a propoxy group and an isopropoxy group, a hydroxyl group or chloro group(Cl), and a is an integer of 0 or 1} and
(A-2) a silane compound represented by following formula (II):

$$R^4_bR^5_cSi(R^3)_{4-b-c} \quad (II)$$

{wherein each of $R^4$ and $R^5$ is a group containing a photopolymerizable unsaturated double bond group or a polymerizable cyclic ether bond group and having a carbon number of 2 to 20, an aryl group having a carbon number of 6 to 20, an alkylaryl group having a carbon number of 2 to 20, an alkyl group having a carbon number of 1 to 20, which may be substituted with a mercapto group or an amino group, a cycloalkyl group having a carbon number of 5 to 20, or a group containing a carboxyl group or a dicarboxylic acid anhydride group and having a carbon umber of 4 to 20, $R^4$ and $R^5$ may be the same or different and may be bonded to each other through a covalent bond, $R^3$ is at least one monovalent organic group selected from the group consisting of a methoxy group, an ethoxy group, a propoxy group and an isopropoxy group, a hydroxyl group or Cl, b is an integer selected from 0 to 2, c is an integer of 0 or 1, but b+c does not exceed 2}.

**4.** The photosensitive alkali-soluble silicone resin composition according to any one of claims 1 to 3, wherein said alkali-soluble silicone resin (A) is obtained by reacting:

said silane compound (A-1);
said silane compound (A-2); and

(A-3) a silanediol compound represented by following formula (III):

$$R^6_2Si(OH)_2 \quad (III)$$

{wherein $R^6$ is an aryl group having a carbon number of 6 to 20, an alkylaryl group having a carbon number of 2 to 20, an alkyl group having a carbon number of 1 to 20, which may be substituted with a mercapto group or an amino group, or a cycloalkyl group having a carbon number of 5 to 20, and a plurality of $R^6$ may be the same or different and may be bonded to each other through a covalent bond}, in the presence of a catalyst.

**5.** The photosensitive alkali-soluble silicone resin composition according to any one of claims 1 to 4, wherein said alkali-soluble silicone resin (A) further contains a polymerizable cyclic ether group in one molecule.

**6.** The photosensitive alkali-soluble silicone resin composition according to any one of claims 1 to 5, wherein said alkali-soluble resin (B) contains a photopolymerizable unsaturated double bond group in one molecule.

**7.** The photosensitive alkali-soluble silicone resin composition according to any one of claims 1 to 6, wherein said alkali-soluble resin (B) contains a photopolymerizable unsaturated double bond group and a carboxyl group or a dicarboxylic acid anhydride group in one molecule.

**8.** The photosensitive alkali-soluble silicone resin composition according to any one of claims 1 to 7, wherein said alkali-soluble resin (B) is at least one polymer selected from the group consisting of a vinyl polymer composed of a reaction product of a polymerizable unsaturated double bond, an epoxy polymer composed of an addition reaction product of an epoxy group and a hydroxyl group, an aromatic methylene polymer composed of a reaction product of phenol and formaldehyde, a urethane polymer composed of a reaction product of dialcohol and diisocyanate, and an ester polymer composed of a reaction product of dicarboxylic acid and diepoxide.

**9.** The photosensitive alkali-soluble silicone resin composition according to any one of claims 1 to 8, wherein the acid value (A)/acid value (B) ratio of the acid value (mgKOH/g) of said alkali-soluble silicone resin (A) to the acid value (mgKOH/g) of said alkali-soluble resin (B) is from 0.1 to 5.0.

**10.** The photosensitive alkali-soluble silicone resin composition according to any one of claims 1 to 9, wherein both said

alkali-soluble silicone resin (A) and said alkali-soluble resin (B) have a photopolymerizable unsaturated double bond group, and said photosensitive alkali-soluble silicone resin composition contains said photopolymerizable unsaturated double bond-containing compound (D).

**11.** The photosensitive alkali-soluble silicone resin composition according to any one of claims 1 to 10, wherein with respect to the FT-IR spectrum of said photosensitive alkali-soluble silicone resin composition, the ratio ($I_y/I_x$) between the intensity ($I_x$) in the region of 1,000 to 1,100 $cm^{-1}$ selected from the highest intensity when a maximum peak is not present, the intensity of one maximum peak when only one maximum peak is present, and the intensity of a highest maximum peak when a plurality of maximum peaks are present, and the intensity ($I_y$) in the region of 880 to 920 $cm^{-1}$ selected from the highest intensity when a maximum peak is not present, the intensity of one maximum peak when only one maximum peak is present, and the intensity of a highest maximum peak when a plurality of maximum peaks are present, is from 0.01 to 0.4.

**12.** The photosensitive alkali-soluble silicone resin composition according to any one of claims 1 to 11, wherein the three-dimensional crosslinking degree (T) as calculated from the integration ratio in the $^{29}$Si-NMR spectrum of said photosensitive alkali-soluble silicone resin composition according to following formula (IV) is 0.15 or less:

$$\text{Three-dimensional crosslinking degree (T)} = (A_{T3}+A_{Q3}+A_{Q4}*2)/\{(A_{M0}+A_{M1})+(A_{D0}+A_{D1}+A_{D2})+(A_{T0}+A_{T1}+A_{T2}+A_{T3})+(A_{Q0}+A_{Q1}+A_{Q2}+A_{Q3}+A_{Q4})\} \quad \text{(formula IV)}$$

**13.** The photosensitive alkali-soluble silicone resin composition according to any one of claims 1 to 11, wherein the three-dimensional crosslinking degree (T') as calculated from the integration ratio in the $^{29}$Si-NMR spectrum of said photosensitive alkali-soluble silicone resin composition according to following formula (V) is 0.3 or less:

$$\text{Three-dimensional crosslinking degree (T')} = (A_{T3})/(A_{T0}+A_{T1}+A_{T2}+A_{T3}) \quad \text{(formula V)}$$

**14.** The photosensitive alkali-soluble silicone resin composition according to any one of claims 1 to 13, which contains:

from 1 to 98 mass% of said alkali-soluble silicone resin (A);
from 1 to 50 mass% of said alkali-soluble resin (B); and
from 0.01 to 15 mass% of said

photopolymerization initiator (C),
based on the total solid content in said photosensitive alkali-soluble silicone resin composition.

**15.** The photosensitive alkali-soluble silicone resin composition according to any one of claims 1 to 14, which contains:

from 1 to 98 mass% of said alkali-soluble silicone resin (A);
from 1 to 50 mass% of said alkali-soluble resin (B);
from 0.01 to 15 mass% of said photopolymerization initiator (C); and
from 5 to 45 mass% of said photopolymerizable unsaturated double bond-containing compound (D),
based on the total solid content in said photosensitive alkali-soluble silicone resin composition.

**16.** The photosensitive alkali-soluble silicone resin composition according to any one of claims 1 to 15, which further contains (E) a solvent.

**17.** The photosensitive alkali-soluble silicone resin composition according to any one of claims 1 to 16, which further contains (F) a hindered amine-based stabilizer.

**18.** The photosensitive alkali-soluble silicone resin composition according to claim 17, wherein said hindered amine-based stabilizer (F) is contained in an amount of 0.001 to 15 mass% based on the mass of the total solid content in said photosensitive alkali-soluble silicone resin composition.

**19.** The photosensitive alkali-soluble silicone resin composition according to any one of claims 1 to 18, wherein in a cured product obtained by curing said photosensitive alkali-soluble silicone resin composition, the transmittance of light at a wavelength of 400 nm under the conditions after baking said cured product having a thickness of 10 μm at 220°C for 3 hours in an atmosphere is 70% or more.

**20.** A cured product obtained by curing the photosensitive alkali-soluble silicone resin composition according to any one of claims 1 to 19.

**21.** A transparent insulating film obtained by curing the photosensitive alkali-soluble silicone resin composition according to any one of claims 1 to 19.

**22.** A cured product obtained by curing a resin composition comprising (G) a polyorganosiloxane, (H) an alkali-soluble resin except for said polyorganosiloxane (G), and (C) a photopolymerization initiator, wherein the three-dimensional crosslinking degree (T) as calculated from the integration ratio in the solid $^{29}$Si-NMR spectrum of said cured product according to following formula (IV) is 0.2 or less:

$$\text{Three-dimensional crosslinking degree (T)} = (A_{T3}+A_{Q3}+A_{Q4}*2)/\{(A_{M0}+A_{M1})+(A_{D0}+A_{D1}+A_{D2})+(A_{T0}+A_{T1}+A_{T2}+A_{T3})+(A_{Q0}+A_{Q1}+A_{Q2}+A_{Q3}+A_{Q4})\} \quad \text{(formula IV)}$$

**23.** A cured product obtained by curing a resin composition comprising (G) a polyorganosiloxane, (H) an alkali-soluble resin except for said polyorganosiloxane (G), and (C) a photopolymerization initiator, wherein the three-dimensional crosslinking degree (T') as calculated from the integration ratio in the solid $^{29}$Si-NMR spectrum of said cured product according to following formula (V) is 0.45 or less:

$$\text{Three-dimensional crosslinking degree (T')} = (A_{T3})/(A_{T0}+A_{T1}+A_{T2}+A_{T3}) \quad \text{(formula V)}$$

**24.** The cured product according to claim 22 or 23, wherein said polyorganosiloxane (G) is obtained by condensing a silane compound having a carboxylic acid group or a carboxylic acid anhydride group.

**25.** The cured product according to any one of claims 22 to 24, wherein said polyorganosiloxane (G) contains a component in which the number of silicon (Si) atoms bonded to an oxygen (O) atom is two and/or a component in which the number of Si atoms bonded to an O atom is three.

**26.** The cured product according to any one of claims 22 to 25, wherein said resin composition further contains at least one member selected from the group consisting of (F) a hindered amine-based stabilizer, (I) a photocrosslinkable monomer, (J) a silane coupling agent and (K) an ultraviolet absorber.

**27.** The cured product according to any one of claims 22 to 26, wherein the glass transition temperature (Tg) of said cured product as measured by dynamic viscoelasticity measurement (DMA) is 80°C or more.

**28.** The cured product according to any one of claims 22 to 27, wherein said cured product has a thickness of 10 μm and the transmittance of light at a wavelength of 400 nm under the conditions after baking said cured product at 220°C for 3 hours in an atmosphere is 70% or more.

Fig.1

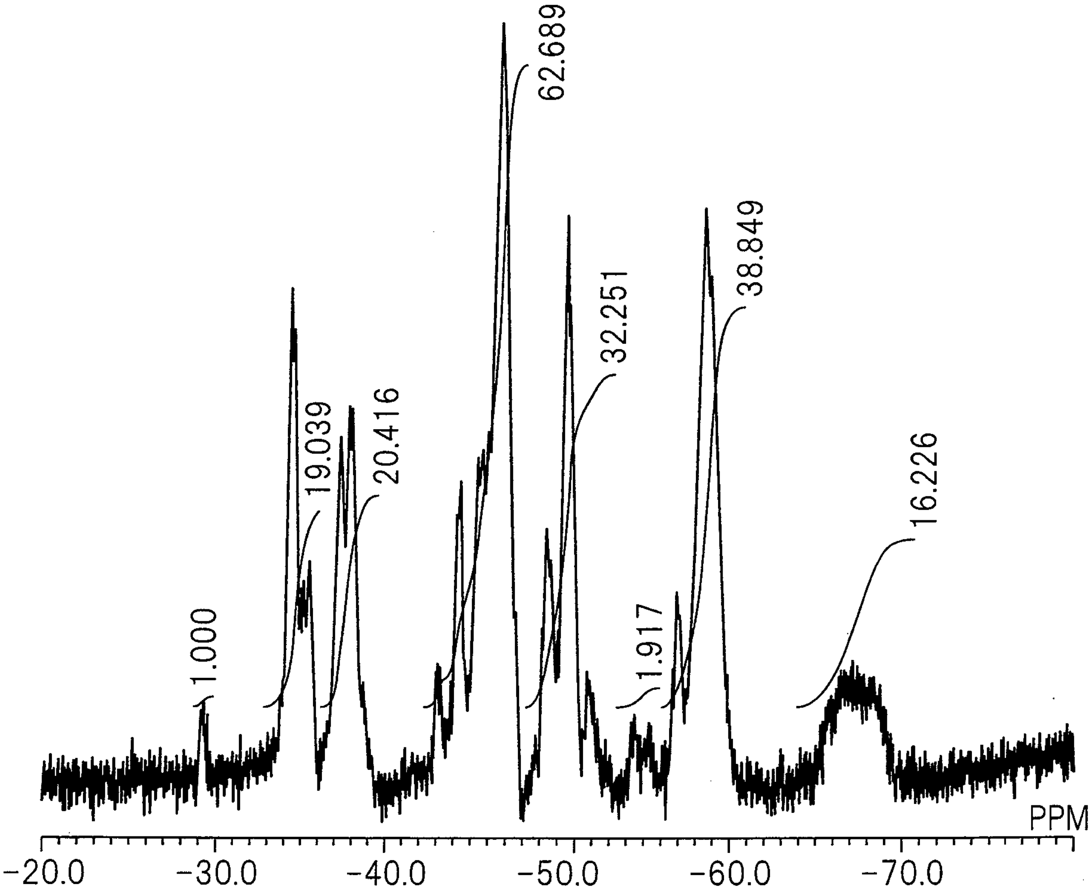
62.689
38.849
32.251
20.416
19.039
16.226
1.917
1.000
PPM
-20.0
-30.0
-40.0
-50.0
-60.0
-70.0

Fig.2

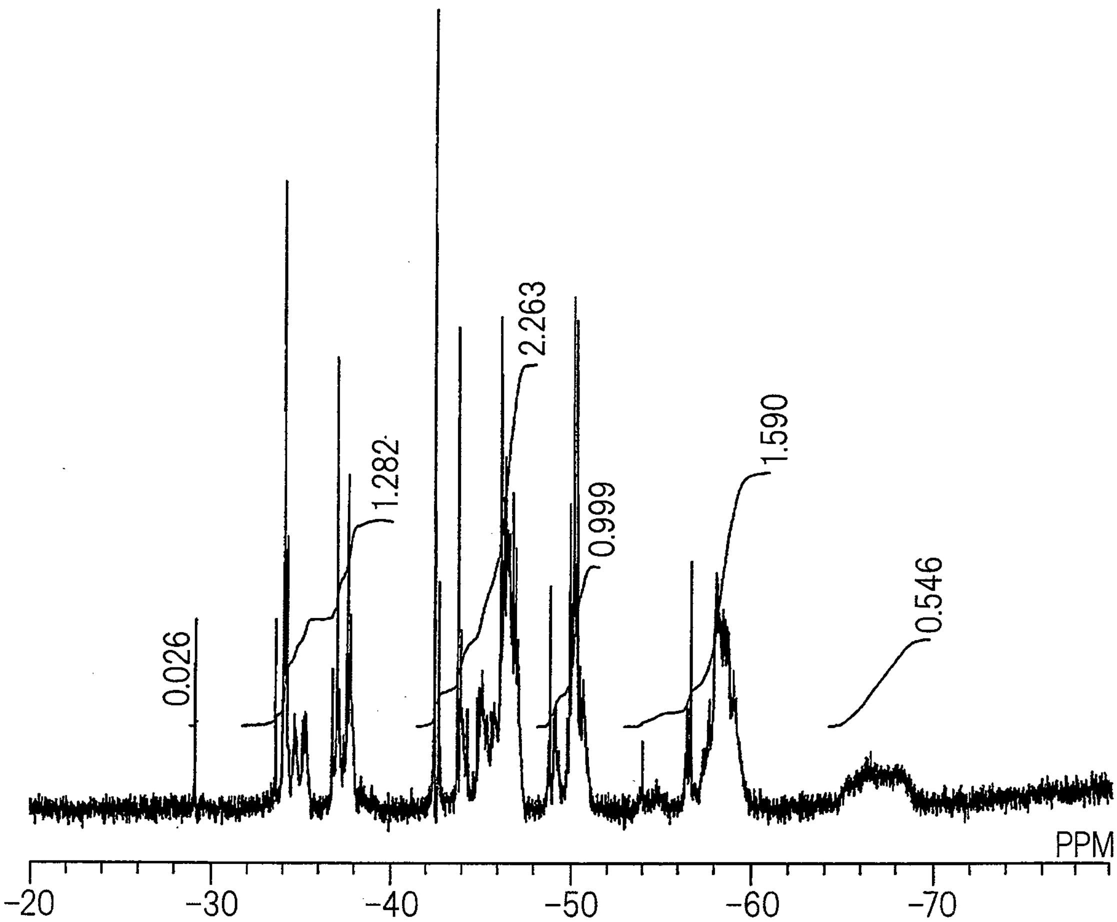

Fig.3

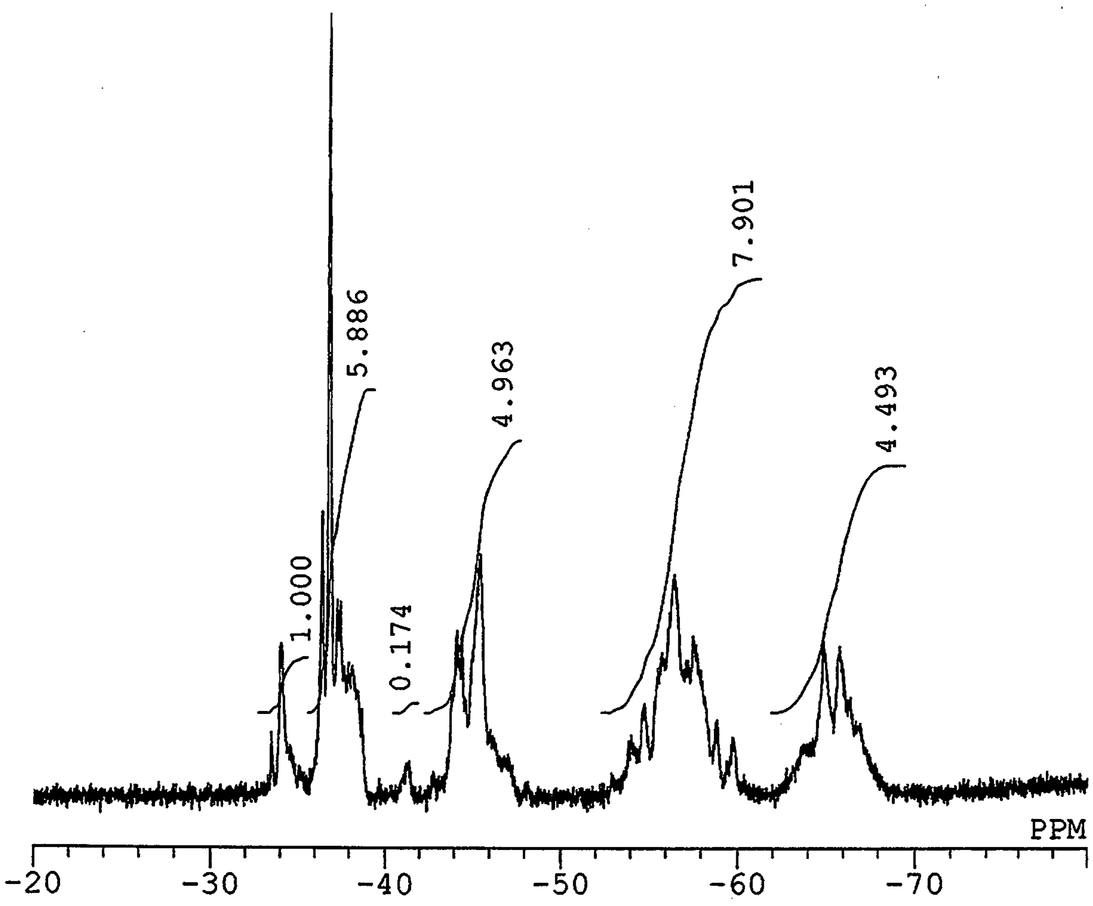

# Fig.4

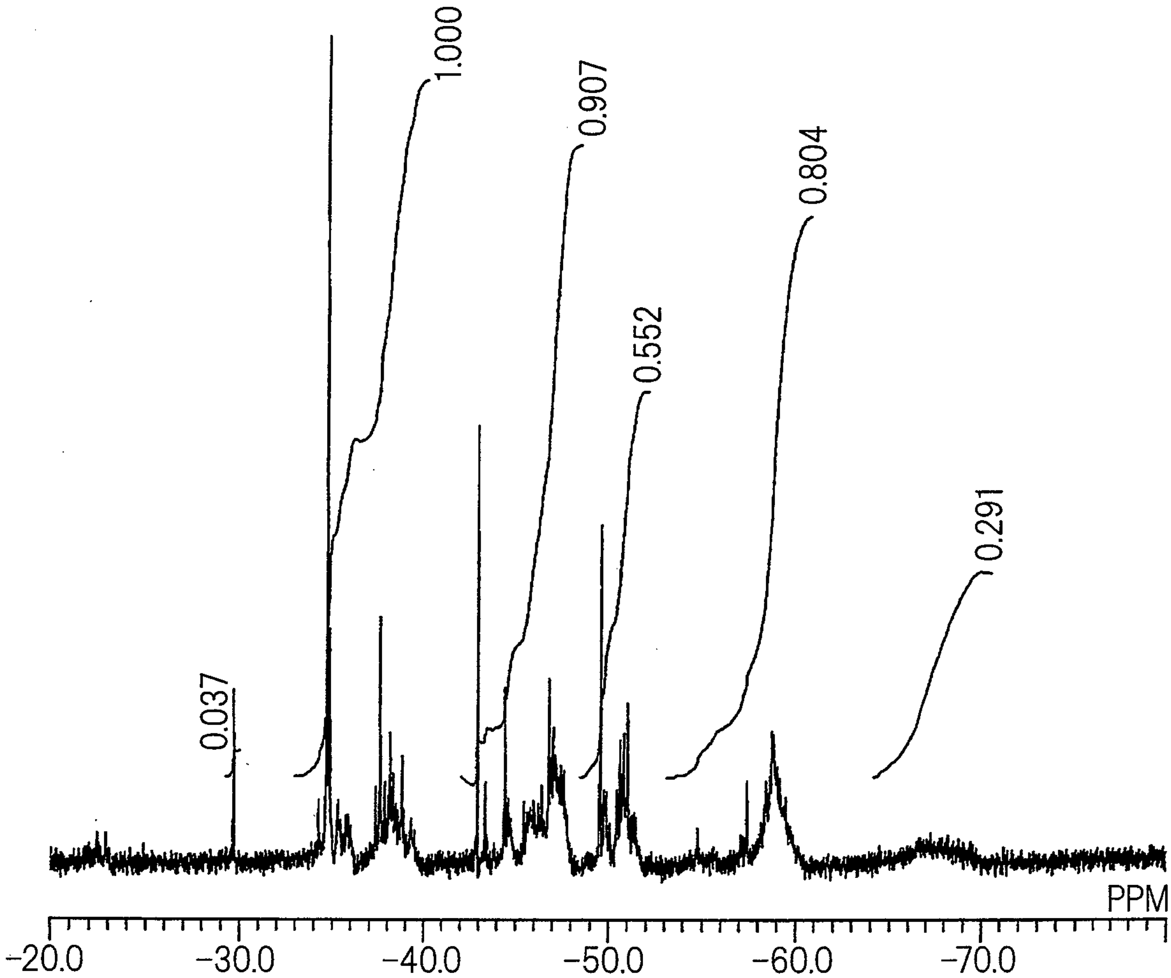

Fig.5

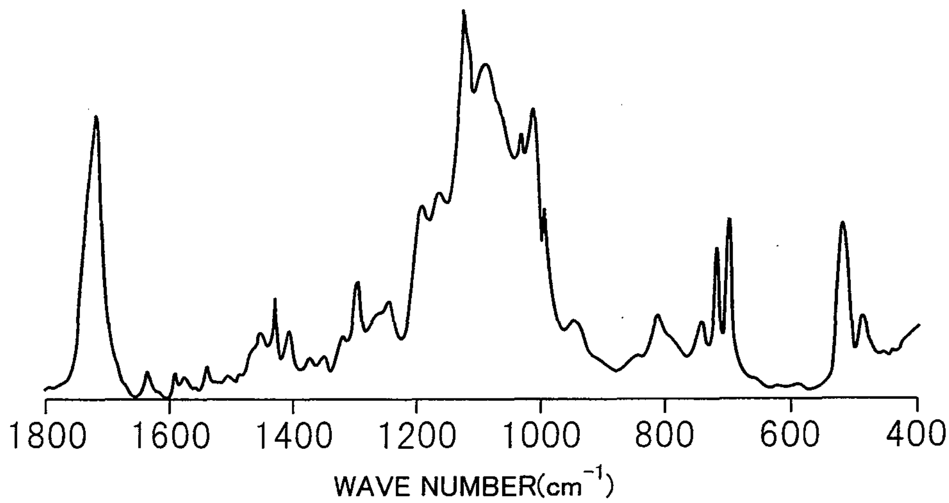
1800
1600
1400
1200
1000
800
600
400
WAVE NUMBER(cm⁻¹)

Fig.6

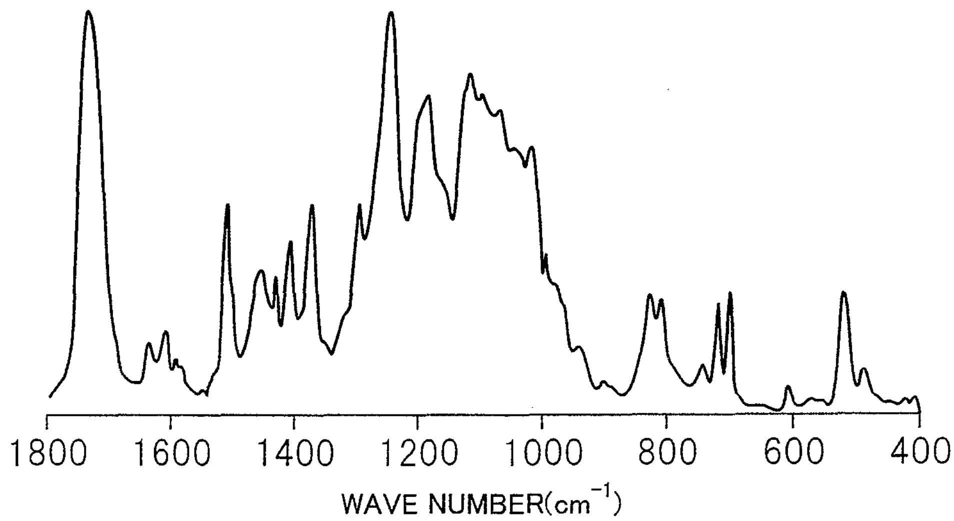
1800
1600
1400
1200
1000
800
600
400
WAVE NUMBER(cm⁻¹)

Fig.7

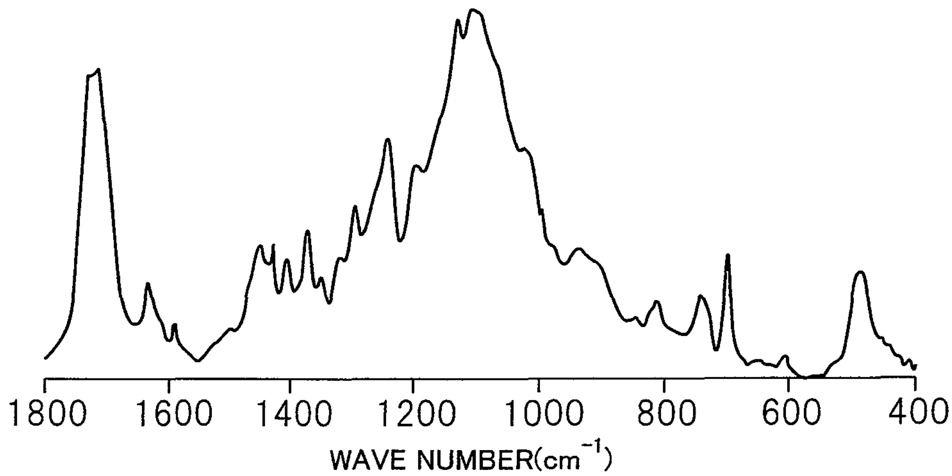
1800
1600
1400
1200
1000
800
600
400
WAVE NUMBER(cm⁻¹)

Fig.8

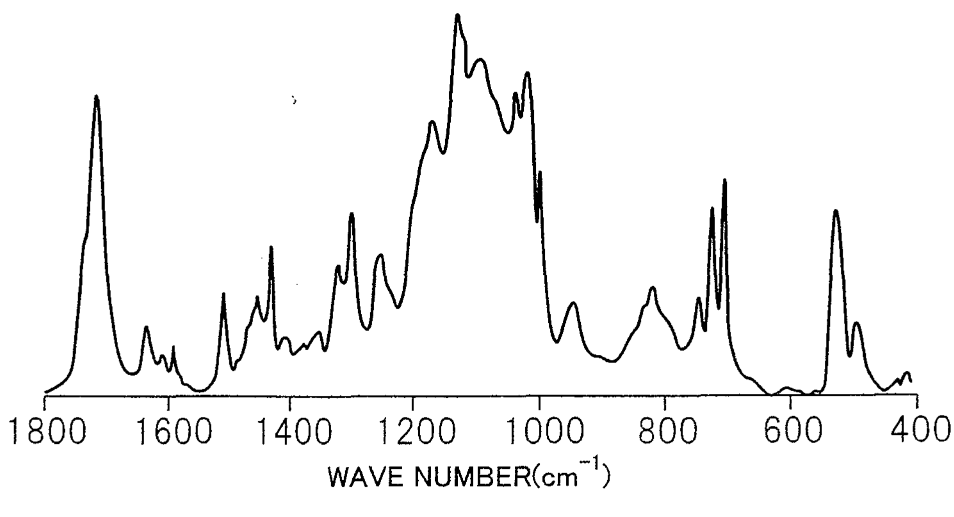
1800
1600
1400
1200
1000
800
600
400
WAVE NUMBER(cm⁻¹)

Fig.9

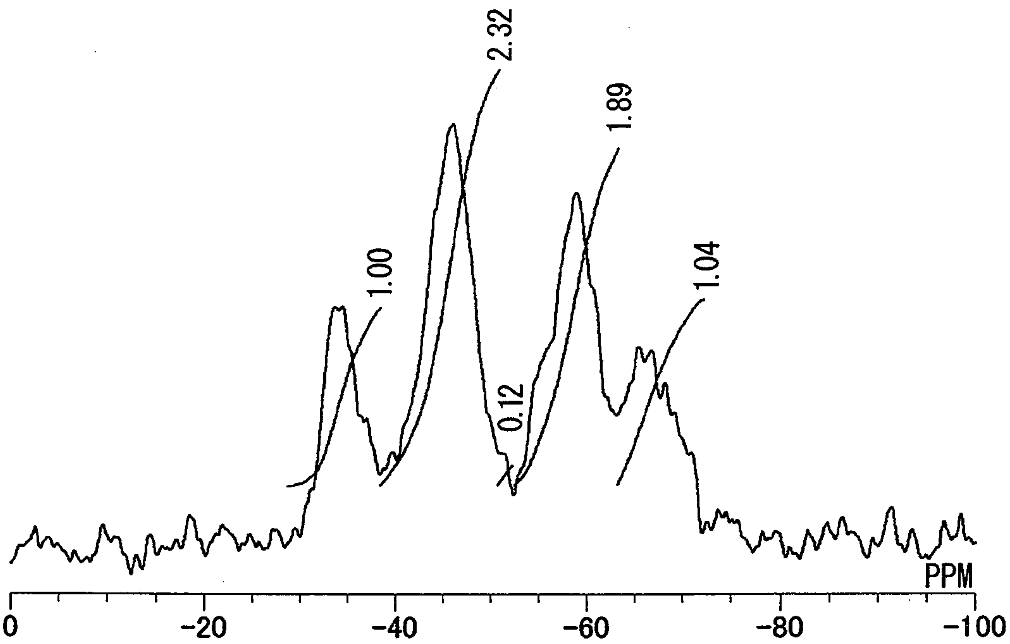
2.32
1.89
1.00
1.04
0.12
PPM
0
-20
-40
-60
-80
-100

Fig.10

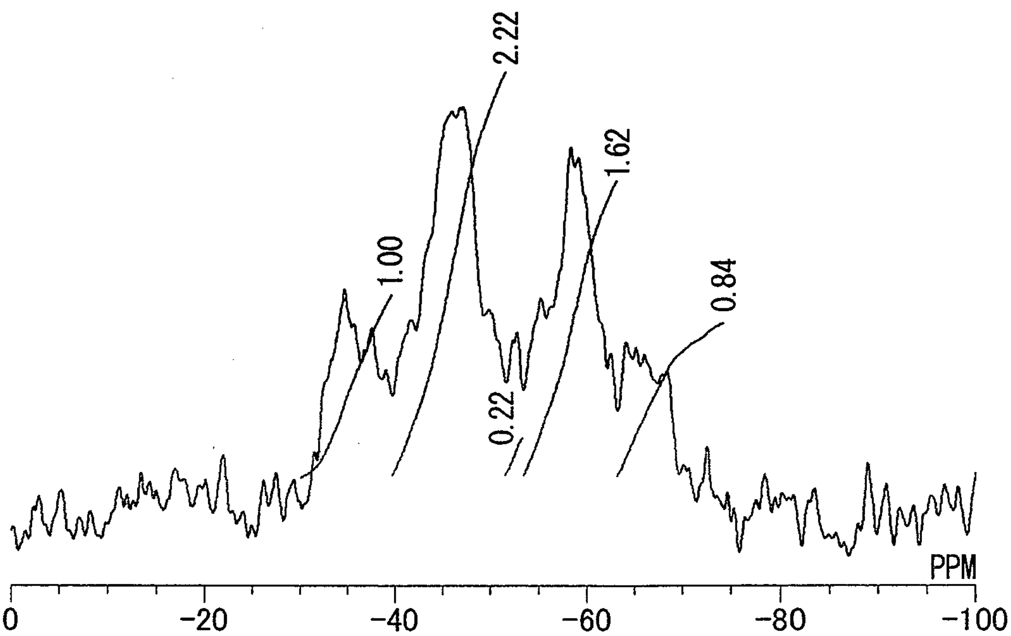
2.22
1.62
1.00
0.84
0.22
PPM
0
-20
-40
-60
-80
-100

Fig.11

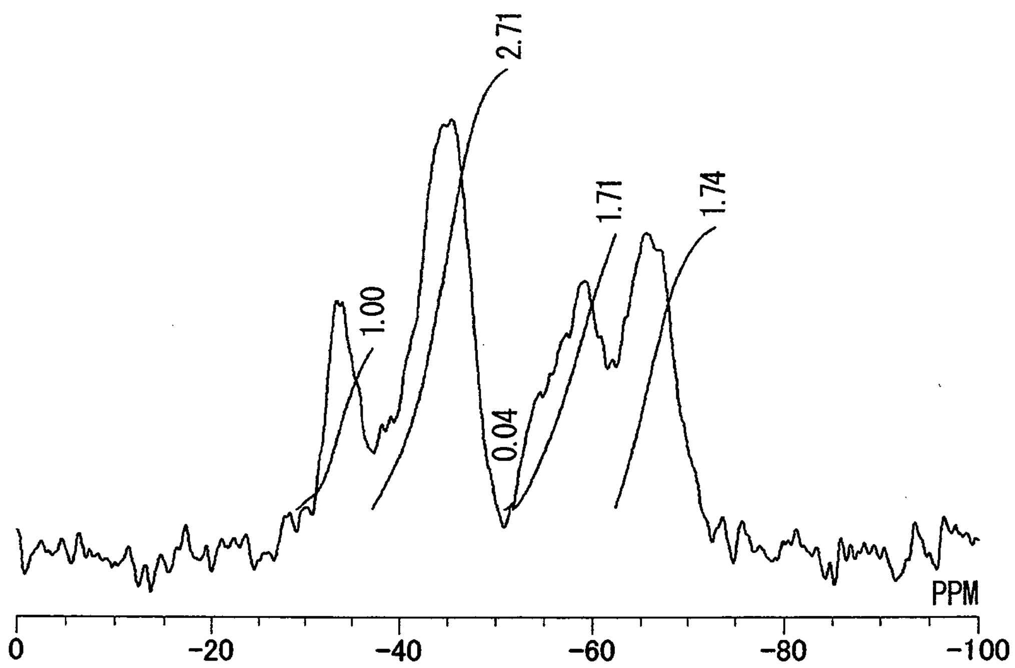
2.71
1.71
1.74
1.00
0.04
PPM
0
-20
-40
-60
-80
-100

Fig.12

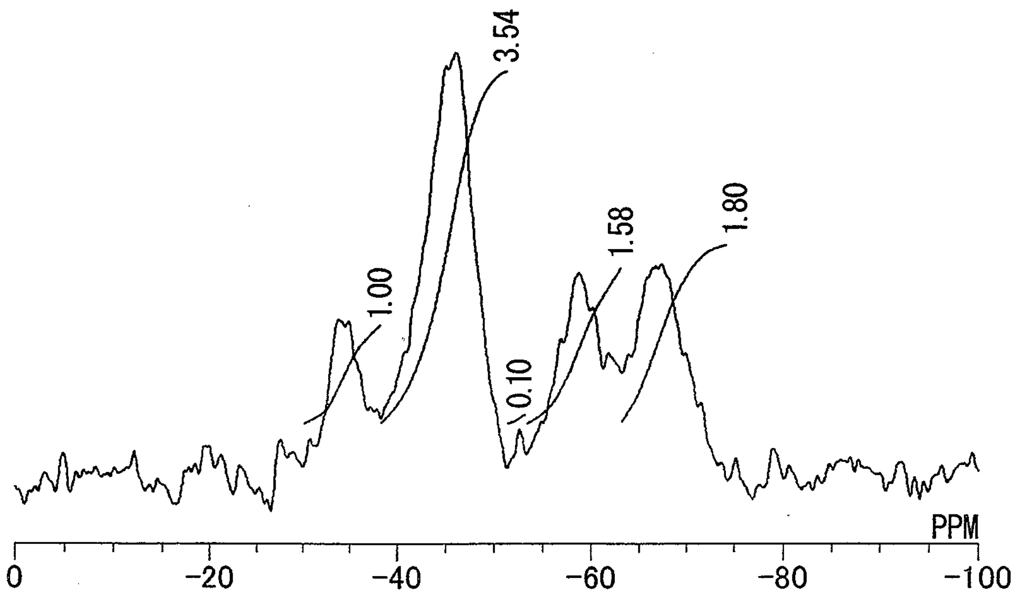
3.54
1.58
1.80
1.00
0.10
PPM
0
-20
-40
-60
-80
-100

Fig.13

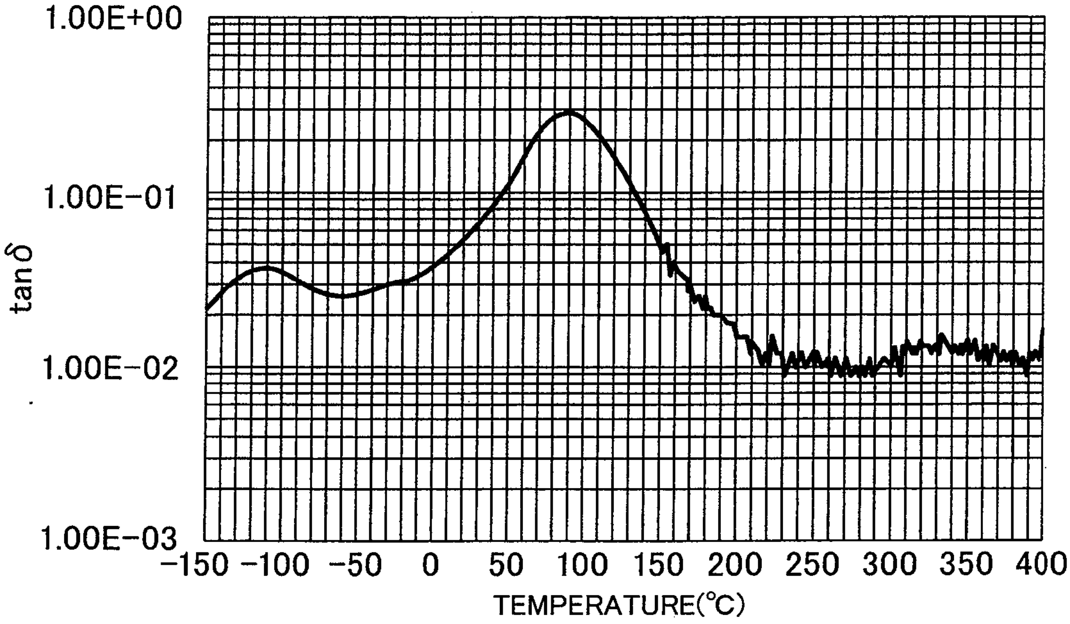
1.00E+00
1.00E−01
1.00E−02
1.00E−03
tan δ
−150 −100 −50 0 50 100 150 200 250 300 350 400
TEMPERATURE(°C)

Fig.14

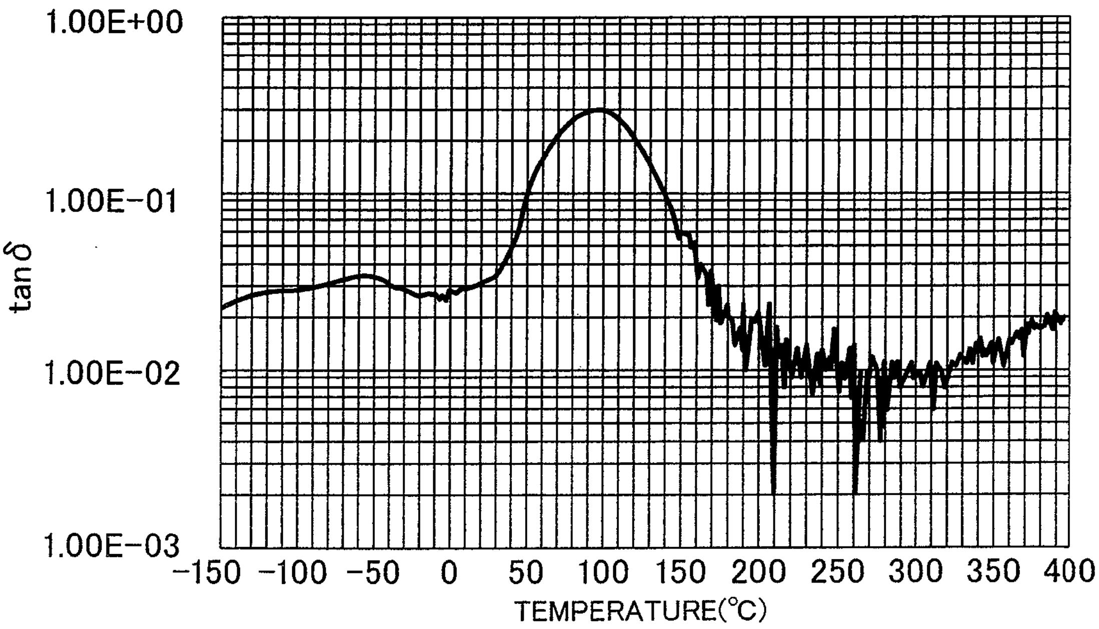
1.00E+00
1.00E−01
1.00E−02
1.00E−03
tan δ
−150 −100 −50 0 50 100 150 200 250 300 350 400
TEMPERATURE(°C)

Fig.15

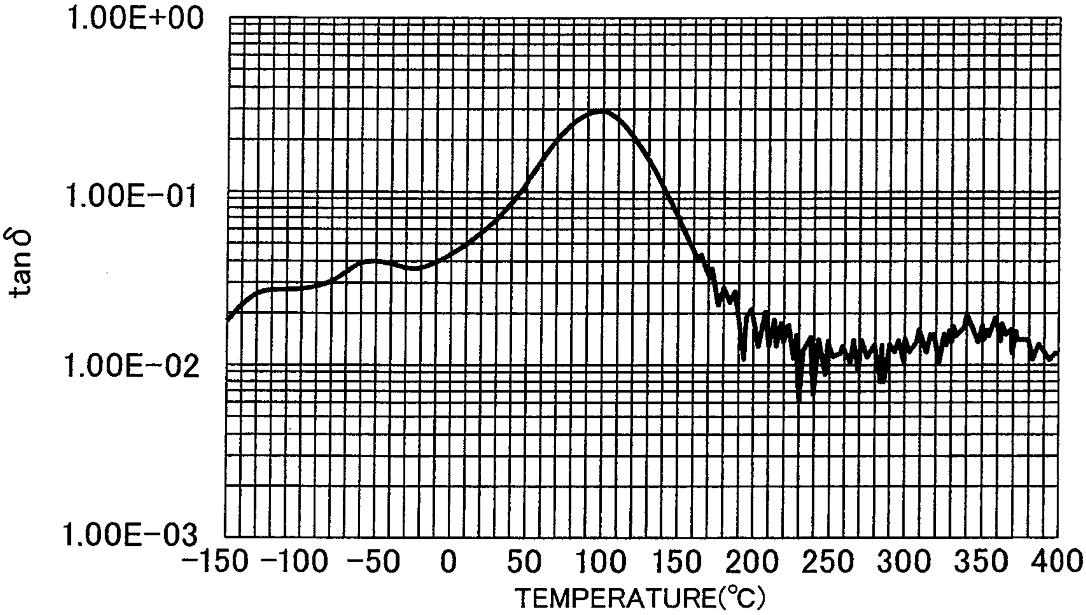
1.00E+00
1.00E-01
1.00E-02
1.00E-03
tanδ
-150 -100 -50 0 50 100 150 200 250 300 350 400
TEMPERATURE(°C)

Fig.16

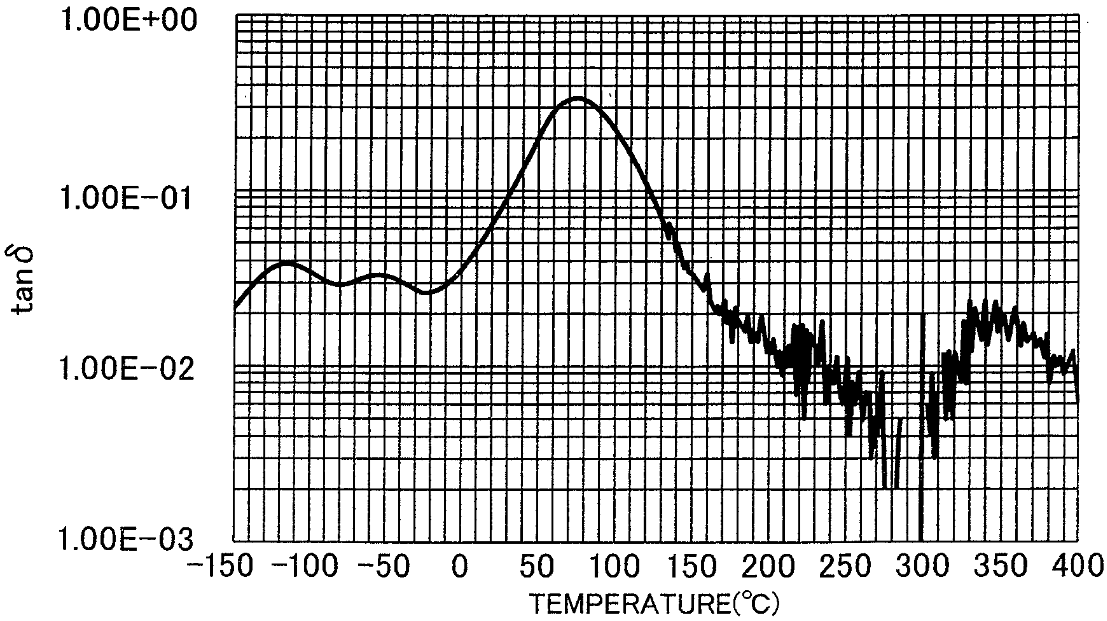
1.00E+00
1.00E-01
1.00E-02
1.00E-03
tanδ
-150 -100 -50 0 50 100 150 200 250 300 350 400
TEMPERATURE(°C)

## INTERNATIONAL SEARCH REPORT

International application No.
PCT/JP2012/072247

A. CLASSIFICATION OF SUBJECT MATTER
*G03F7/075*(2006.01)i, *C08F230/08*(2006.01)i, *C08F290/08*(2006.01)i, *C08G77/14*(2006.01)i, *C08G77/20*(2006.01)i, *G03F7/033*(2006.01)i, *G03F7/038*(2006.01)i, *H01L21/027*(2006.01)i

According to International Patent Classification (IPC) or to both national classification and IPC

B. FIELDS SEARCHED

Minimum documentation searched (classification system followed by classification symbols)
G03F7/075, C08F230/08, C08F290/08, C08G77/14, C08G77/20, G03F7/033, G03F7/038, H01L21/027

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2012 |
| Kokai Jitsuyo Shinan Koho | 1971-2012 | Toroku Jitsuyo Shinan Koho | 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2011-158513 A (Sanyo Chemical Industries, Ltd.), 18 August 2011 (18.08.2011), entire text (Family: none) | 1-28 |
| A | JP 2010-39056 A (Sekisui Chemical Co., Ltd.), 18 February 2010 (18.02.2010), entire text (Family: none) | 1-28 |
| A | JP 2010-39052 A (Sekisui Chemical Co., Ltd.), 18 February 2010 (18.02.2010), entire text (Family: none) | 1-28 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 13 November, 2012 (13.11.12) | 20 November, 2012 (20.11.12) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No. PCT/JP2012/072247

C (Continuation). DOCUMENTS CONSIDERED TO BE RELEVANT

| Category* | Citation of document, with indication, where appropriate, of the relevant passages | Relevant to claim No. |
|---|---|---|
| A | WO 2009/90867 A1 (Sekisui Chemical Co., Ltd.), 23 July 2009 (23.07.2009), entire text & JP 4392464 B & TW 200937123 A | 1-28 |
| P,A | JP 2012-32673 A (Fujifilm Corp.), 16 February 2012 (16.02.2012), entire text (Family: none) | 1-28 |
| E,X | JP 2012-215837 A (JSR Corp.), 08 November 2012 (08.11.2012), claims; paragraphs [0132] to [0169] (Family: none) | 1-3,5,8-9, 14-16,19-21 |
| A | JP 2009-19093 A (Asahi Kasei EMD Corp.), 29 January 2009 (29.01.2009), entire text (Family: none) | 1-28 |
| P,A | WO 2012/50201 A1 (Asahi Kasei E-materials Corp.), 19 April 2012 (19.04.2012), entire text (Family: none) | 1-28 |

Form PCT/ISA/210 (continuation of second sheet) (July 2009)

**INTERNATIONAL SEARCH REPORT**

International application No.
PCT/JP2012/072247

**Box No. II Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III Observations where unity of invention is lacking (Continuation of item 3 of first sheet)**

This International Searching Authority found multiple inventions in this international application, as follows:

The invention described in claim 1 and the inventions described in claims 22 and 23 share a common technical feature [a resin composition comprising a silicone resin, an alkali-soluble resin and a photopolymerization initiator].

However, the above-said technical feature cannot be considered to be a special technical feature, since the technical feature does not make a contribution over the prior art in the light of the contents disclosed in JP 2011-158513 A and JP 2010-39056 A.

(Continued to extra sheet)

1. ☒ As all required additional search fees were timely paid by the applicant, this international search report covers all searchable claims.
2. ☐ As all searchable claims could be searched without effort justifying additional fees, this Authority did not invite payment of additional fees.
3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**

☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☒ No protest accompanied the payment of additional search fees.

**INTERNATIONAL SEARCH REPORT**

International application No. PCT/JP2012/072247

Continuation of Box No.III of continuation of first sheet(2)

Further, there is no other same or corresponding special technical feature among these inventions.

Accordingly, the following two inventions (invention groups) are involved in claims.

(Invention 1) the inventions of claims 1-21

[The inventions relating to a photosensitive alkali-soluble silicone resin composition.]

(Invention 2) the inventions of claims 22-28

[The inventions relating to a cured article having a specific three-dimensional crosslinking degree.]

Form PCT/ISA/210 (extra sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 6342211 A
- JP 2007277332 A
- JP 2010061744 A